(19) Europäisches Patentamt
European Patent Office
Office européen des brevets

(11) **EP 4 692 099 A2**

(12) **EUROPEAN PATENT APPLICATION**

(43) Date of publication:
**11.02.2026 Bulletin 2026/07**

(21) Application number: **25193639.9**

(22) Date of filing: **04.08.2025**

(51) International Patent Classification (IPC):
***C07F 15/00*** *(2006.01)* ***C07B 59/00*** *(2006.01)*
***C09K 11/02*** *(2006.01)* ***C09K 11/06*** *(2006.01)*
***H10K 50/11*** *(2023.01)* ***H10K 85/30*** *(2023.01)*

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **09.08.2024 KR 20240107082**
**23.07.2025 KR 20250100032**

(71) Applicant: **Samsung Display Co., Ltd.**
**Yongin-si, Gyeonggi-do 17113 (KR)**

(72) Inventors:
- **WON, Joonghee**
  **16678 Suwon-si (KR)**
- **KIM, Jong Soo**
  **16678 Suwon-si (KR)**
- **KANG, Hosuk**
  **16678 Suwon-si (KR)**
- **BAE, Hyejin**
  **16678 Suwon-si (KR)**
- **LEE, Yeonkyung**
  **16678 Suwon-si (KR)**
- **CHUNG, Yeon Sook**
  **16678 Suwon-si (KR)**
- **HEO, Joon**
  **16678 Suwon-si (KR)**

(74) Representative: **Elkington and Fife LLP**
**Prospect House**
**8 Pembroke Road**
**Sevenoaks, Kent TN13 1XR (GB)**

# (54) ORGANOMETALLIC COMPOUND, ORGANIC LIGHT-EMITTING DEVICE INCLUDING THE ORGANOMETALLIC COMPOUND, AND ELECTRONIC APPARATUS INCLUDING THE ORGANIC LIGHT-EMITTING DEVICE

(57) An organometallic compound represented by Formula A and satisfying Inequality 1:

Formula A

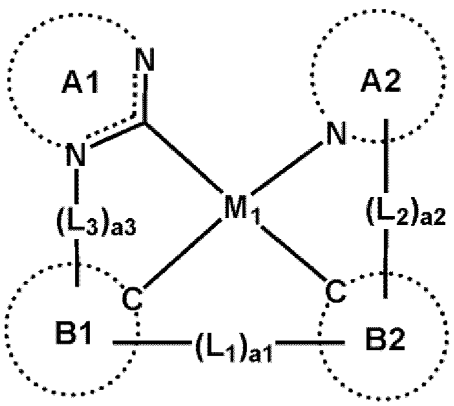

Inequality 1

LUNTO(A1) < LUNTO(A2)

wherein LUNTO(A1) denotes a percentage of contribution of ring A1 to lowest unoccupied natural transition orbital (LUNTO) distribution of the organometallic compound in a triplet ($T_1$) state, LUNTO(A2) denotes a percentage of contribution of ring A2 to LUNTO distribution of the organometallic compound in a $T_1$ state, and the LUNTO distribution of the organometallic compound in a $T_1$ state represents LUNTO distribution for the organometallic compound excited from a ground state (So) to a $T_1$ state, as calculated by time-dependent density function theory.

FIG. 1

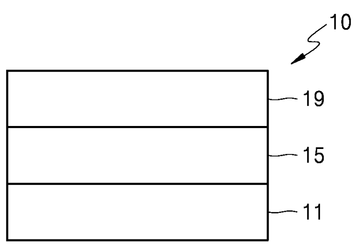


EP 4 692 099 A2

## Description

FIELD OF THE INVENTION

The subject matter relates to an organometallic compound, an organic light-emitting device including the organometallic compound, and an electronic apparatus including the organic light-emitting device.

BACKGROUND OF THE INVENTION

Organic light-emitting devices (OLEDs) are self-emissive devices that have excellent characteristics in terms of viewing angles, response time, brightness, driving voltage, response speed, and the like. In addition, OLEDs can produce full-color images.

In an example, an organic light-emitting device includes an anode, a cathode, and an organic layer that is arranged between the anode and the cathode and includes an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. When the excitons transition from an excited state to a ground state, light is emitted.

SUMMARY OF THE INVENTION

Provided are an organometallic compound, an organic light-emitting device including the organometallic compound, and an electronic apparatus including the organic light-emitting device.

Additional aspects will be set forth in part in the detailed description that follows and, in part, will be apparent from the detailed description, or may be learned by practice of the presented exemplary embodiments herein.

According to an aspect, provided is an organometallic compound represented by Formula A and satisfying Inequality 1:

Formula A

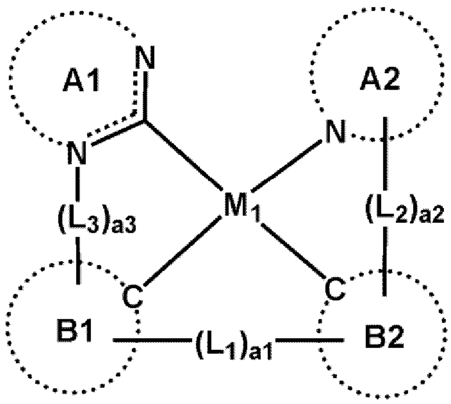

wherein in Formula A,

$M_1$ is a metal or a metalloid,
ring A1 and ring A2 are each independently a $C_1$-$C_{60}$ heterocyclic group unsubstituted or substituted with at least one $R_{10a}$,
ring B1 and ring B2 are each independently a $C_5$-$C_{60}$ carbocyclic group unsubstituted or substituted with at least one $R_{10a}$, or a $C_1$-$C_{60}$ heterocyclic group unsubstituted or substituted with at least one $R_{10a}$,
$L_1$ to $L_3$ are each independently a single bond, O, S, Se, $N(R_{11a})$, $B(R_{11a})$, $C(R_{11a})(R_{12a})$, or $Si(R_{11a})(R_{12a})$,
$R_{10a}$, $R_{11a}$, and $R_{12a}$ are each independently hydrogen, deuterium, -F, - Cl, -Br, -I, $-SF_5$, a hydroxyl group, a cyano group, a nitro group, an amidino group, a hydrazine group, a hydrazone group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group,

a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -Ge($Q_1$)($Q_2$)($Q_3$), -B($Q_1$)($Q_2$), - N($Q_1$)($Q_2$), -P($Q_1$)($Q_2$), -C(=O)($Q_1$), -S(=O)($Q_1$), -S(=O)$_2$($Q_1$), -P(=O)($Q_1$)($Q_2$), or -P(=S)($Q_1$)($Q_2$),

at least two neighboring groups of $R_{10a}$, $R_{11a}$, and $R_{12a}$ are optionally bonded together to form a substituted or unsubstituted $C_5$-$C_{30}$ carbocyclic group or a substituted or unsubstituted $C_1$-$C_{30}$ heterocyclic group,

at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ hetero arylthio group, the substituted monovalent non-aromatic condensed polycyclic group, and the substituted monovalent non-aromatic condensed heteropolycyclic group is:

deuterium, -F, -Cl, -Br, -I, -$SF_5$, -$CD_3$, -$CD_2H$, -$CDH_2$, -$CF_3$, -$CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group,

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, -Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -Si($Q_{11}$)($Q_{12}$)($Q_{13}$), -Ge($Q_{11}$)($Q_{12}$)($Q_{13}$), -N($Q_{14}$)($Q_{15}$), -B($Q_{16}$)($Q_{17}$), - P($Q_{18}$)($Q_{19}$), -P(=O)($Q_{18}$)($Q_{19}$), or a combination thereof,

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group,

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, -$SF_5$, -$CD_3$, -$CD_2H$, - $CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, - Si($Q_{21}$)($Q_{22}$)($Q_{23}$), -Ge($Q_{21}$)($Q_{22}$)($Q_{23}$), -N($Q_{24}$)($Q_{25}$), -B($Q_{26}$)($Q_{27}$), -P($Q_{28}$)($Q_{29}$), -P(=O)($Q_{28}$)($Q_{29}$), or a combination thereof, or

-Si($Q_{31}$)($Q_{32}$)($Q_{33}$), -Ge($Q_{31}$)($Q_{32}$)($Q_{33}$), -N($Q_{34}$)($Q_{35}$), -B($Q_{36}$)($Q_{37}$), - P($Q_{38}$)($Q_{39}$), or -P(=O)($Q_{38}$)($Q_{39}$), and

$Q_1$ to $Q_9$, $Q_{11}$ to $Q_{19}$, $Q_{21}$ to $Q_{29}$, and $Q_{31}$ to $Q_{39}$ may each independently be hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group,

Inequality 1

$$\text{LUNTO(A1)} < \text{LUNTO(A2)}$$

wherein, in Inequality 1,

LUNTO(A1) denotes a percentage of contribution of ring A1 to lowest unoccupied natural transition orbital (LUNTO) distribution of the organometallic compound in a triplet ($T_1$) state,
LUNTO(A2) denotes a percentage of contribution of ring A2 to the LUNTO distribution of the organometallic compound in a $T_1$ state, and
the LUNTO distribution of the organometallic compound in a $T_1$ state represents LUNTO distribution of the organometallic compound excited from a ground state ($S_0$) to a $T_1$ state, as calculated by time-dependent density function theory.

According to another aspect, an organic light-emitting device includes at least one of the organometallic compounds of Formula A.

According to another aspect, an electronic apparatus includes the organic light-emitting device.

Another aspect provides an organic light-emitting device, comprising: a first electrode; a second electrode, and an organic layer arranged between the first electrode and the second electrode, wherein the organic layer comprises an emission layer, and wherein the organic layer further comprises at least one of the organometallic compounds of Formula A.

According to another aspect, provided is an organometallic compound represented by Formula 1:

Formula 1

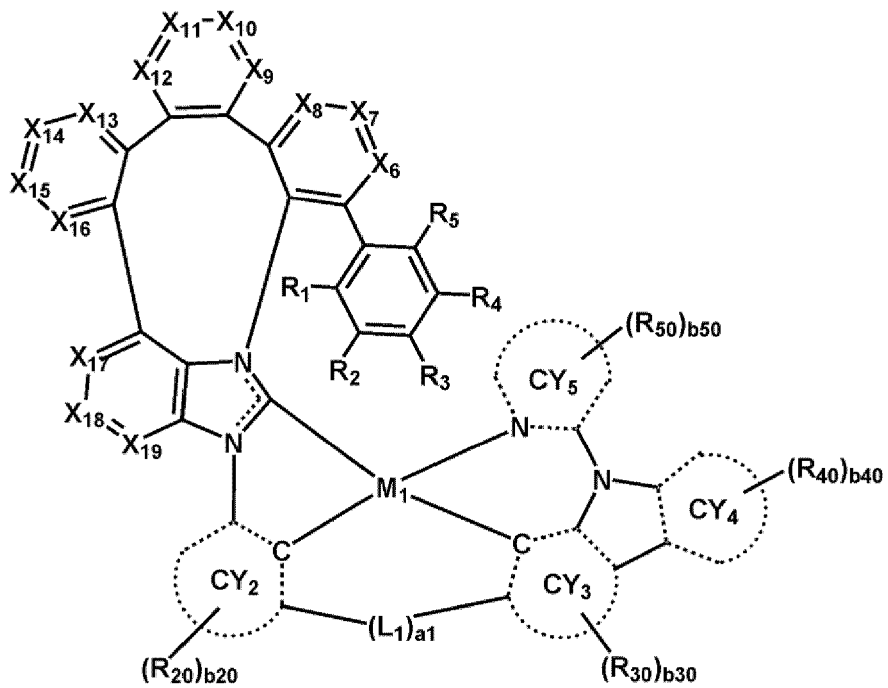

wherein, in Formula 1,

$M_1$ is a metal or a metalloid,
ring $CY_2$ to ring $CY_5$ are each independently a $C_5$-$C_{60}$ carbocyclic group or a $C_1$-$C_{60}$ heterocyclic group,
$X_6$ is $C(R_6)$ or N, $X_7$ is $C(R_7)$ or N, and $X_8$ is $C(R_8)$ or N,
$X_9$ is $C(R_9)$ or N, $X_{10}$ is $C(R_{10})$ or N, $X_{11}$ is $C(R_{11})$ or N, and $X_{12}$ is $C(R_{12})$ or N,
$X_{13}$ may be $C(R_{13})$ or N, $X_{14}$ may be $C(R_{14})$ or N, $X_{15}$ may be $C(R_{15})$ or N, and $X_{16}$ may be $C(R_{16})$ or N,
$X_{17}$ is $C(R_{17})$ or N, $X_{18}$ is $C(R_{18})$ or N, and $X_{19}$ is $C(R_{19})$ or N,
$L_1$ is a single bond, O, S, Se, $N(R_{61})$, $B(R_{61})$, $C(R_{61})(R_{62})$, or $Si(R_{61})(R_{62})$,
a1 may be 1, 2, 3, 4, or 5,
$R_1$ to $R_{20}$, $R_{30}$, $R_{40}$, $R_{50}$, $R_{61}$, and $R_{62}$ are each independently hydrogen, deuterium, -F, -Cl, -Br, -I, $-SF_5$, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$,

(i) at least one of $R_1$ to $R_5$ and at least one of $R_6$ to $R_{19}$ are each independently a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, or a substituted or unsubstituted $C_1$-$C_{60}$ alkylthio group, and/or
(ii) at least one of $R_{50}$ is a substituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a

substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group,

at least two neighboring groups among $R_1$ to $R_{20}$, $R_{30}$, $R_{40}$, $R_{50}$, $R_{61}$, and $R_{62}$ are optionally bonded together to form a substituted or unsubstituted Cs-$C_{30}$ carbocyclic group or a substituted or unsubstituted $C_1$-$C_{30}$ heterocyclic group,
b20, b30, b40, and b50 are each independently 1, 2, 3, 4, 5, 6, 7, 8, 9, or 10,
at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ hetero arylthio group, the substituted monovalent non-aromatic condensed polycyclic group, and the substituted monovalent non-aromatic condensed heteropolycyclic group is:
deuterium, -F, -Cl, -Br, -I, -$SF_5$, -$CD_3$, -$CD_2H$, -$CDH_2$, -$CF_3$, -$CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group,
a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, -Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, - Si($Q_{11}$)($Q_{12}$)($Q_{13}$), -Ge($Q_{11}$)($Q_{12}$)($Q_{13}$), -N($Q_{14}$)($Q_{15}$), -B($Q_{16}$)($Q_{17}$), -P($Q_{18}$)($Q_{19}$), -P(=O)($Q_{18}$)($Q_{19}$), or a combination thereof,
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group,
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, -$SF_5$, -$CD_3$, -$CD_2H$, - $CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -Si($Q_{21}$)($Q_{22}$)($Q_{23}$), - Ge($Q_{21}$)($Q_{22}$)($Q_{23}$), -N($Q_{24}$)($Q_{25}$), -B($Q_{26}$)($Q_{27}$), -P($Q_{28}$)($Q_{29}$), -P(=O)($Q_{28}$)($Q_{29}$), or a combination thereof, or
-Si($Q_{31}$)($Q_{32}$)($Q_{33}$), -Ge($Q_{31}$)($Q_{32}$)($Q_{33}$), -N($Q_{34}$)($Q_{35}$), -B($Q_{36}$)($Q_{37}$), - P($Q_{38}$)($Q_{39}$), or -P(=O)($Q_{38}$)($Q_{39}$), and
$Q_1$ to $Q_9$, $Q_{11}$ to $Q_{19}$, $Q_{21}$ to $Q_{29}$, and $Q_{31}$ to $Q_{39}$ are each independently hydrogen, deuterium, -F, -Cl, -Br, -I, -$SF_5$, a hydroxyl group, a cyano group, a nitro group, an amino group, an amidino group, a hydrazine group, a hydrazone

group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a schematic cross-sectional view of an organic light-emitting device according to one or more embodiments;

FIG. 2 shows energy transfer according to one or more embodiments;

FIG. 3 shows energy transfer according to one or more embodiments; and

FIG. 4 shows energy transfer according to one or more embodiments.

DETAILED DESCRIPTION OF THE EMBODIMENTS

Reference will now be made in further detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to

as being "directly on" another element, there are no intervening elements present.

Unless otherwise defined, all terms (including technical and scientific terms) used herein have the same meaning as commonly understood by one of ordinary skill in the art to which this general inventive concept belongs. **It** will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 30%, 20%, 10%, 5% of the stated value.

As used herein, an "energy level" (e.g., a highest occupied molecular orbital (HOMO) energy level or a triplet ($T_1$) energy level) is expressed as an absolute value from a vacuum level. **In** addition, when the energy level is referred to as being "deep," "high," or "large," the energy level has a large absolute value based on "0 electron Volts (eV)" of the vacuum level, and when the energy level is referred to as being "shallow," "low," or "small," the energy level has a small absolute value based on "0 eV" of the vacuum level.

According to an aspect, provided is organometallic compound represented by Formula A and satisfying Inequality 1:

Formula A

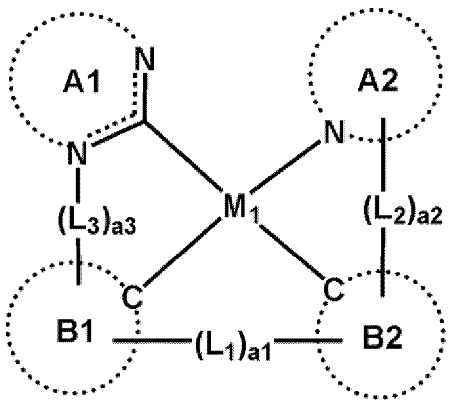

In Formula A, $M_1$ is a metal or metalloid.

In one or more embodiments, $M_1$ may be beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au).

In some embodiments, $M_1$ may be a transition metal. For example, $M_1$ may be a first row transition metal of the Periodic Table of Elements, a second row transition metal of the Periodic Table of Elements, or a third row transition metal of the Periodic Table of Elements.

In one or more embodiments, $M_1$ may be Pd, Ag, Re, Pt, or Au.

In one or more embodiments, $M_1$ may be Pd or Pt.

In Formula A, ring A1 and ring A2 are each independently a $C_1$-$C_{60}$ heterocyclic group unsubstituted or substituted with at least one $R_{10a}$.

In one or more embodiments, ring A1 and ring A2 may each independently be (i) a first ring unsubstituted or substituted with at least one $R_{10a}$, (ii) a second ring unsubstituted or substituted with at least one $R_{10a}$, (iii) a condensed ring group unsubstituted or substituted with at least one $R_{10a}$, in which two or more first rings are condensed with each other, or (iv) a condensed ring group unsubstituted or substituted with at least one $R_{10a}$, in which one or more first rings are condensed with one or more second rings,

wherein the first ring may be a pyridine group, a pyrimidine group, a pyrazine group, a pyridazine group, a triazine group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group,

and

the second ring may be a cyclopentane group, a cyclopentadiene group, an adamantane group, a norbornene group, a bicyclo[1.1.1]pentane group, a bicyclo[2.1.1]hexane group, a bicyclo[2.2.1]heptane group (also known as a norbornane group), a bicyclo[2.2.2]octane group, an indene group, a cyclohexane group, a cyclohexene group, or a benzene group.

In Formula A, ring B1 and ring B2 are each independently a $C_5$-$C_{60}$ carbocyclic group unsubstituted or substituted with at least one $R_{10a}$, or a $C_1$-$C_{60}$ heterocyclic group unsubstituted or substituted with at least one $R_{10a}$.

In one or more embodiments, ring B1 and ring B2 may each independently be (i) a first ring unsubstituted or substituted with at least one $R_{10a}$, (ii) a second ring unsubstituted or substituted with at least one $R_{10a}$, (iii) a condensed ring group unsubstituted or substituted with at least one $R_{10a}$, in which two or more first rings are condensed with each other, (iv) a condensed ring group unsubstituted or substituted with at least one $R_{10a}$, in which two or more second rings are condensed with each other, or (iv) a condensed ring group unsubstituted or substituted with at least one $R_{10a}$, in which one or more first rings are condensed with one or more second rings,

wherein the first ring may be a pyridine group, a pyrimidine group, a pyrazine group, a pyridazine group, a triazine group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and

the second ring may be a cyclopentane group, a cyclopentadiene group, an adamantane group, a norbornene group, a bicyclo[1.1.1]pentane group, a bicyclo[2.1.1]hexane group, a bicyclo[2.2.1]heptane group (also known as a norbornane group), a bicyclo[2.2.2]octane group, an indene group, a cyclohexane group, a cyclohexene group, or a benzene group.

In Formula A, $L_1$ to $L_3$ are each independently a single bond, O, S, Se, N($R_{11a}$), B($R_{11a}$), C($R_{11a}$)($R_{12a}$), or Si($R_{11a}$)($R_{12a}$).

In Formula A, a1 to a3 are each independently 1, 2, 3, 4, or 5.

In Formula A, $R_{10a}$, $R_{11a}$, and $R_{12a}$ are each independently hydrogen, deuterium, -F, -Cl, -Br, -I, -$SF_5$, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkylheteroaryl group, a substituted or unsubstituted $C_2$-$C_{60}$ heteroarylalkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -Ge($Q_1$)($Q_2$)($Q_3$), -C($Q_1$)($Q_2$)($Q_3$), -B($Q_1$)($Q_2$), -N($Q_1$)($Q_2$), -P($Q_1$)($Q_2$), -C(=O)($Q_1$), -S(=O)($Q_1$), -S(=O)$_2$($Q_1$), - P(=O)($Q_1$)($Q_2$), or -P(=S)($Q_1$)($Q_2$), and

at least two neighboring groups of $R_{10a}$, $R_{11a}$, and $R_{12a}$ are optionally bonded together to form a substituted or unsubstituted $C_5$-$C_{30}$ carbocyclic group or a substituted or unsubstituted $C_1$-$C_{30}$ heterocyclic group.

In one or more embodiments, ring A1 may include at least two electron-donating groups.

In one or more embodiments, ring A2 may include at least one electron-donating group.

In one or more embodiments, the electron-donating group may be a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

The organometallic compound is represented by Formula A and satisfies Inequality 1:

Inequality 1

$$\text{LUNTO(A1)} < \text{LUNTO(A2)}.$$

In Inequality 1,

LUNTO(A1) denotes a percentage of contribution of ring A1 to lowest unoccupied natural transition orbital (LUNTO) distribution of the organometallic compound in a triplet ($T_1$) state,

LUNTO(A2) denotes a percentage of contribution of ring A2 to the LUNTO distribution of the organometallic compound in a $T_1$ state, and

the LUNTO distribution of the organometallic compound in a $T_1$ state represents a LUNTO distribution of the organometallic compound excited from a ground state ($S_0$) to a $T_1$ state, as calculated by time-dependent density function theory (TD-DFT).

In one or more embodiments, the organometallic compound in a $T_1$ state may have a structure optimized by density functional theory (DFT) calculation.

In one or more embodiments, the DFT calculation may be performed based on the optimized molecular structure through the Gaussian 16 program and the B3LYP/6-31G(d,p) function.

In one or more embodiments, to calculate the values of the LUNTO(A1) and the LUNTO(A2), the DFT calculation (B3LYP/6-31G(d,p)) is performed first for the organometallic compound to optimize the structure of the compound in a $T_1$ state, and then, based on the optimized structure of the compound, the excited state from $S_0$ to $T_1$ is calculated according to TD-DFT.

In one or more embodiments, the calculation of the LUNTO distribution quantification of the organometallic compound, for example, the calculation of the values of the LUNTO(A1) and the LUNTO(A2), may be performed by using the Multiwfn program.

By satisfying Inequality 1, the organometallic compound of Formula A according to one or more embodiments may have improved luminescence efficiency as the LUNTO contribution of ring A2 is higher than the LUNTO contribution of ring A1.

In one or more embodiments, the organometallic compound of Formula A may satisfy Inequality 2:

Inequality 2

$$15 < \text{LUNTO(A1)} < 28.$$

In Inequality 2,

LUNTO(A1) may be the same as described elsewhere herein.

In one or more embodiments, LUNTO(A1) may satisfy: $18 < \text{LUNTO(A1)} < 27$.

In one or more embodiments, the organometallic compound may satisfy Inequality 3:

Inequality 3

$$40 < \text{LUNTO(A2)} < 80.$$

In Inequality 3,

LUNTO(A2) may be the same as described elsewhere herein.

In one or more embodiments, LUNTO(A2) may satisfy: $40 < \text{LUNTO(A2)} < 70$, $40 < \text{LUNTO(A2)} < 60$, or $40 < \text{LUNTO(A2)} < 55$.

The organometallic compound represented by Formula A according to one or more embodiments may satisfy Inequality 2 and/or Inequality 3 so that the luminescence efficiency may be improved when the LUNTO contribution of ring A1 and/or the LUNTO contribution of ring A2 satisfies a certain range.

In one or more embodiments, the organometallic compound represented by Formula A may be represented by Formula 1:

Formula 1

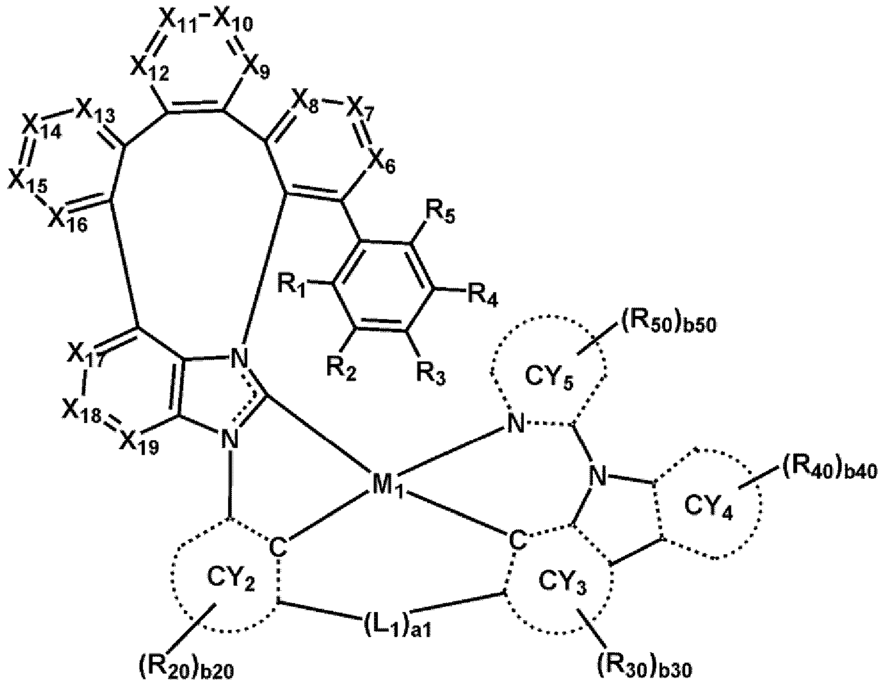

.

In one or more embodiments, ring A1, ring A2, ring B1, and ring B2 of the organometallic compound represented by Formula A may each correspond to moieties of Formula 1, as follows:

Formula 1-A

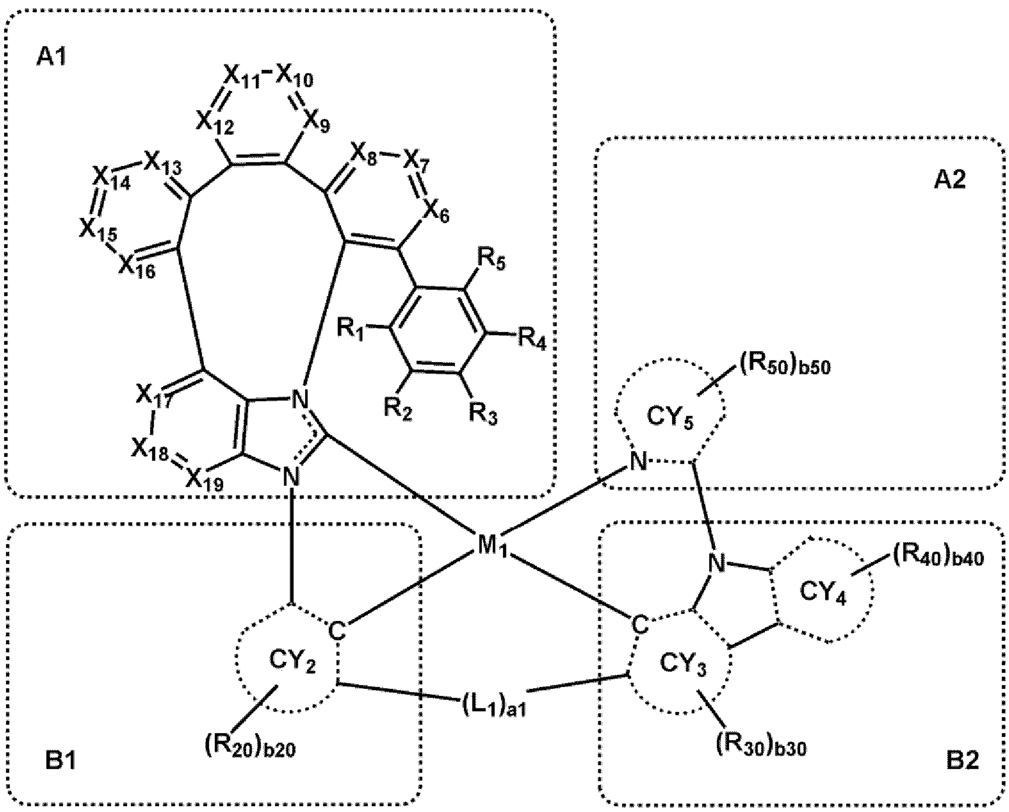

.

For example, the LUNTO(A1) in Formula 1, i.e., the percentage (%) of the contribution of ring A1, may refer to the

percentage of contribution of a moiety represented by

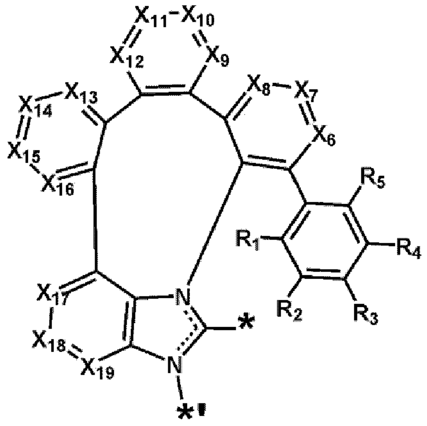

.

For example, the LUNTO(A2) in Formula 1, i.e., the percentage of the contribution of ring A2, may refer to the percentage of contribution of a moiety represented by

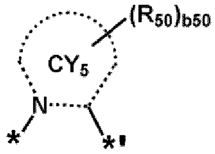

.

In the above moieties of Formula 1, * and *' each indicate a binding site to a neighboring atom.

Although not limited to a particular theory, when the organometallic compound according to one or more embodiments satisfies the structure of Formula 1, the conjugation effect in the moiety represented by

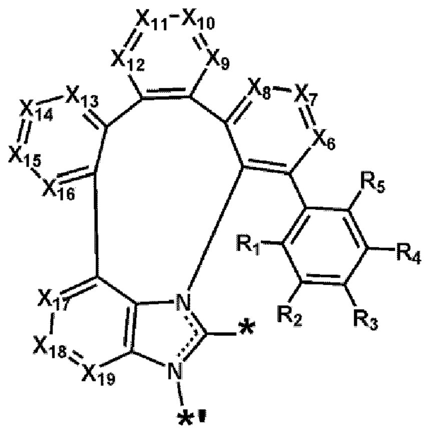

may be reduced, and accordingly, the quantity of electrons moving from the excited state of the organometallic compound to this moiety may be reduced. In this regard, the LUNTO(A1) may decrease and the LUNTO(A2) may increase, thereby improving the luminescence efficiency.

Also, as described above, in the organometallic compound of Formula A according to one or more embodiments, ring A1 may include at least two electron-donating groups and/or ring A2 may include at least one weak electron-donating group or at least one electron-withdrawing group, and in this embodiment, the luminescence efficiency may be also improved by a reduction in the LUNTO(A1) and an increase in the LUNTO(A2).

In Formula 1, $M_1$ may be a metal or a metalloid, for example a transition metal.

$M_1$ may be the same as described elsewhere herein.

In Formula 1, ring $CY_2$ to ring $CY_5$ are each independently a $C_5$-$C_{60}$ carbocyclic group or a $C_1$-$C_{60}$ heterocyclic group. For example, ring $CY_3$ and ring $CY_4$ may each independently be a $C_5$-$C_{30}$ carbocyclic group or a $C_1$-$C_{30}$ heterocyclic group. For example, ring $CY_5$ may be a $C_1$-$C_{60}$ heterocyclic group.

In one or more embodiments, ring $CY_2$ to ring $CY_5$ may each independently be (i) a first ring, (ii) a second ring, (iii) a condensed ring group in which two or more first rings are condensed with each other, (iv) a condensed ring group in which two or more second rings are condensed with each other, (v) a condensed ring group in which at least one first ring is condensed with at least one second ring, or (vi) a group represented by Formula 1A, wherein

the first ring may be a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and

the second ring may be an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclohexane group, a cyclohexene group, a benzene group, a pyridine group, a pyrimidine group, a pyrazine group, a pyridazine group, or a triazine group.

In one or more embodiments, ring $CY_2$ to ring $CY_5$ may each independently be a benzene group, a naphthalene group, an anthracene group, a phenanthrene group, a triphenylene group, a pyrene group, a chrysene group, a 1,2,3,4-tetrahydronaphthalene group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a fluorene group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a 5,6,7,8-tetrahydroisoquinoline group, a 5,6,7,8-tetrahydroquinoline group, an adamantane group, a norbornane group, or a norbornene group.

In one or more embodiments, ring $CY_2$ to ring $CY_5$ may each independently be a benzene group, a naphthalene group, a phenanthrene group, a furan group, a thiophene group, a pyrrole group, a cyclopentene group, a silole group, a germole group, a benzofuran group, a benzothiophene group, an indole group, an indene group, a benzosilole group, a benzogermole group, a dibenzofuran group, a dibenzothiophene group, a carbazole group, a fluorene group, a dibenzosilole group, a dibenzogermole group, a pyridine group, a pyrimidine group, a pyridazine group, or a pyrazine group.

In Formula 1, $X_6$ is $C(R_6)$ or N, $X_7$ is $C(R_7)$ or N, $X_8$ is $C(R_8)$ or N, $X_9$ is $C(R_9)$ or N, $X_{10}$ is $C(R_{10})$ or N, $X_{11}$ is $C(R_{11})$ or N, $X_{12}$ is $C(R_{12})$ or N, $X_{13}$ is $C(R_{13})$ or N, $X_{14}$ is $C(R_{14})$ or N, $X_{15}$ is $C(R_{15})$ or N, $X_{16}$ is $C(R_{16})$ or N, $X_{17}$ is $C(R_{17})$ or N, $X_{18}$ is $C(R_{18})$ or N, and $X_{19}$ is $C(R_{19})$ or N.

In Formula 1, $L_1$ is a single bond, O, S, Se, $N(R_{61})$, $B(R_{61})$, $C(R_{61})(R_{62})$, or $Si(R_{61})(R_{62})$.

In Formula 1, a1 is 1, 2, 3, 4, or 5.

a1 may be the same as described elsewhere herein.

In Formula 1, $R_1$ to $R_{20}$, $R_{30}$, $R_{40}$, $R_{50}$, $R_{61}$, and $R_{62}$ are each independently hydrogen, deuterium, -F, -Cl, -Br, -I, $-SF_5$, a hydroxyl group, a cyano group, a nitro group, an amidino group, a hydrazine group, a hydrazone group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$. $R_1$ to $R_5$ may each independently be hydrogen or as defined for the substituents in Formula A.

In one or more embodiments, $R_1$ to $R_{20}$, $R_{30}$, $R_{40}$, $R_{50}$, $R_{61}$, and $R_{62}$ may each independently be:

hydrogen, deuterium, -F, -Cl, -Br, -I, -$SF_5$, -$CD_3$, -$CD_2H$, -$CDH_2$, -$CF_3$, - $CF_2H$, -$CFH_2$, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group; or

a group represented by one of Formulae 9-1 to 9-61, 9-201 to 9-244, 10-1 to 10-154, or 10-201 to 10-350:

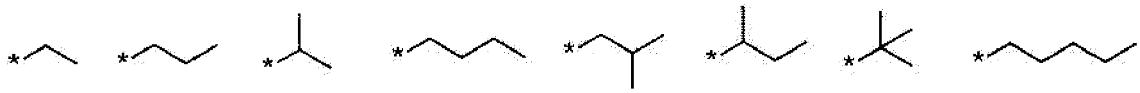
9-1 9-2 9-3 9-4 9-5 9-6 9-7 9-8

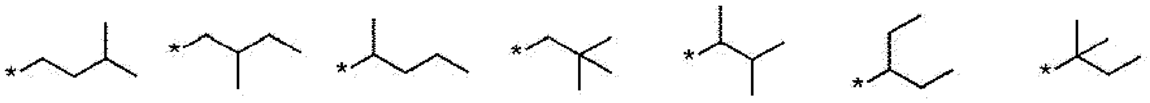
9-9 9-10 9-11 9-12 9-13 9-14 9-15

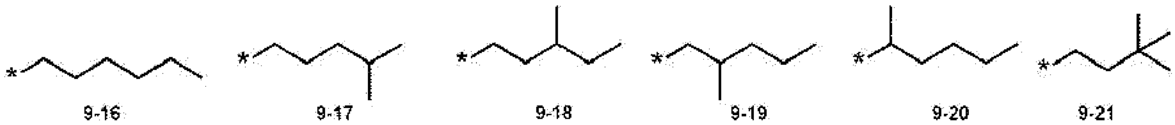
9-16 9-17 9-18 9-19 9-20 9-21

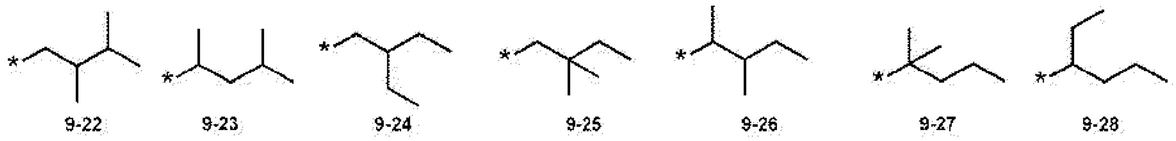
9-22 9-23 9-24 9-25 9-26 9-27 9-28

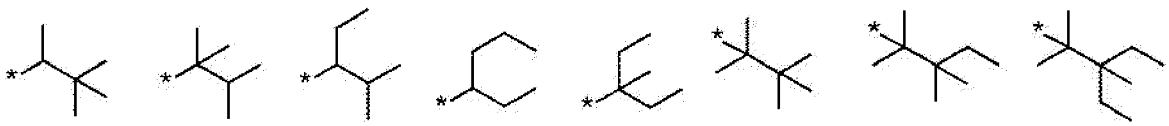
9-29 9-30 9-31 9-32 9-33 9-34 9-35 9-36

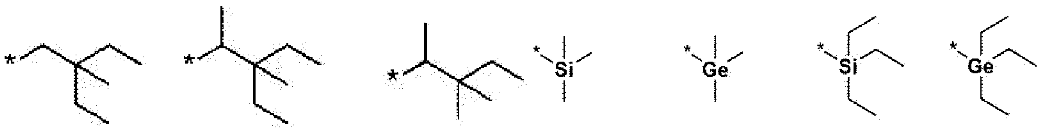
9-37 9-38 9-39 9-40 9-41 9-42 9-43

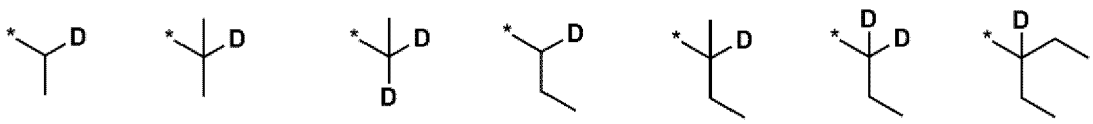
9-44 9-45 9-46 9-47 9-48 9-49 9-50

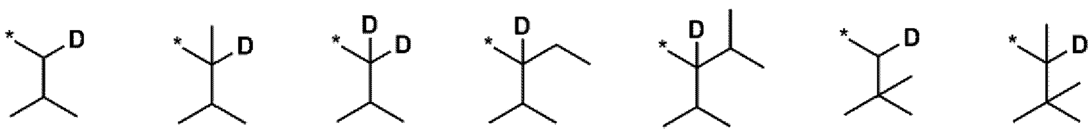
9-51 9-52 9-53 9-54 9-55 9-56 9-57

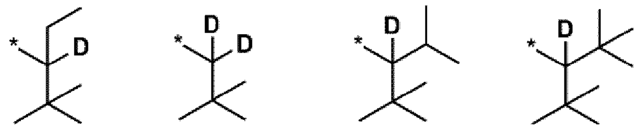

9-58 9-59 9-60 9-61

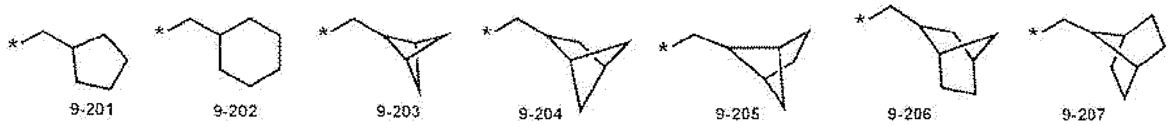

9-201 9-202 9-203 9-204 9-205 9-206 9-207

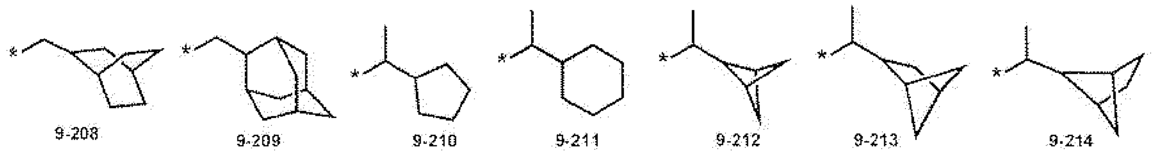

9-208 9-209 9-210 9-211 9-212 9-213 9-214

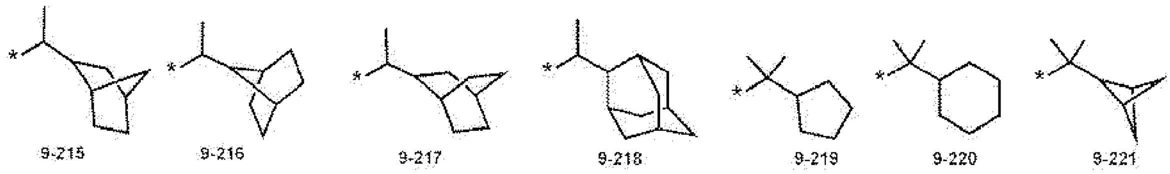

9-215 9-216 9-217 9-218 9-219 9-220 9-221

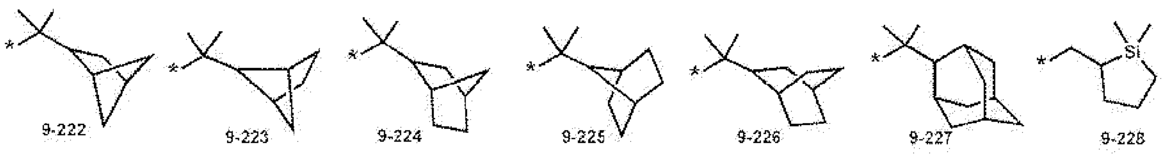

9-222 9-223 9-224 9-225 9-226 9-227 9-228

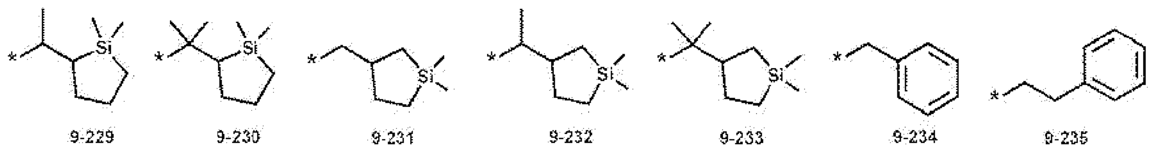

9-229 9-230 9-231 9-232 9-233 9-234 9-235

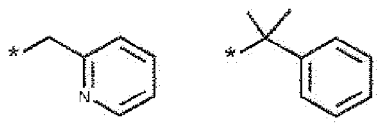

9-236 9-237

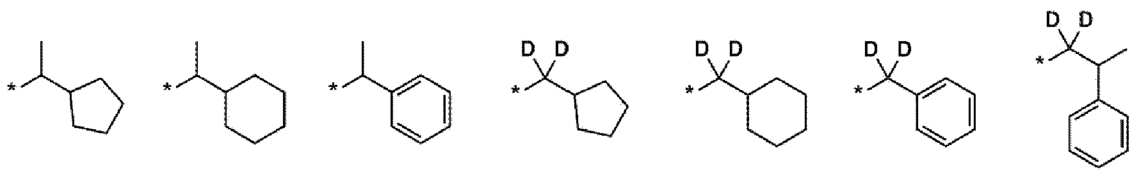

9-238 9-239 9-240 9-241 9-242 9-243 9-244

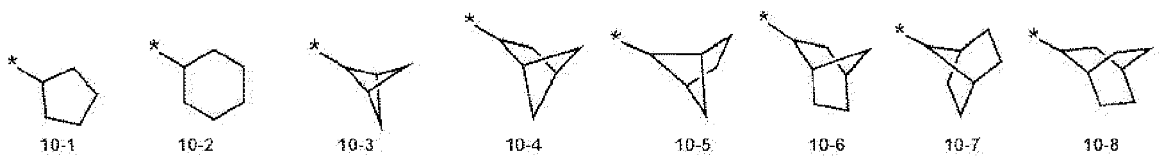

10-1 10-2 10-3 10-4 10-5 10-6 10-7 10-8

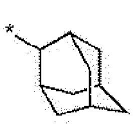

10-9

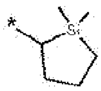

10-10

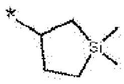

10-11

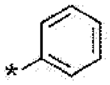

10-12

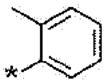

10-13

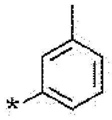

10-14

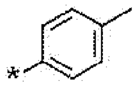

10-15

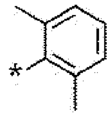

10-16

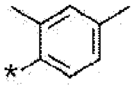

10-17

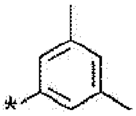

10-18

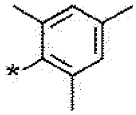

10-19

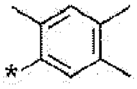

10-20

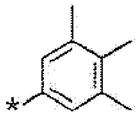

10-21

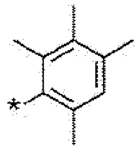

10-22

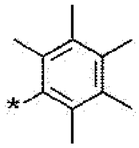

10-23

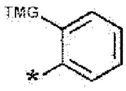

10-24

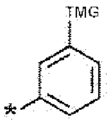

10-25

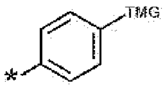

10-26

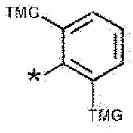

10-27

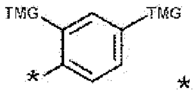

10-28

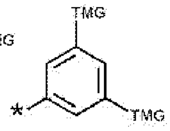

10-29

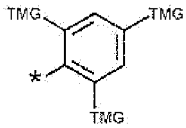

10-30

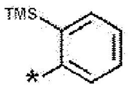

10-31

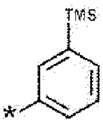

10-32

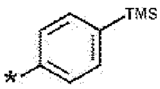

10-33

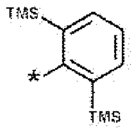

10-34

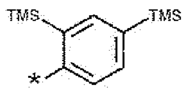

10-35

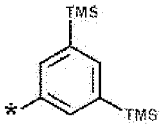

10-36

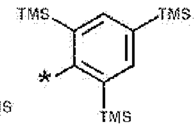

10-37

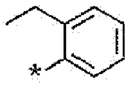

10-38

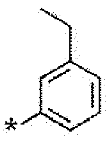

10-39

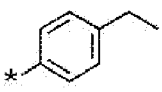

10-40

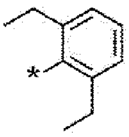

10-41

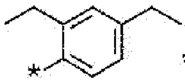

10-42

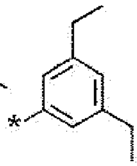

10-43

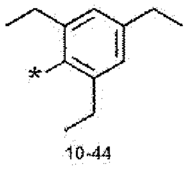

10-44

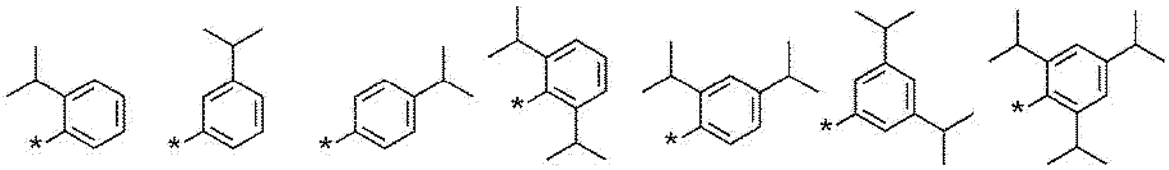

10-45 10-46 10-47 10-48 10-49 10-50 10-51

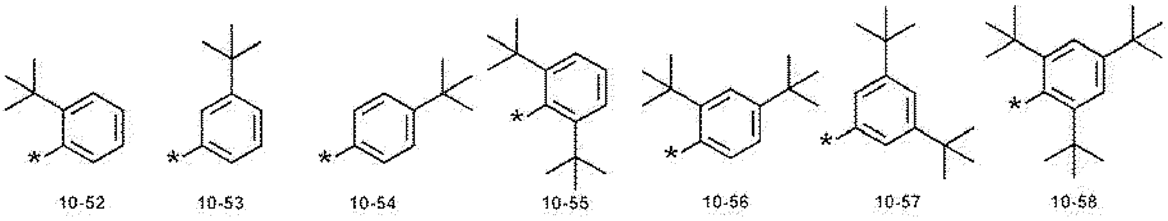

10-52 10-53 10-54 10-55 10-56 10-57 10-58

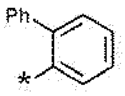
10-59

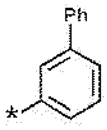
10-60

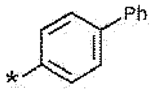
10-61

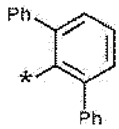
10-62

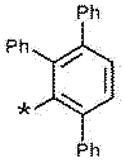
10-63

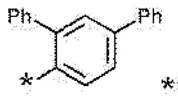
10-64

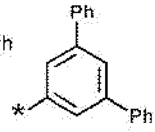
10-65

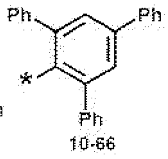
10-66

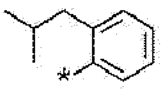
10-67

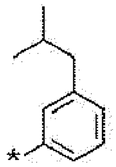
10-68

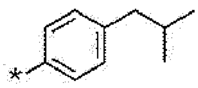
10-69

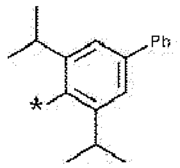
10-70

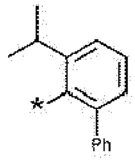
10-71

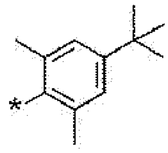
10-72

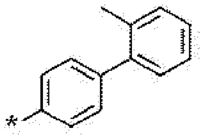
10-73

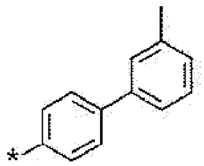
10-74

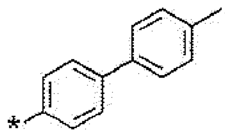
10-75

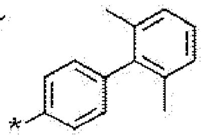
10-76

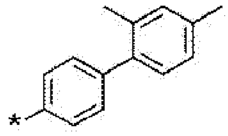
10-77

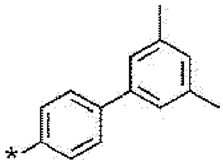
10-78

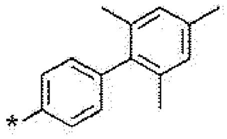
10-79

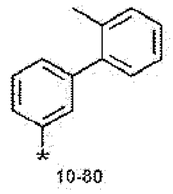
10-80

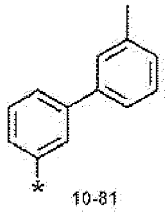
10-81

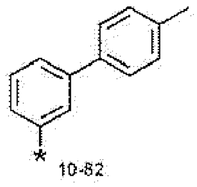
10-82

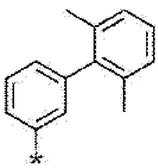
10-83

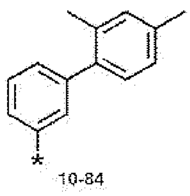
10-84

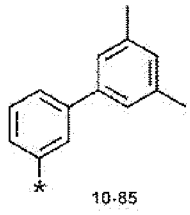
10-85

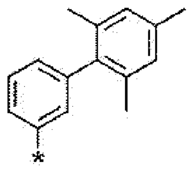
10-86

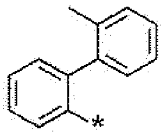
10-87

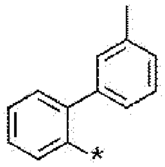
10-88

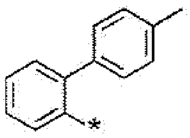
10-89

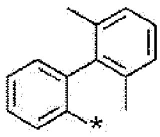
10-90

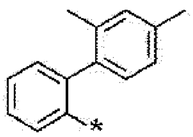
10-91

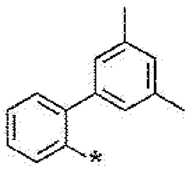
10-92

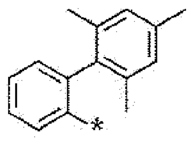
10-93

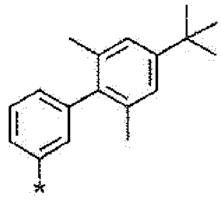
10-94

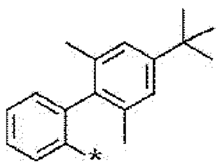
10-95

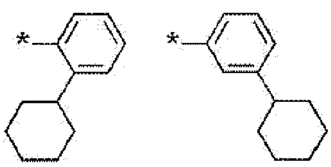
10-96

10-97

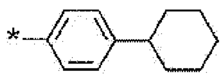
10-98

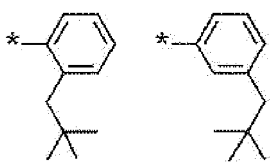
10-99

10-100

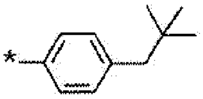
10-101

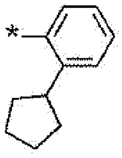
10-102

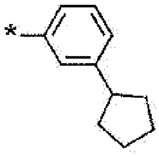
10-103

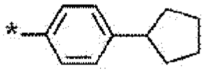
10-104

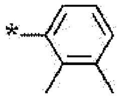
10-105

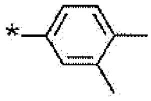
10-106

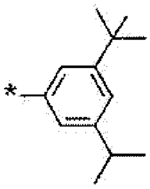
10-107

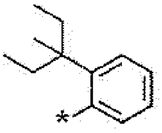
10-108

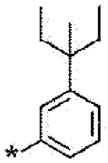
10-109

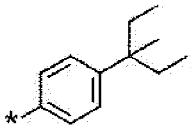
10-110

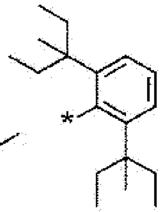
10-111

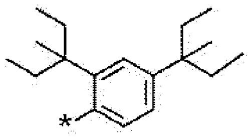
10-112

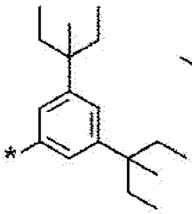
10-113

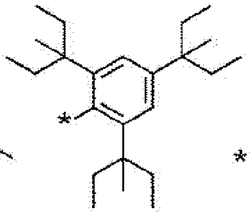
10-114

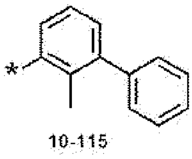
10-115

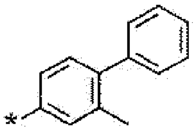
10-116

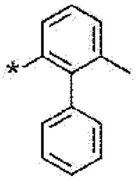
10-117

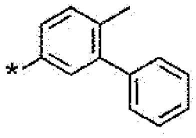
10-118

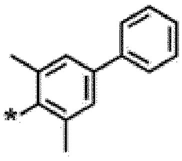
10-119

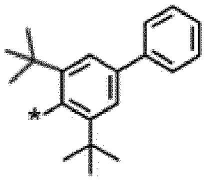
10-120

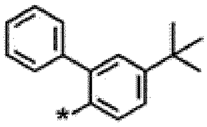
10-121

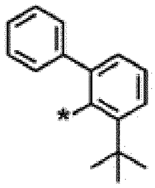
10-122

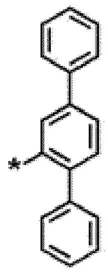
10-123

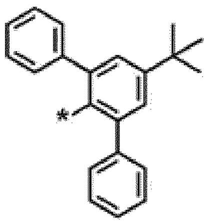
10-124

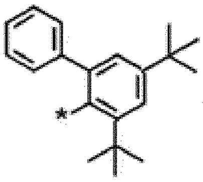
10-125

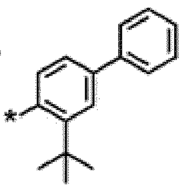
10-126

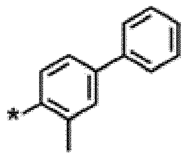
10-127

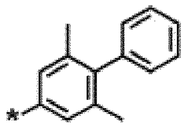
10-128

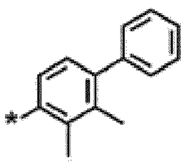
10-129

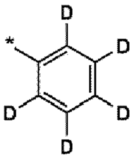
10-130

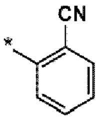
10-131

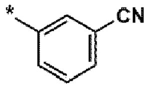
10-132

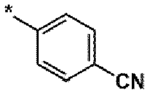
10-133

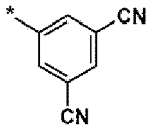
10-134

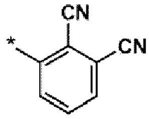
10-135

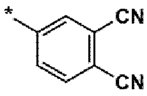
10-136

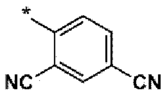
10-137

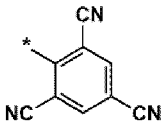
10-138

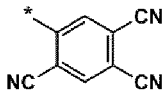
10-139

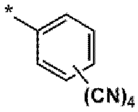
10-140

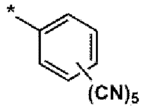
10-141

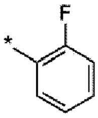
10-142

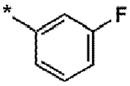
10-143

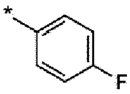
10-144

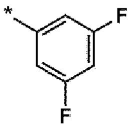
10-145

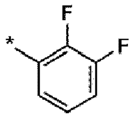
10-146

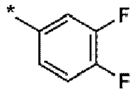
10-147

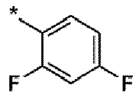
10-148

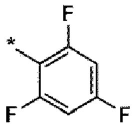
10-149

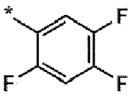
10-150

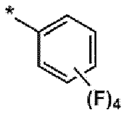
10-151

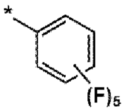
10-152

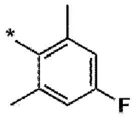
10-153

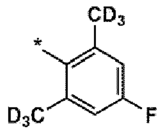
10-154

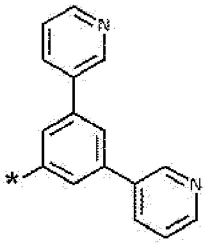
10-201

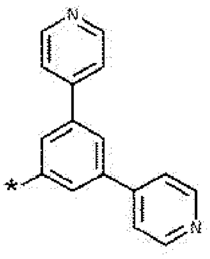
10-202

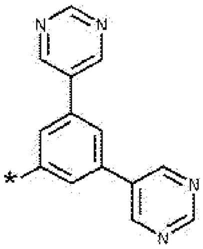
10-203

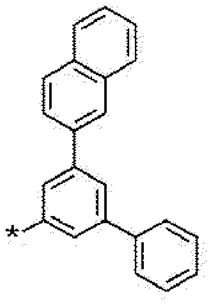
10-204

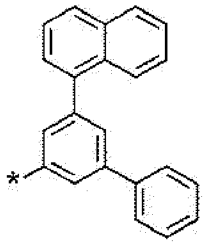
10-205

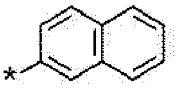
10-206

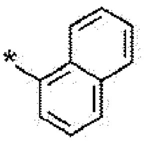
10-207

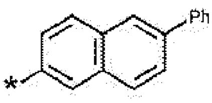
10-208

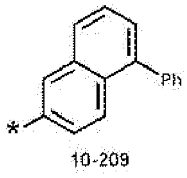
10-209

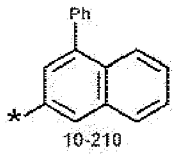
10-210

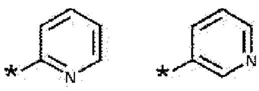
10-211 10-212

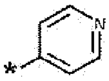
10-213

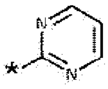
10-214

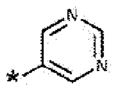
10-215

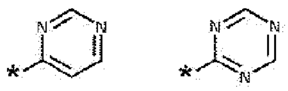
10-216 10-217

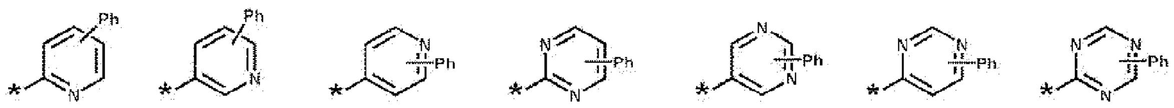
10-218 10-219 10-220 10-221 10-222 10-223 10-224

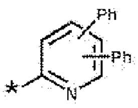
10-225
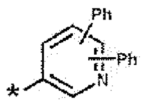
10-226
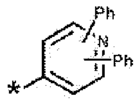
10-227
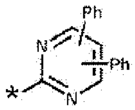
10-228
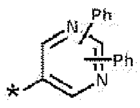
10-229
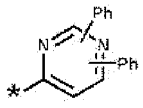
10-230
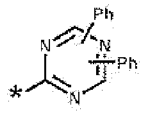
10-231

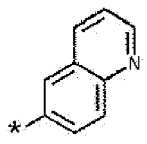
10-232
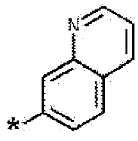
10-233
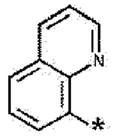
10-234
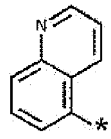
10-235
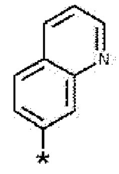
10-236
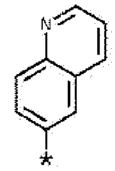
10-237

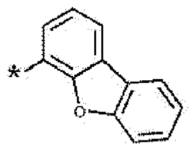
10-238
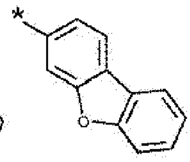
10-239
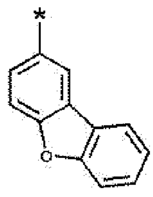
10-240
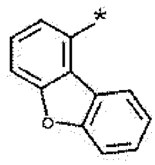
10-241
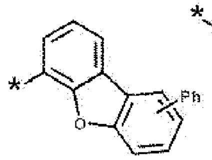
10-242
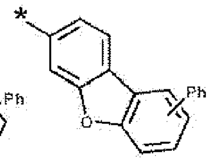
10-243

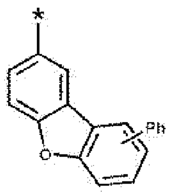
10-244
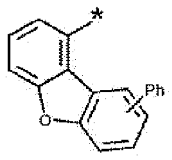
10-245
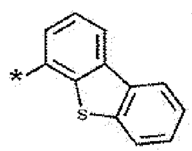
10-246
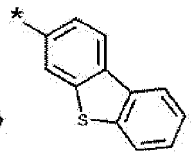
10-247
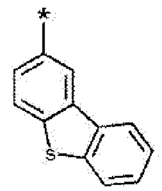
10-248
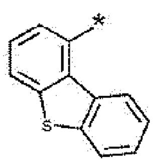
10-249

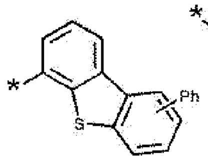
10-250
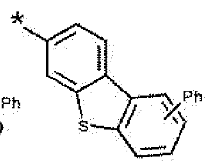
10-251
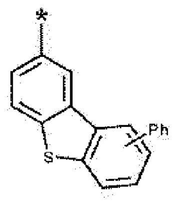
10-252
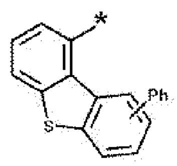
10-253
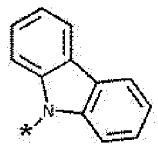
10-254
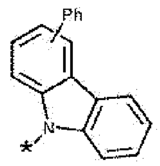
10-255

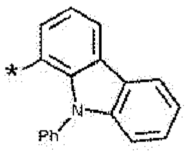
10-256
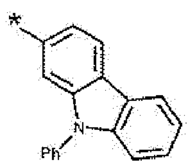
10-257
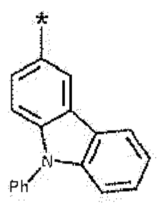
10-258
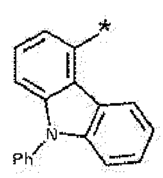
10-259
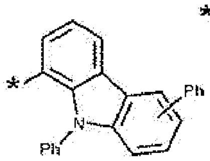
10-260
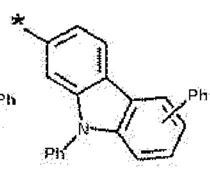
10-261

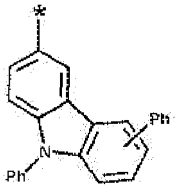
10-262

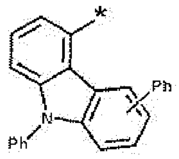
10-263

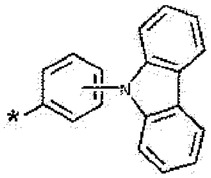
10-264

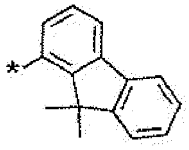
10-265

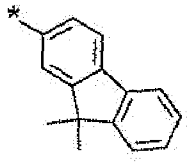
10-266

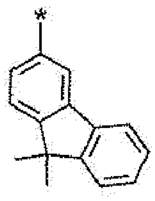
10-267

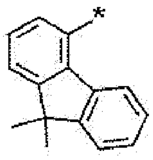
10-268

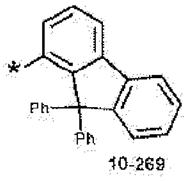
10-269

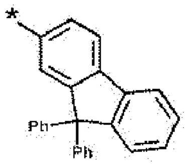
10-270

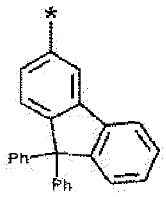
10-271

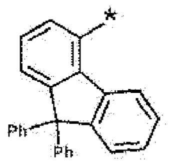
10-272

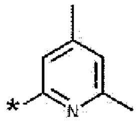
10-273

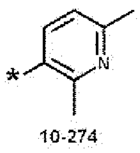
10-274

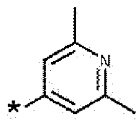
10-275

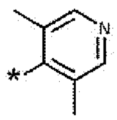
10-276

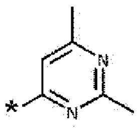
10-277

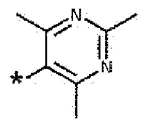
10-278

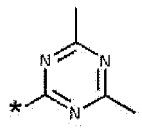
10-279

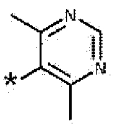
10-280

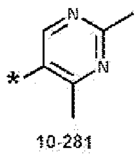
10-281

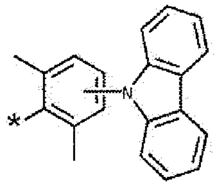
10-282

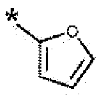
10-283

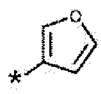
10-284

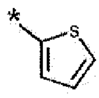
10-285

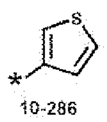
10-286

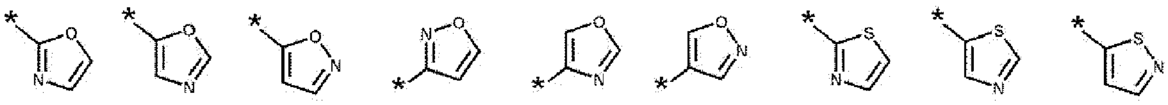
10-287 10-288 10-289 10-290 10-291 10-292 10-293 10-294 10-295

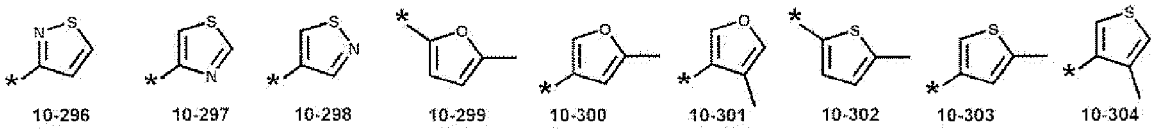
10-296 10-297 10-298 10-299 10-300 10-301 10-302 10-303 10-304

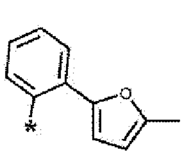
10-305

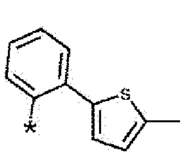
10-306

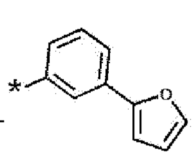
10-307

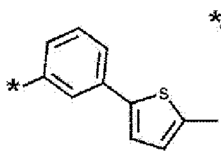
10-308

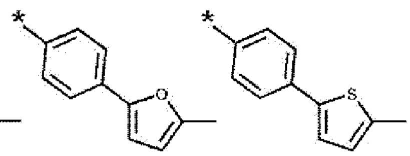
10-309

10-310

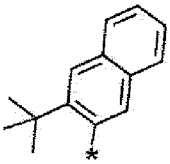
10-311

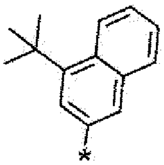
10-312

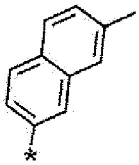
10-313

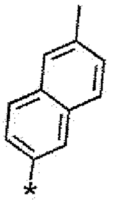
10-314

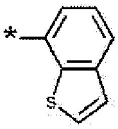
10-315

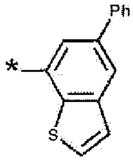
10-316

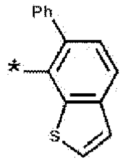
10-317

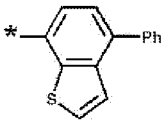
10-318

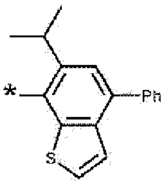
10-319

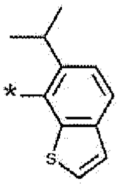
10-320

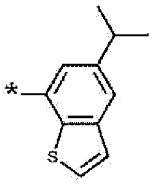
10-321

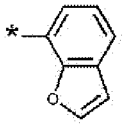
10-322

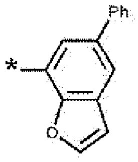
10-323

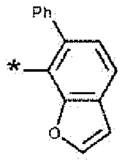
10-324

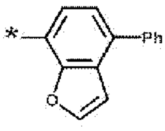
10-325

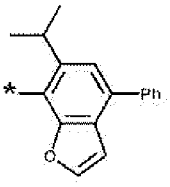
10-326

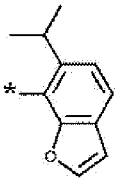
10-327

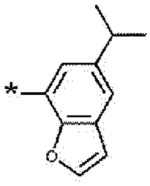
10-328

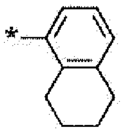
10-329

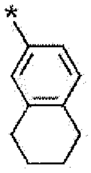
10-330

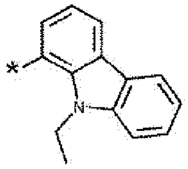
10-331

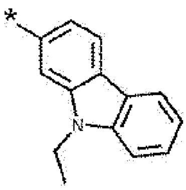
10-332

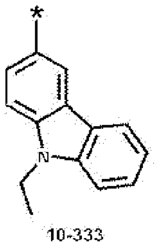
10-333

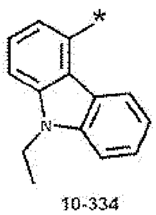
10-334

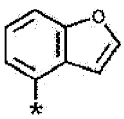
10-335

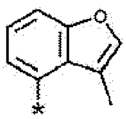
10-336

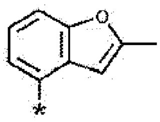
10-337

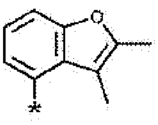
10-338

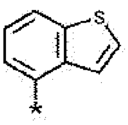
10-339

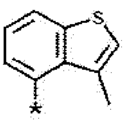
10-340

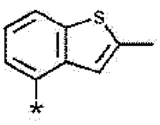
10-341

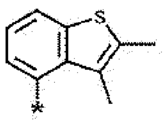
10-342

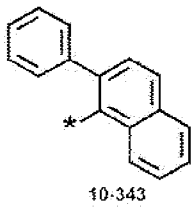
10-343

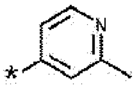
10-344

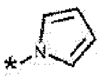
10-345

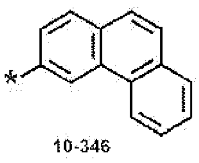
10-346

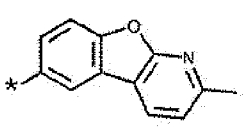
10-347

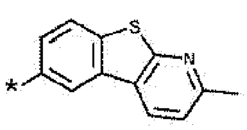
10-348

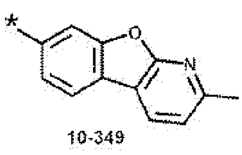
10-349

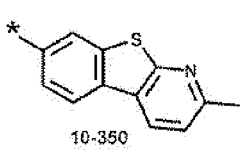
10-350

In Formulae 9-1 to 9-61, 9-201 to 9-244, 10-1 to 10-154, and 10-201 to 10-350, * indicates a binding site to an adjacent atom, "Ph" represents a phenyl group, "TMS" represents a trimethylsilyl group, and "TMG" represents a

trimethylgermyl group.

In one or more embodiments, at least one of $R_1$ to $R_5$ or at least one of $R_6$ to $R_{19}$ are each independently a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, or a substituted or unsubstituted $C_1$-$C_{60}$ alkylthio group.

In one or more embodiments, at least two of $R_1$ to $R_{19}$ may each independently be a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, or a substituted or unsubstituted $C_1$-$C_{60}$ alkylthio group. **In** one or more embodiments, at least three of $R_1$ to $R_{19}$ may each independently be a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, or a substituted or unsubstituted $C_1$-$C_{60}$ alkylthio group.

In one or more embodiments, at least one $R_{50}$ is a substituted or unsubstituted $C_1$-$C_{60}$ alkyl group (e.g. a $C_1$-$C_{60}$ alkyl group substituted with substituents other than an alkyl group), a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

In one or more embodiments, at least one of $R_{50}$ (e.g., $R_{53}$ in Formula 21 to be described later) may be a substituted or unsubstituted $C_1$-$C_{60}$ alkyl group (e.g. a $C_1$-$C_{60}$ alkyl group substituted with substituents other than an alkyl group), a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

In one or more embodiments, Formula 1 satisfies features (1) and (2), and further satisfies at least one (e.g., one or two) of features (3-1) and (3-2):

Feature (1)

At least one of $R_1$ to $R_5$ are each independently a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, or a substituted or unsubstituted $C_1$-$C_{60}$ alkylthio group,

Feature (2)

At least one of $R_{50}$ are each independently a substituted or unsubstituted $C_1$-$C_{60}$ alkyl group (e.g. a $C_1$-$C_{60}$ alkyl group substituted with substituents other than an alkyl group), a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group,

Feature (3-1)

At least one of R6 to R19 are each independently a substituted or unsubstituted C1-C60 alkyl group, a substituted or unsubstituted C2-C60 alkenyl group, a substituted or unsubstituted C2-C60 alkynyl group, a substituted or unsubstituted C1-C60 alkoxy group, or a substituted or unsubstituted C1-C60 alkylthio group,

Feature (3-2)

At least one of $R_{50}$ are each independently a $C_1$-$C_{60}$ alkyl group substituted with at least one substituent, the at least one substituent being each independently a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, or a $C_1$-$C_{60}$ heteroaryloxy group, a $C_1$-$C_{60}$ heteroarylthio group, each unsubstituted or substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, or a combination thereof.

Preferably, in feature (3-2), at least one of $R_{50}$ are each independently a $C_1$-$C_{60}$ alkyl group substituted with at least one substituent, the at least one substituent being each independently a $C_6$-$C_{60}$ aryl group unsubstituted or substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a combination thereof.

In feature (1), the at least one of $R_1$ to $R_5$ may be $R_2$ and/or $R_4$ in Formula 21 to be described later. In feature (2) or (3-2), the at least one of $R_{50}$ may be $R_{53}$ in Formula 21 to be described later. In feature (3-1), the at least one of $R_6$ to $R_{19}$ may be $R_6$, $R_7$, and/or $R_8$, such as $R_7$ in Formula 21 to be described later.

In Formula 1, at least two neighboring groups among $R_1$ to $R_{20}$, $R_{30}$, $R_{40}$, $R_{50}$, $R_{61}$, and $R_{62}$ are optionally bonded together to form a substituted or unsubstituted Cs-$C_{30}$ carbocyclic group or a substituted or unsubstituted $C_1$-$C_{30}$ heterocyclic group.

In Formula 1, b20, b30, b40, and b50 are each independently 1, 2, 3, 4, 5, 6, 7, 8, 9, or 10.

In one or more embodiments, b20, b30, b40, and b50 may each independently be 1, 2, 3, or 4.

In the present specification, substituents of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, the substituted monovalent non-aromatic condensed heteropolycyclic group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic condensed polycyclic group, and the substituted divalent non-aromatic condensed heteropolycyclic group are each independently:

deuterium, -F, -Cl, -Br, -I, $-SF_5$, $-CD_3$, $-CD_2H$, $-CDH_2$, $-CF_3$, $-CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid or a salt thereof, a sulfonic acid or a salt thereof, a phosphoric acid or a salt thereof, a $C_3$-$C_{10}$ cycloalkyl group, a $C_1$-$C_{10}$

heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$, $-Si(Q_{11})(Q_{12})(Q_{13})$, $-Ge(Q_{11})(Q_{12})(Q_{13})$, $-C(=O)(Q_{11})$, $-S(=O)(Q_{11})$, $-S(=O)_2(Q_{11})$, $-B(Q_{11})(Q_{12})$, $-P(Q_{11})(Q_{12})$, $-P(=O)(Q_{11})(Q_{12})$, $-P(=S)(Q_{11})(Q_{12})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, $-Si(Q_{21})(Q_{22})(Q_{23})$, $-Ge(Q_{21})(Q_{22})(Q_{23})$, $-C(=O)(Q_{21})$, $-S(=O)(Q_{21})$, $-S(=O)_2(Q_{21})$, $-B(Q_{21})(Q_{22})$, $-P(Q_{21})(Q_{22})$, $-P(=O)(Q_{21})(Q_{22})$, $-P(=S)(Q_{21})(Q_{22})$, or a combination thereof;

$-N(Q_{31})(Q_{32})$, $-Si(Q_{31})(Q_{32})(Q_{33})$, $-Ge(Q_{31})(Q_{32})(Q_{33})$, $-C(=O)(Q_{31})$, $-S(=O)(Q_{31})$, $-S(=O)_2(Q_{31})$, $-B(Q_{31})(Q_{32})$, $-P(Q_{31})(Q_{32})$, $-P(=O)(Q_{31})(Q_{32})$, or $-P(Q_{31})(Q_{32})$; or

a combination thereof.

In the present specification, $Q_1$ to $Q_3$, $Q_{11}$ to $Q_{13}$, $Q_{21}$ to $Q_{23}$, and $Q_{31}$ to $Q_{33}$ may each independently be: hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

For example, in the present specification, $Q_1$ to $Q_3$, $Q_{11}$ to $Q_{13}$, $Q_{21}$ to $Q_{23}$, and $Q_{31}$ to $Q_{33}$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or $-CD_2CDH_2$; or

an n-propyl group, an isopropyl group, an n-butyl group, a sec-butyl group, an isobutyl group, a tert-butyl group, an n-pentyl group, a tert-pentyl group, an neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{10}$ alkyl group, a phenyl group, or a combination thereof.

In one or more embodiments, the organometallic compound may be represented by Formula 11:

Formula 11

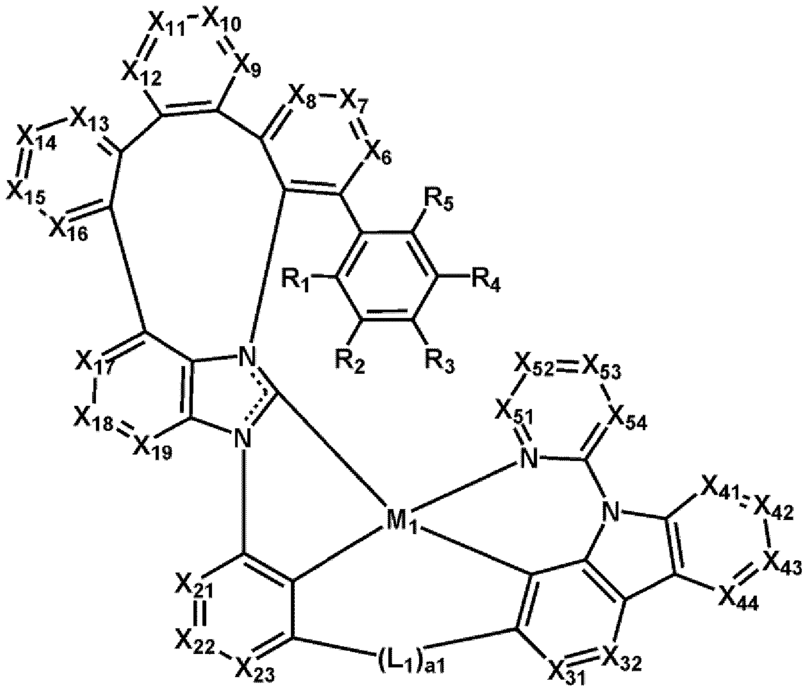

.

In Formula 11,

$M_1$, $X_6$ to $X_{19}$, $L_1$, a1, and $R_1$ to $R_5$ may each be the same as described elsewhere herein,
$X_{21}$ may be $C(R_{21})$ or N, $X_{22}$ may be $C(R_{22})$ or N, and $X_{23}$ may be $C(R_{23})$ or N,
$X_{31}$ may be $C(R_{31})$ or N, and $X_{32}$ may be $C(R_{32})$ or N,
$X_{41}$ may be $C(R_{41})$ or N, $X_{42}$ may be $C(R_{42})$ or N, $X_{43}$ may be $C(R_{43})$ or N, and $X_{44}$ may be $C(R_{44})$ or N,
$X_{51}$ may be $C(R_{51})$ or N, $X_{52}$ may be $C(R_{52})$ or N, $X_{53}$ may be $C(R_{53})$ or N, and $X_{54}$ may be $C(R_{54})$ or N,
$R_{21}$ to $R_{23}$ may each be the same as described in connection with $R_{20}$,
$R_{31}$ and $R_{32}$ may each be the same as described in connection with $R_{30}$,
$R_{41}$ to $R_{44}$ may each be the same as described in connection with $R_{40}$, and
$R_{51}$ to $R_{54}$ may each be the same as described in connection with $R_{50}$.

In one or more embodiments, the organometallic compound may be represented by Formula 21:

Formula 21

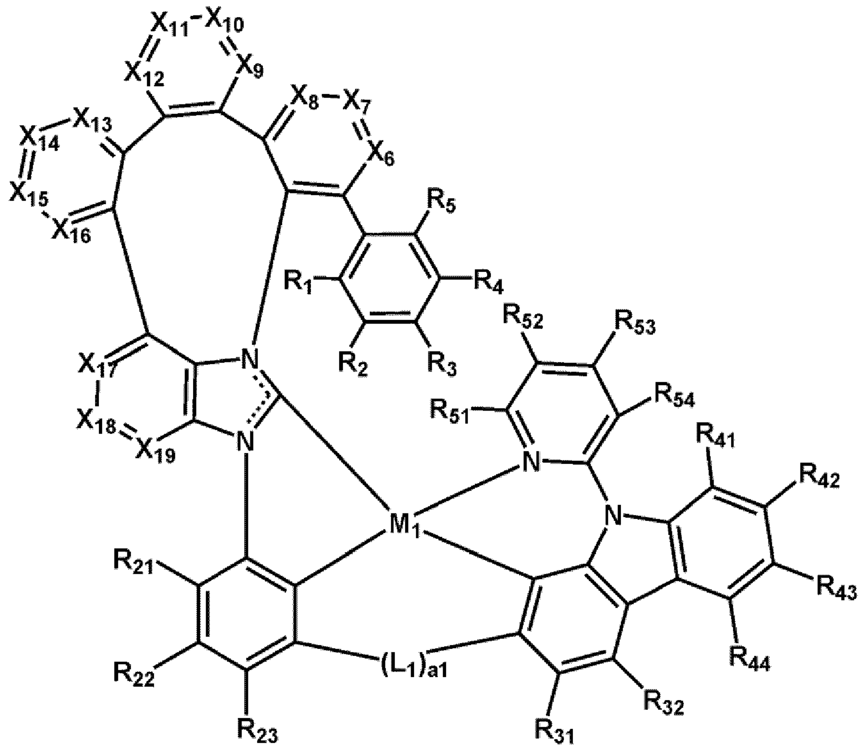

.

In Formula 21,

$M_1$, $X_6$ to $X_{19}$, $L_1$, a1, and $R_1$ to $R_5$ may each be the same as described herein,
$R_{21}$ to $R_{23}$ may each be the same as described in connection with $R_{20}$,
$R_{31}$ and $R_{32}$ may each be the same as described in connection with $R_{30}$,
$R_{41}$ to $R_{44}$ may each be the same as described in connection with $R_{40}$, and
$R_{51}$ to $R_{54}$ may each be the same as described in connection with $R_{50}$.

In one or more embodiments, the organometallic compound may include at least one of Compounds 1 to 53, but embodiments are not limited thereto:

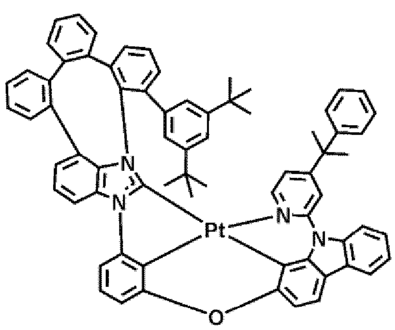

1

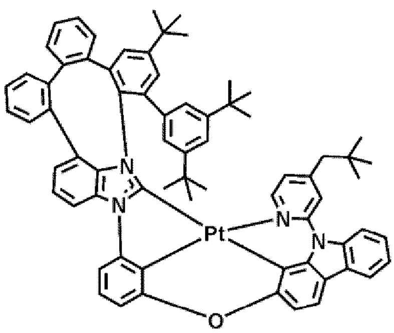

2

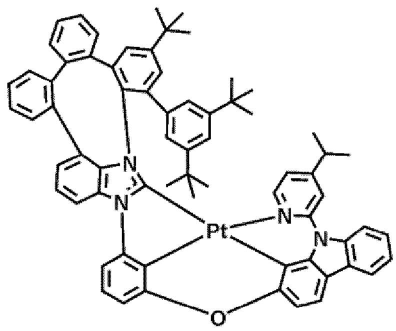

3

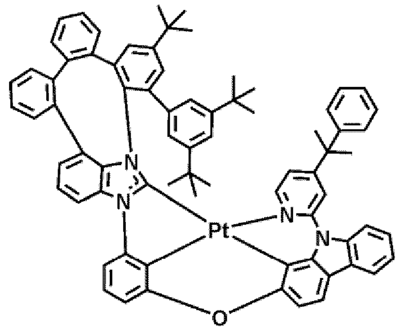

4

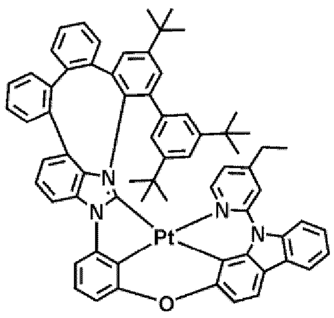

5

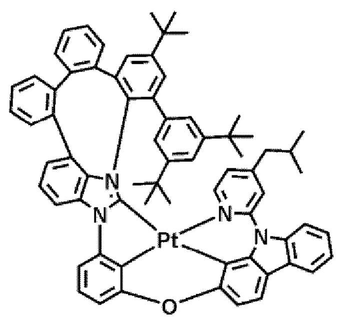

6

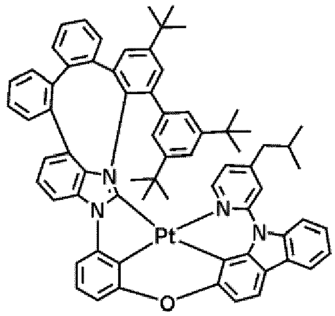

7

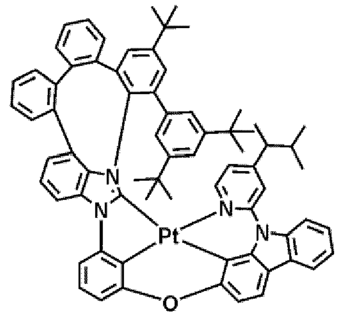

8

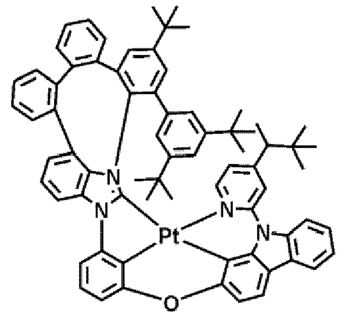

9

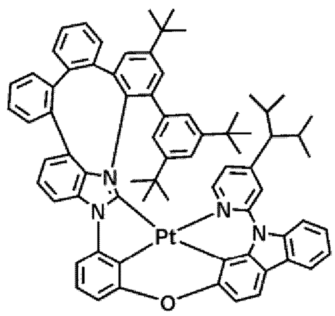

10

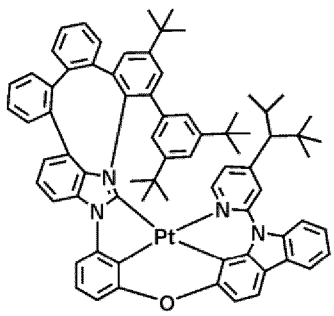

11

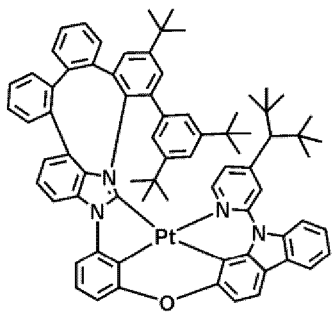

12

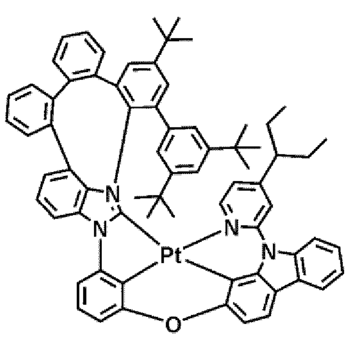

13

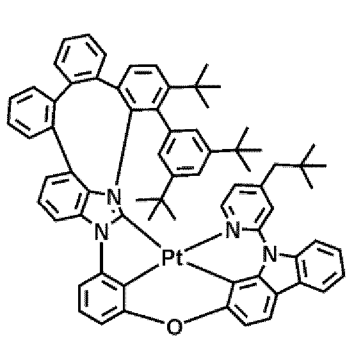

14

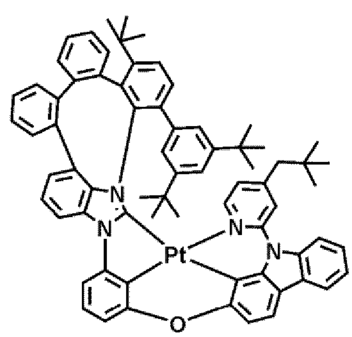

15

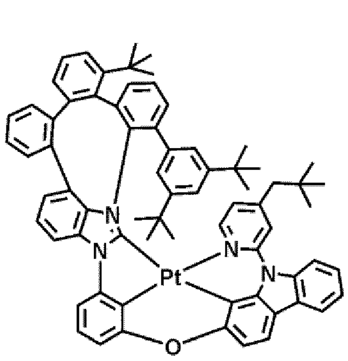

**16**

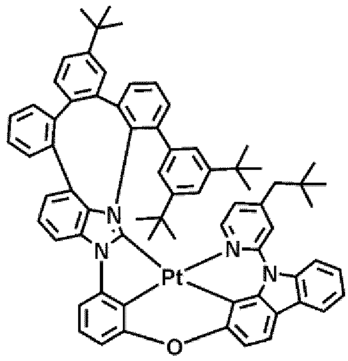

**17**

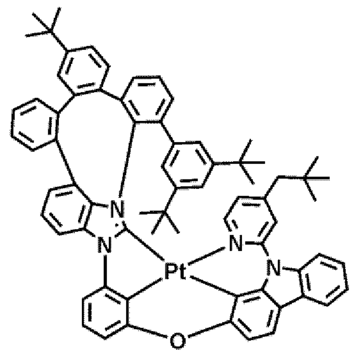

**18**

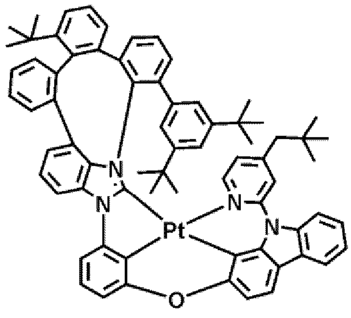

**19**

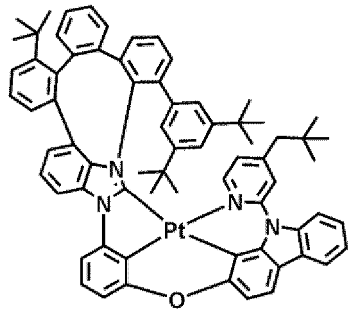

**20**

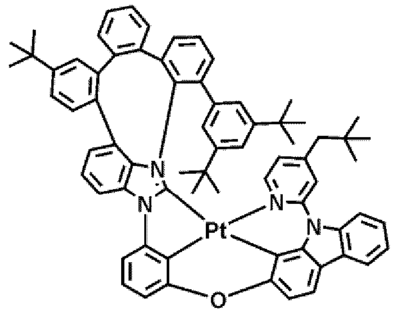

**21**

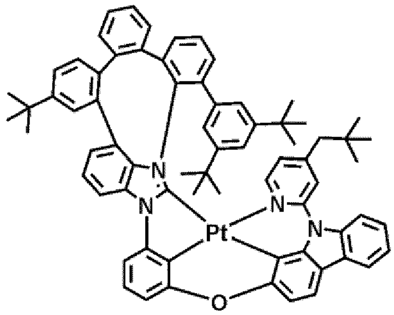

**22**

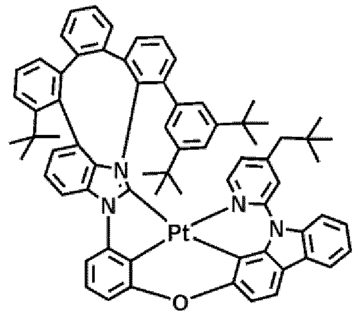

**23**

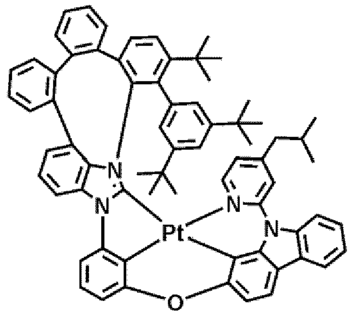

**24**

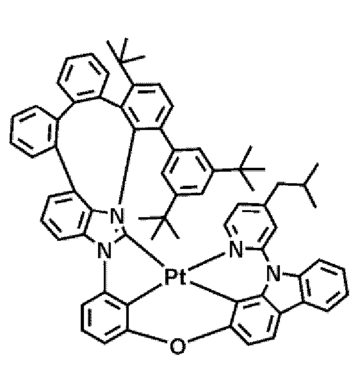

**25**

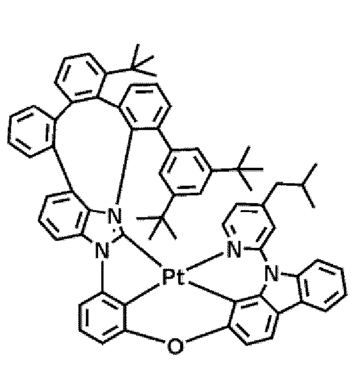

**26**

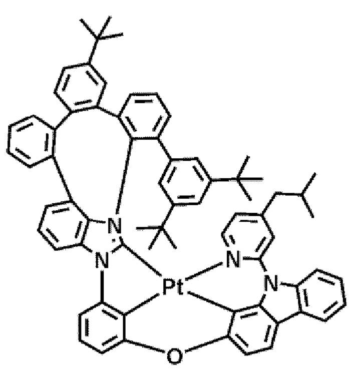

**27**

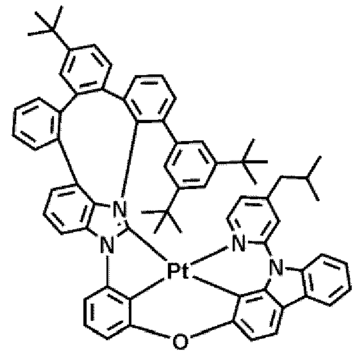

**28**

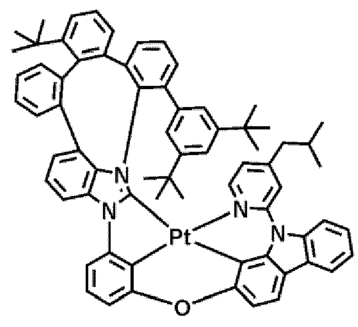

**29**

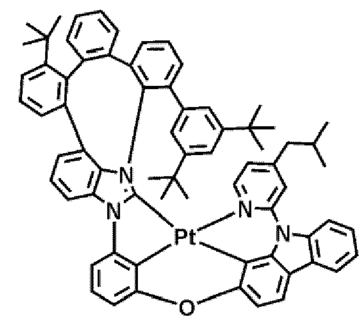

**30**

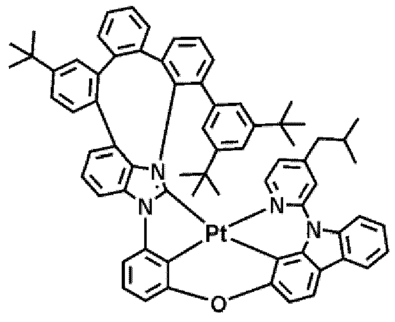

**31**

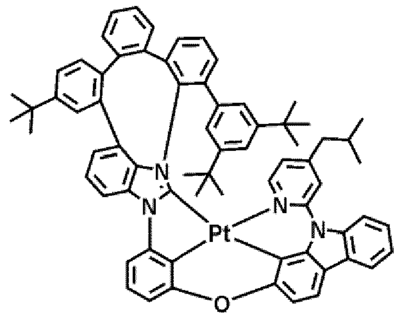

**32**

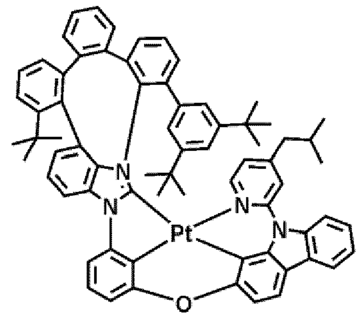

**33**

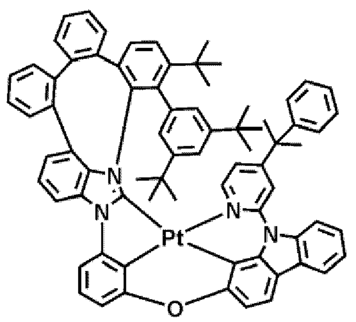

**34**

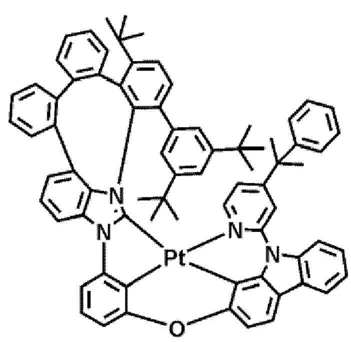

**35**

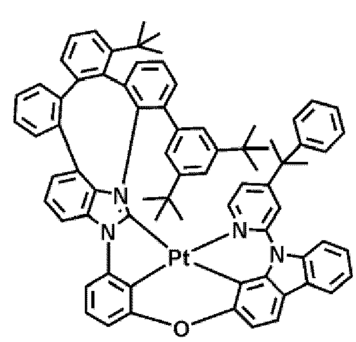

**36**

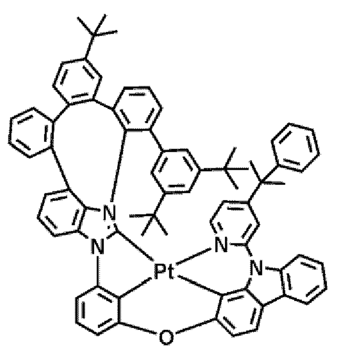

**37**

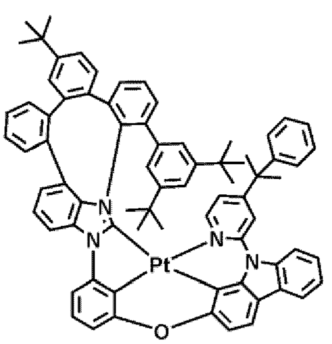

**38**

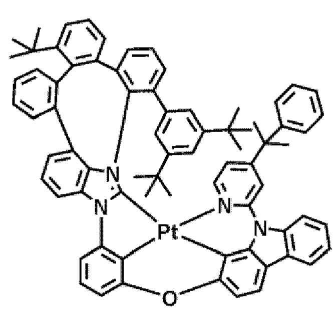

**39**

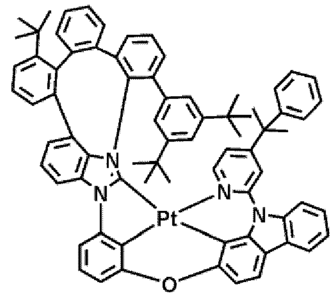

40

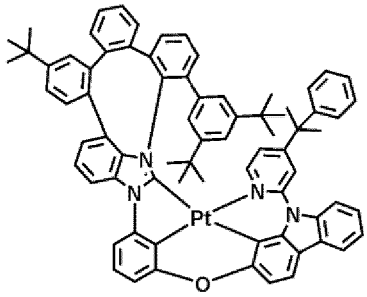

41

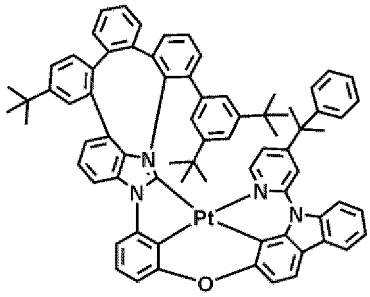

42

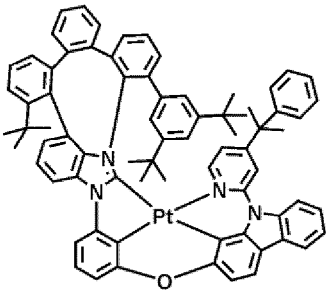

43

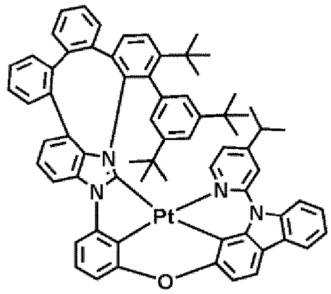

44

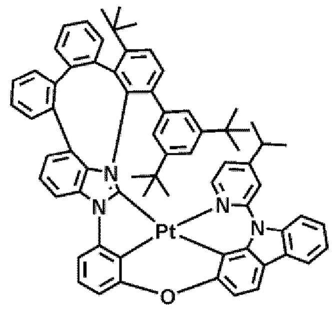

45

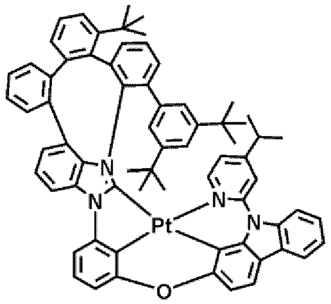

46

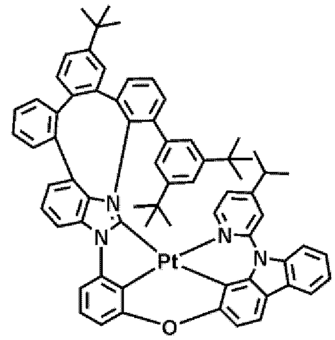

47

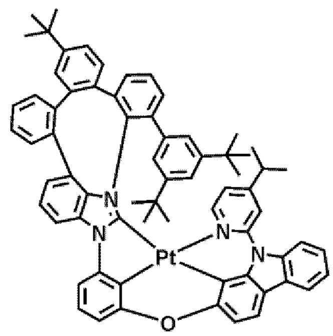

48

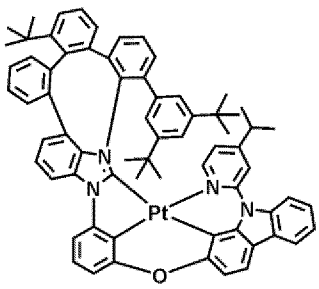

49

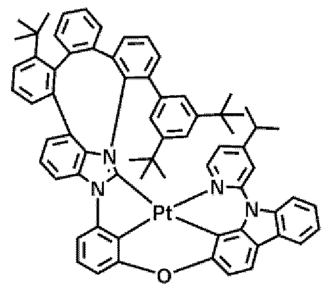

50

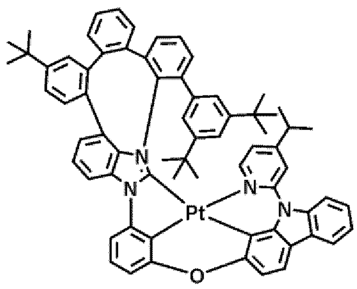

51

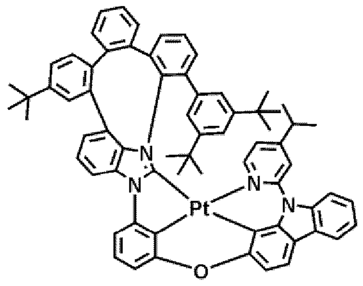

**52**

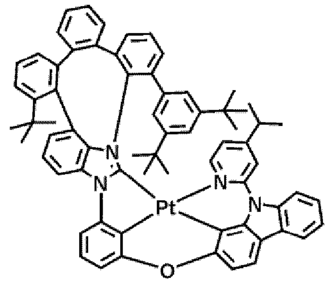

**53**

The organometallic compound according to one or more embodiments may be represented by Formula 1:

Formula 1

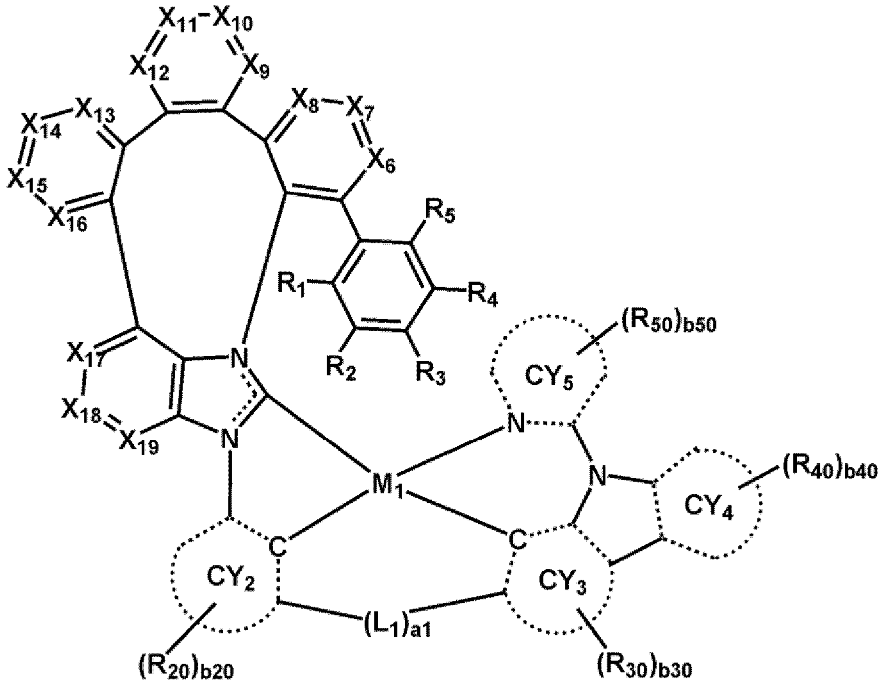

In Formula 1,

$M_1$ is a metal or a metalloid,
ring $CY_2$ to ring $CY_5$ are each independently a $C_5$-$C_{60}$ carbocyclic group or a $C_1$-$C_{60}$ heterocyclic group,
$X_6$ is $C(R_6)$ or N, $X_7$ is $C(R_7)$ or N, and $X_8$ is $C(R_8)$ or N,
$X_9$ is $C(R_9)$ or N, $X_{10}$ is $C(R_{10})$ or N, $X_{11}$ is $C(R_{11})$ or N, and $X_{12}$ is $C(R_{12})$ or N,
$X_{13}$ is $C(R_{13})$ or N, $X_{14}$ is $C(R_{14})$ or N, $X_{15}$ is $C(R_{15})$ or N, and $X_{16}$ is $C(R_{16})$ or N,
$X_{17}$ is $C(R_{17})$ or N, $X_{18}$ is $C(R_{18})$ or N, and $X_{19}$ is $C(R_{19})$ or N,
$L_1$ is a single bond, O, S, Se, $N(R_{61})$, $B(R_{61})$, $C(R_{61})(R_{62})$, or $Si(R_{61})(R_{62})$,
a1 is 1, 2, 3, 4, or 5,
$R_1$ to $R_{20}$, $R_{30}$, $R_{40}$, $R_{50}$, $R_{61}$, and $R_{62}$ are each independently hydrogen, deuterium, -F, -Cl, -Br, -I, $-SF_5$, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl

group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$,

(i) at least one of $R_1$ to $R_5$ and at least one of $R_6$ to $R_{19}$ are each independently a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, or a substituted or unsubstituted $C_1$-$C_{60}$ alkylthio group, or

(ii) at least one of $R_{50}$ is a substituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group,

at least two neighboring groups among $R_1$ to $R_{20}$, $R_{30}$, $R_{40}$, $R_{50}$, $R_{61}$, and $R_{62}$ are optionally bonded together to form a substituted or unsubstituted $C_5$-$C_{30}$ carbocyclic group or a substituted or unsubstituted $C_1$-$C_{30}$ heterocyclic group,
b20, b30, b40, and b50 are each independently 1, 2, 3, 4, 5, 6, 7, 8, 9, or 10,
at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ hetero arylthio group, the substituted monovalent non-aromatic condensed polycyclic group, and the substituted monovalent non-aromatic condensed heteropolycyclic group is:
deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;
a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{11})(Q_{12})(Q_{13})$, $-Ge(Q_{11})(Q_{12})(Q_{13})$, $-N(Q_{14})(Q_{15})$, $-B(Q_{16})(Q_{17})$, $-P(Q_{18})(Q_{19})$, $-P(=O)(Q_{18})(Q_{19})$, or a combination thereof;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a

monovalent non-aromatic condensed polycyclic group, or a monovalent non-aromatic condensed heteropolycyclic group, each substituted with deuterium, -F, -Cl, -Br, -I, $-SF_5$, $-CD_3$, $-CD_2H$, - $CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{21})(Q_{22})(Q_{23})$, - $Ge(Q_{21})(Q_{22})(Q_{23})$, $-N(Q_{24})(Q_{25})$, $-B(Q_{26})(Q_{27})$, $-P(Q_{28})(Q_{29})$, $-P(=O)(Q_{28})(Q_{29})$, or a combination thereof, or

$-Si(Q_{31})(Q_{32})(Q_{33})$, $-Ge(Q_{31})(Q_{32})(Q_{33})$, $-N(Q_{34})(Q_{35})$, $-B(Q_{36})(Q_{37})$, - $P(Q_{38})(Q_{39})$, or $-P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ are each independently hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

$M_1$, ring $CY_2$ to ring $CY_5$, $X_6$ to $X_{20}$, $L_1$, a1, $R_1$ to $R_{20}$, $R_{30}$, $R_{40}$, $R_{50}$, $R_{61}$, $R_{62}$, b20, b30, b40, and b50 are each the same as described herein.

The organometallic compound according to one or more embodiments satisfies the structure represented by Formula 1, and due to this structure, the organometallic compound may have excellent luminescence characteristics, may be suitable for implementing a deep blue color, and may have excellent charge transfer characteristics.

Although not limited to a particular theory, the organometallic compound includes a polycyclic carbene structure with a rigid structure as shown in Formula 1, so that the structural changes in an excited state may be reduced, and accordingly, non-luminescent transitions may be suppressed and molecular interactions may be also controlled due to steric hindrance effects. Also, since the organometallic compound of Formula 1 includes: (1) at least one of $R_1$ to $R_5$ and at least one of $R_6$ to $R_{19}$, or (2) at least one among $R_{50}$ in the number of b50, the organometallic compound may have improved luminescence efficiency and improved color purity. Furthermore, an organic light-emitting device with excellent characteristics, such as easy control of the emission wavelength for deep blue luminescence and improved lifespan characteristics, may be implemented. When the organometallic compound satisfies features (1) and (2) as defined, and further satisfies at least one of features (3-1) and (3-2) as defined, the organometallic compound and an electronic device such as an organic light-emitting device including the organometallic compound may have significantly excellent luminescence efficiency.

In one or more embodiments, a full width at half maximum (FWHM) of an emission peak of an emission spectrum or an electroluminescence spectrum of the organometallic compound may be 60 nanometers (nm) or less. For example, the FWHM of the emission peak of the emission spectrum or the electroluminescence spectrum of the organometallic compound may be in a range of about 5 nm to about 50 nm, about 7 nm to about 40 nm, or about 10 nm to about 30 nm.

Synthesis methods for the organometallic compound may be recognized by those skilled in the art with reference to Synthesis Examples to be described later.

A way to confirm the structure of the organometallic compound is not particularly limited. In one or more embodiments, the structure of the organometallic compound may be identified by a known method (e.g., NMR, LC-MS, etc.).

## Electronic apparatus

Another aspect of the disclosure provides an electronic apparatus including at least one of the organometallic compounds of Formula A or Formula 1.

In one or more embodiments, the electronic apparatus may be an organic light-emitting device (OLED), an

organic photodiode (OPD), or an organic solar cell (OSC).

Organic light-emitting device

Another aspect provides an organic light-emitting device including at least one of the organometallic compounds.
In one or more embodiments, the organic light-emitting device may include a first electrode; a second electrode; and an organic layer that is arranged between the first electrode and the second electrode, wherein the organic layer includes an emission layer, and
wherein the organic layer further includes at least one of the organometallic compounds represented by Formula A or Formula 1.
In one or more embodiments, the emission layer may include at least one of the organometallic compounds.
In one or more embodiments, the emission layer may include a host and an emitter, and the emitter may include at least one of the organometallic compounds.
In one or more embodiments, based on a weight, an amount of the host in the emission layer may be greater than an amount of the at least one organometallic compound in the emission layer.
In one or more embodiments, the emission layer may further include a sensitizer.
In one or more embodiments, the sensitizer may include a phosphorescent compound, a delayed fluorescence compound, or a combination thereof.
Detailed descriptions of the aforementioned host, emitter, and sensitizer may be as provided herein.
When the organic light-emitting device includes the emission layer including at least one of the aforementioned organometallic compounds, the organic light-emitting device may have a relatively narrow FWHM of an emission peak of an electroluminescence spectrum, excellent efficiency, and long lifespan characteristics.
In one or more embodiments, the at least one organometallic compound may serve as a dopant (e.g., an emitter or a sensitizer) in the emission layer, and the emission layer may further include a host (that is, in the emission layer, an amount of the at least one organometallic compound may be less than an amount of the host, based on weight).
In one or more embodiments, the emission layer may emit a blue light. In one or more embodiments, the emission layer may emit a blue light having a maximum emission wavelength of about 400 nm to about 490 nm. In one or more embodiments, the emission layer may emit a blue light having a maximum emission wavelength of about 430 nm to about 480 nm.
The expression "(an emission layer) includes at least one organometallic compound" as used herein may be interpreted as "(an emission layer) includes one type of the organometallic compound or two or more different types of the organometallic compounds."
For example, the emission layer may include, as the at least one organometallic compound, only Compound 1. In this regard, Compound 1 may be present in the emission layer of the organic light-emitting device. In one or more embodiments, the emission layer may include, as the at least one organometallic compound, Compound 1 and Compound 2. In this regard, Compound 1 and Compound 2 may be present in the emission layer of the organic light-emitting device, wherein Compound 1 and Compound 2 are different from each other.

Description of FIG. 1

FIG. 1 is a schematic cross-sectional view of an organic light-emitting device 10 according to one or more embodiments. Hereinafter, the structure and manufacturing method of the organic light-emitting device 10 according to one or more embodiments will be described in connection with FIG. 1.
In FIG. 1, the organic light-emitting device 10 includes a first electrode 11, a second electrode 19 facing the first electrode 11, and an organic layer 15 arranged between the first electrode 11 and the second electrode 19.
The organic layer 15 includes an emission layer, and may further include a hole transport region arranged between the first electrode 11 and the emission layer, and an electron transport region arranged between the emission layer and the second electrode 19.
A substrate may be additionally arranged under the first electrode 11 or on the second electrode 19. For use as the substrate, a substrate generally used in organic light-emitting devices, e.g., a glass substrate or a transparent plastic substrate, having excellent mechanical strength, thermal stability, transparency, surface smoothness, ease of handling, and/or water repellency may be used.

First electrode 11

The first electrode 11 may be formed by, for example, depositing or sputtering, onto the substrate, a material for forming the first electrode 11. The first electrode 11 may be an anode. The material for forming the first electrode 11 may be selected from materials with a high work function for easy hole injection.

The first electrode 11 may be a reflective electrode, a transflective electrode, or a transmissive electrode. In one or more embodiments, when the first electrode 11 is a transmissive electrode, the material for forming the first electrode 11 may include indium tin oxide (ITO), indium zinc oxide (IZO), tin oxide ($SnO_2$), zinc oxide (ZnO), or a combination thereof. In one or more embodiments, when the first electrode 11 is a transflective electrode or a reflective electrode, the material for forming the first electrode 11 may be one of magnesium (Mg), silver (Ag), aluminum (Al), aluminum-lithium (Al-Li), calcium (Ca), magnesium-indium (Mg-In), magnesium-silver (Mg-Ag), or a combination thereof, but embodiments are not limited thereto.

The first electrode 11 may have a single-layered structure or a multi-layered structure including two or more layers.

Emission layer 15

The emission layer 15 may include at least one of the organometallic compounds as described herein.

Description of FIG. 2

In one or more embodiments, the emission layer may include at least one of the organometallic compounds as an emitter.

In one or more embodiments, the emission layer may further include a host (hereinafter referred to as 'Host A', wherein Host A is not the same as the organometallic compound). Host A may be understood by referring to the description of the host material provided herein, but is not limited thereto.

Referring to FIG. 2, the energy transfer according to one or more embodiments is described as follows.

25 % of singlet excitons are formed in Host A of the emission layer, and these singlet excitons formed in Host A may be transferred to the organometallic compound through Förster energy transfer (or, Förster resonance energy transfer (FRET)). In addition, 75 % of triplet excitons formed in Host A of the emission layer may be transferred to the organometallic compound through Dexter energy transfer. Here, at least a part of the singlet energy of the organometallic compound may be transferred to the triplet energy by intersystem crossing (ISC), and the organometallic compound may accordingly emit phosphorescence. In one or more embodiment, at least a part of the triplet energy of the organometallic compound may be transferred to the singlet energy by reverse intersystem crossing (RISC), and the organometallic compound may accordingly emit delayed fluorescence (or thermally activated delayed fluorescence (TADF).

In one or more embodiments, a ratio of luminescent components emitted from the at least one organometallic compound to the total luminescent components emitted from the emission layer may be 80 % or more, for example, 90 % or more. In one or more embodiments, a ratio of luminescent components emitted from the at least one organometallic compound to the total luminescent components emitted from the emission layer may be 95 % or more.

Here, the organometallic compound may emit phosphorescence or delayed fluorescence, whereas the host may not emit light.

In one or more embodiments, when the emission layer further includes Host A in addition to the at least one organometallic compound, the amount of the at least one organometallic compound in the emission layer may be, based on 100 parts by weight of the emission layer, 50 parts by weight or less, for example, 30 parts by weight less or less, and the amount of Host A in the emission layer amount may be, based on 100 parts by weight of the emission layer, 50 parts by weight or more, for example, 70 parts by weight or more, but embodiments are not limited thereto.

Description of FIG. 3

In one or more embodiments, the organometallic compound may serve as a sensitizer, and the emission layer may further include a fluorescent emitter.

In one or more embodiments, the emission layer may further include a host (hereinafter referred to as 'Host B', wherein Host B is not the same as the at least one organometallic compound and the fluorescent emitter) and a fluorescent emitter (hereinafter referred to as 'Fluorescent emitter B', wherein Fluorescent emitter B is not the same as Host B and the at least one organometallic compound). Host B and Fluorescent emitter B may be understood by referring to a host material and a fluorescent emitter material described herein, but embodiments are not limited thereto.

In one or more embodiments, a ratio of luminescent components emitted from Fluorescent emitter B to the total emission luminescent components emitted from the emission layer may be 80 % or more, for example, 90 % or more (or for example, 95 % or more). For example, Fluorescent emitter B may emit fluorescence. In addition, Host D and Sensitizer B may each not emit a light.

Referring to FIG. 3, the energy transfer according to one or more embodiments is described as follows.

75 % proportion of triplet excitons formed in Host B of the emission layer may be transferred to the at least one organometallic compound through the Dexter energy transfer, and energy of 25 % proportion of singlet excitons formed in

Host B of the emission layer may be transferred to the singlet and triplet energy of the at last one organometallic compound, wherein at least a part of the energy transferred to the singlet energy of the at least one organometallic compound may be transferred to the triplet energy by ISC, and then, the triplet energy of the at least one organometallic compound may be transferred to Fluorescent emitter B by FRET. Also, at least a part of the triplet energy of the at least one organometallic compound may be transferred to the singlet energy first by RISC, and then, to the Fluorescent emitter B.

Accordingly, all of the singlet and triplet excitons generated in the emission layer may be transferred to the emitter, thereby obtaining the organic light-emitting device having improved efficiency. In addition, since an organic light-emitting device with significantly reduced energy loss can be obtained, the lifespan characteristics of the organic light-emitting device can be improved.

In one or more embodiments, the amount of the at least one organometallic compound in the emission layer may be selected within a range of about 5 wt% to about 50 wt%, for example, about 10 wt% to about 30 wt%, based on total weight of the emission layer. When the content is within this range, energy transfer in the emission layer may be effectively occurred. Thus, the organic light-emitting device may have high efficiency and long lifespan.

In one or more embodiments, an amount of Fluorescent emitter B in the emission layer may be selected within a range of about 0.01 wt% to about 15 wt%, for example, about 0.05 wt% to about 3 wt%, based on total weight of the emission layer, but embodiments are not limited thereto.

Description of FIG. 4

In one or more embodiments, the at least one organometallic compound may be used as a sensitizer, and the emission layer may further include a delayed fluorescence emitter.

In one or more embodiments, the emission layer may further include a host (hereinafter referred to as 'Host C', wherein Host C is not the same as the at least one organometallic compound and the delayed fluorescence emitter) and a delayed fluorescence emitter (hereinafter referred to as 'Delayed fluorescence emitter C', wherein Delayed fluorescence emitter C is not the same as Host C and the organometallic compound). Host C and Delayed fluorescence emitter C may be understood by referring to a host material and a delayed fluorescence emitter material described later, but embodiments are not limited thereto.

In one or more embodiments, a ratio of luminescent components emitted from Delayed fluorescent emitter C to the total luminescent components emitted from the emission layer may be 80 % or more, for example, 90 % or more (or for example, 95 % or more). For example, Fluorescent emitter C may emit fluorescence. In addition, Host D and Sensitizer B may not each emit a light.

Referring to FIG. 4, the energy transfer according to one or more embodiments is described as follows.

75 % proportion of triplet excitons formed in Host C of the emission layer may be transferred to the at least one organometallic compound through the Dexter energy transfer, and energy of 25 % proportion of singlet excitons formed in Host C of the emission layer may be transferred to the singlet and triplet energy of the at least one organometallic compound, wherein at least a part of the energy transferred to the singlet energy of the at least one organometallic compound may be transferred to the triplet energy by ISC, and then, the triplet energy of the at least one organometallic compound may be transferred to Delayed fluorescent emitter C by FRET. Also, at least a part of the triplet energy of the at least one organometallic compound may be transferred to the singlet energy first by RISC, and then, to the Delayed fluorescent emitter C.

Accordingly, all of the singlet and triplet excitons generated in the emission layer may be transferred to the emitter, thereby obtaining the organic light-emitting device having improved efficiency. In addition, since an organic light-emitting device with significantly reduced energy loss can be obtained, the lifespan characteristics of the organic light-emitting device can be improved.

In one or more embodiments, the amount of the at least one organometallic compound in the emission layer may be about 5 wt% to about 50 wt%, for example, about 10 wt% to about 30 wt%, based on total weight of the emission layer. When the content is within this range, energy transfer in the emission layer may be effectively occurred. Thus, the organic light-emitting device may have high efficiency and a long lifespan.

In one or more embodiments, an amount of Delayed fluorescence emitter C in the emission layer may be about 0.01 wt% to about 15 wt%, for example, about 0.05 wt% to about 3 wt%, based on total weight of the emission layer, but embodiments are not limited thereto.

Host in emission layer

In one or more embodiments, the host may not include a metal atom.

In one or more embodiments, the host may include at least one compound of a fluorene-containing compound, a carbazole-containing compound, a dibenzofuran-containing compound, a dibenzothiophene-containing compound, an indenocarbazole-containing compound, an indolocarbazole-containing compound, a benzofurocarbazole-containing

compound, a benzothienocarbazole-containing compound, an acridine-containing compound, a dihydroacridine-containing compound, a triindolobenzene-containing compound, a pyridine-containing compound, a pyrimidine-containing compound, a triazine-containing compound, a silicon-containing compound, a cyano group-containing compound, a phosphine oxide-containing compound, a sulfoxide-containing compound, or a sulfonyl-containing compound.

For example, the host may be a compound, which includes at least one carbazole ring and at least one cyano group, or a phosphine oxide-containing compound.

In one or more embodiments, the host may consist of one type of host. When the host consists of one type of host, the one type of host may be selected from among a bipolar host, an electron-transporting host, or a hole-transporting host, which will be described herein.

In one or more embodiments, the host may be a mixture of two or more types of different hosts. For example, the host may include a hole-transporting host, an electron-transporting host, a bipolar host, or a combination thereof.

In one or more embodiments, the host may be a mixture of an electron-transporting host and a hole-transporting host, a mixture of two types of different electron-transporting hosts, or a mixture of two types of different hole-transporting hosts. The electron-transporting host and the hole-transporting host may be understood by referring to the related description to be presented herein.

In one or more embodiments, the host may include an electron-transporting host including at least one electron-transporting moiety; and a hole-transporting host not including an electron-transporting moiety.

The electron-transporting moiety used herein may be a cyano group, a $\pi$ electron-deficient nitrogen-containing ring group, or a group represented by one of the following Formulae:

ET-moiety

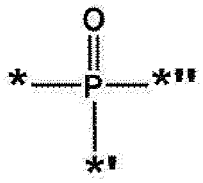 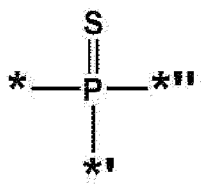 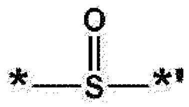 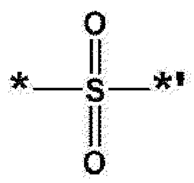

wherein, in the formulae above, *, *', and *'' each indicate a binding site to a neighboring atom.

In one or more embodiments, the electron-transporting host in the emission layer may include at least one of a cyano group or a $\pi$-electron deficient nitrogen-containing ring group.

In one or more embodiments, the electron-transporting host in the emission layer may include at least one cyano group.

In one or more embodiments, the electron-transporting host in the emission layer may include at least one cyano group and at least one $\pi$ electron-deficient nitrogen-containing ring group.

In one or more embodiments, in the emission layer, the hole-transporting host may include a hole-transporting moiety, and may not include an electron-transporting moiety.

The hole transporting moiety may be a $\pi$ electron-rich $C_3$-$C_{60}$ ring group or a group represented by Formula HT-moiety:

HT-moiety

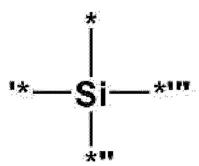

wherein, in the formulae above, *, *', *'', and *''' each indicate a binding site to a neighboring atom.

In one or more embodiments, the host may include an electron-transporting host and a hole-transporting host, wherein the electron-transporting host may include at least one $\pi$ electron-deficient nitrogen-free ring group and at least one electron-transporting moiety, and the hole-transporting host may include at least one $\pi$ electron-deficient nitrogen-free ring group and may not include an electron-transporting moiety.

The term "$\pi$ electron-deficient nitrogen-containing ring group" used herein refers to a ring group having at least one *-N=*' moiety, and for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a

naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group; or a condensed ring group in which two or more π electron- efficient nitrogen-containing ring groups are condensed with each other.

Meanwhile, the π electron-deficient nitrogen-free ring group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, a hexacene group, a pentacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group, or a condensed ring group of two or more π electron-deficient nitrogen-free ring groups, but embodiments of the disclosure are not limited thereto.

In one or more embodiments, when the host is a mixture of the electron-transporting host and the hole-transporting host, a weight ratio of the electron-transporting host to the hole-transporting host may be about 1:9 to about 9:1, for example, about 2:8 to about 8:2, or for example, about 4:6 to about 6:4, or for example, 5:5. When the weight ratio of the electron transport host and the hole transport host satisfies the above-described ranges, the hole-and-electron transport balance in the emission layer may be made.

In one or more embodiments, the bipolar host may include at least one electron-transporting moiety and at least one hole transport moiety.

In one or more embodiments, the host may include both a first compound and a second compound, wherein

i) the first compound may be a hole-transporting host, and the second compound may be an electron-transporting host,
ii) the first compound may be an electron-transporting host, and the second compound may be a hole transport host,
iii) the first compound and the second compound may each be a bipolar host,
iv) the first compound may be a hole-transporting host, and the second compound may be a bipolar host,
v) the first compound may be an electron-transporting host, and the second compound may be a bipolar host,
vi) the first compound may be a bipolar host, and the second compound may be a hole-transporting host, or
vii) the first compound may be a bipolar host, and the second compound may be an electron-transporting host.

The host may include at least one of 1,3,5-tri(1-phenyl-1H-benzo[d]imidazol-2-yl)benzene (TPBi), 3-tert-butyl-9,10-di(naphth-2-yl)anthracene (TBADN), 9,10-di(naphth-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazol-9-yl) benzene (TCP), 1,3-bis(N-carbazolyl)benzene (mCP), Compound H50, or Compound H51, but embodiments are not limited thereto:

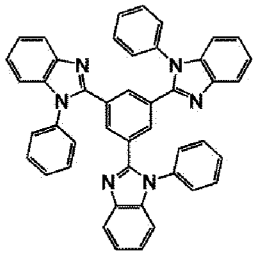
TPBi

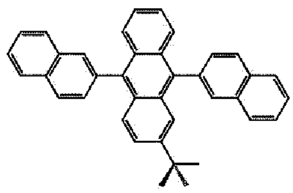
TBADN

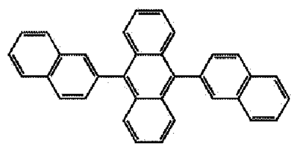
ADN

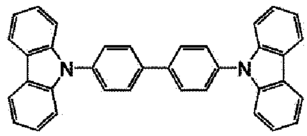

CBP

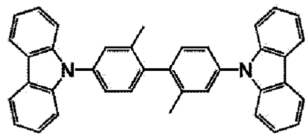

CDBP

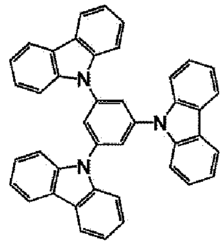

TCP

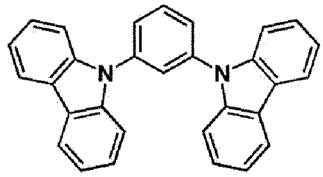

mCP

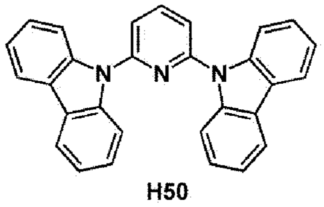

H50

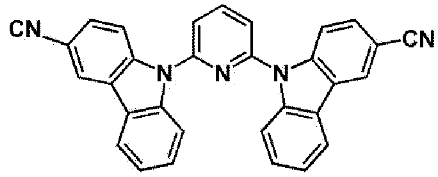

H51

.

In one or more embodiments, the host may further include a compound represented by Formula 301:

Formula 301

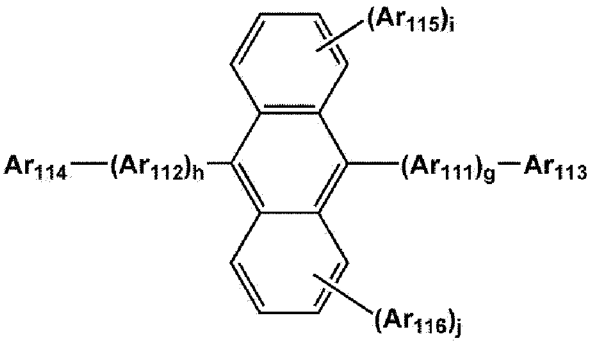

wherein $Ar_{111}$ and $Ar_{112}$ in Formula 301 may each independently be:

a phenylene group, a naphthylene group, a phenanthrenylene group, and a pyrenylene group; and
a phenylene group, a naphthylene group, a phenanthrenylene group, and a pyrenylene group, each substituted with at least one of a phenyl group, a naphthyl group, or an anthracenyl group.

$Ar_{113}$ to $Ar_{116}$ in Formula 301 may each independently be:

a $C_1$-$C_{10}$ alkyl group, a phenyl group, a naphthyl group, a phenanthrenyl group, and a pyrenyl group; and
a phenyl group, a naphthyl group, a phenanthrenyl group, and a pyrenyl group, each substituted with at least one of a phenyl group, a naphthyl group, or an anthracenyl group.

g, h, i, and j in Formula 301 may each independently be an integer from 0 to 4, and g, h, i, and j may each independently be, for example, 0, 1, or 2.

In some embodiments, $Ar_{113}$ to $Ar_{116}$ in Formula 301 may each independently be:

a $C_1$-$C_{10}$ alkyl group substituted with at least one of a phenyl group, a naphthyl group, or an anthracenyl group;
a phenyl group, a naphthyl group, an anthracenyl group, a pyrenyl group, a phenanthrenyl group, or a fluorenyl group;
a phenyl group, a naphthyl group, an anthracenyl group, a pyrenyl group, a phenanthrenyl group, or a fluorenyl group, each substituted with at least one of deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a

sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a phenyl group, a naphthyl group, an anthracenyl group, a pyrenyl group, a phenanthrenyl group, or a fluorenyl group; or

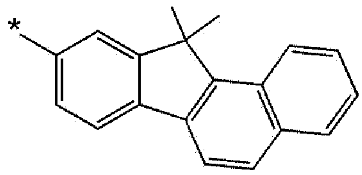

,

but embodiments of the disclosure are not limited thereto.

In one or more embodiments, the host may include a compound represented by Formula 302:

Formula 302

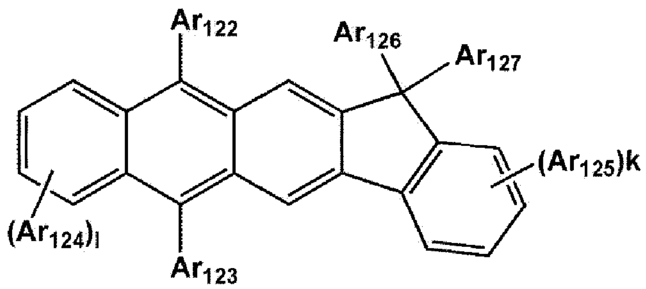

.

In Formula 302, $Ar_{122}$ to $Ar_{125}$ may each be the same as described in connection with $Ar_{113}$ in Formula 301.

In Formula 302, $Ar_{126}$ and $Ar_{127}$ may each independently be hydrogen, deuterium, -F, -Cl, -Br, -I, -$SF_5$, a hydroxyl group, a cyano group, a nitro group, an amidino group, a hydrazine group, a hydrazone group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

In one or more embodiments, $Ar_{126}$ and $Ar_{127}$ may each independently be a $C_1$-$C_{10}$ alkyl group (e.g., a methyl group, an ethyl group, a propyl group, or the like).

In Formula 302, k and l may each independently be an integer from 0 to 4. For example, k and l may each independently be 0, 1, or 2.

In one or more embodiments, the host may include at least one compound of Compounds H1 to H108 and Compounds E1 to E47, but embodiments are not limited thereto:

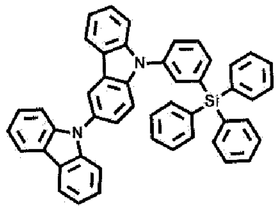

H1

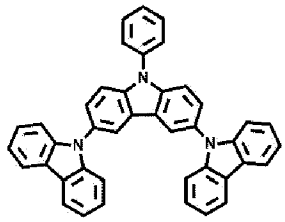

H2

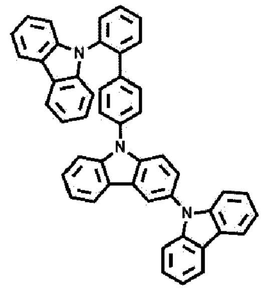

H3

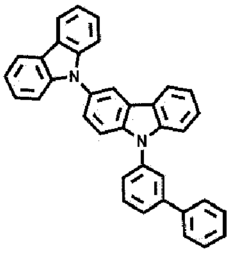

H4

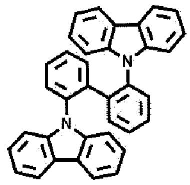

H5

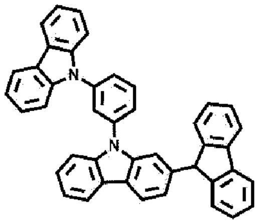

H6

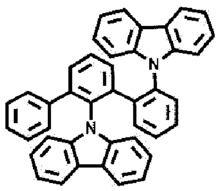

H7

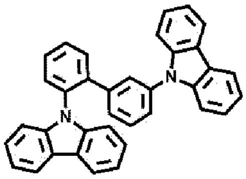

H8

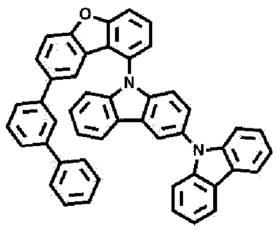

H9

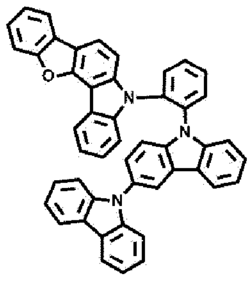

H10

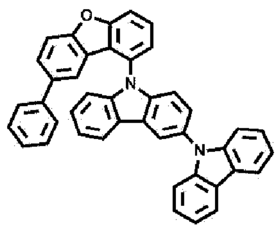

H11

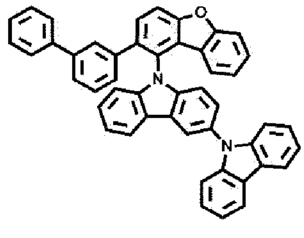

H12

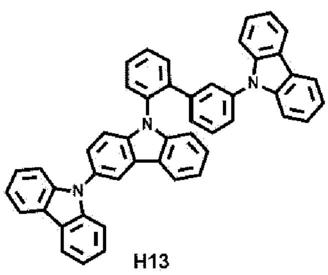

H13

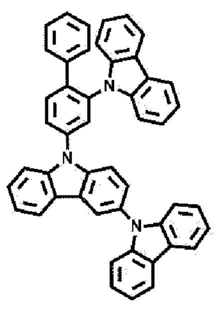

H14

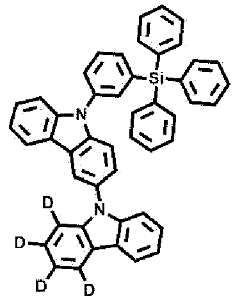

H15

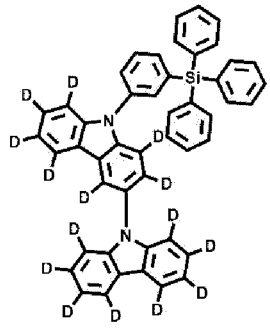

H16

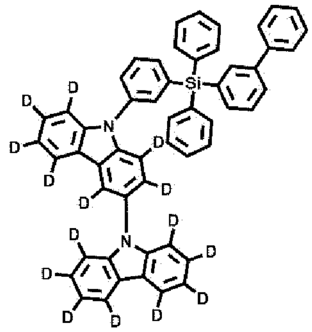

H17

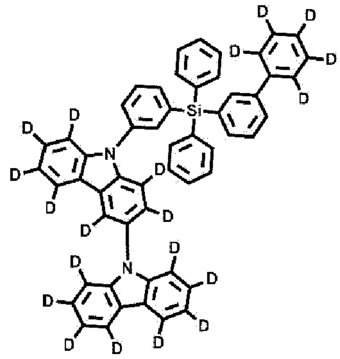

H18

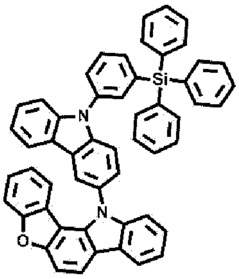

H19

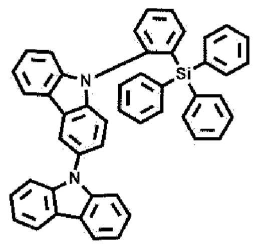

H20

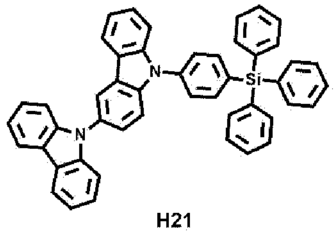

H21

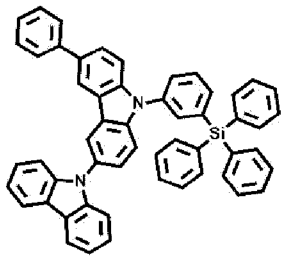

H22

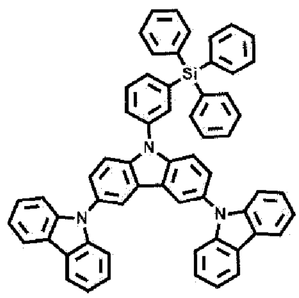

H23

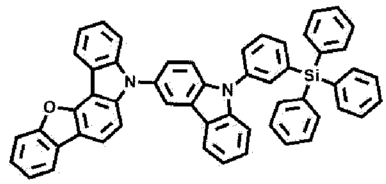

H24

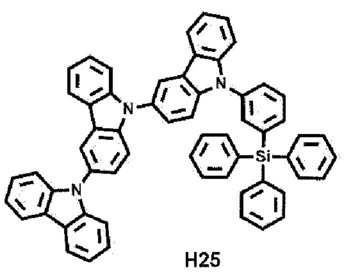

H25

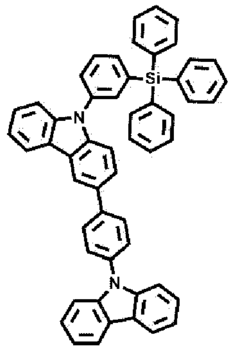

H26

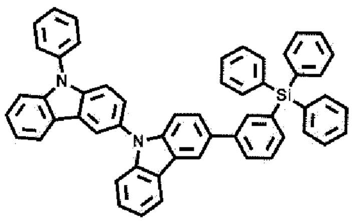

H27

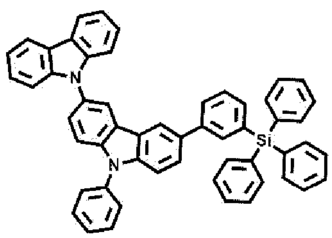

H28

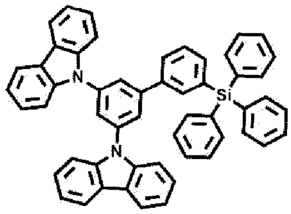

H29

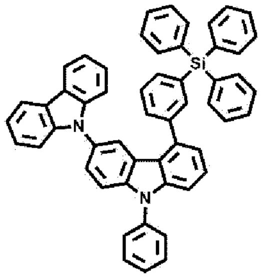

H30

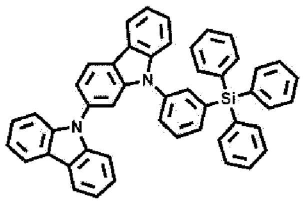

H31

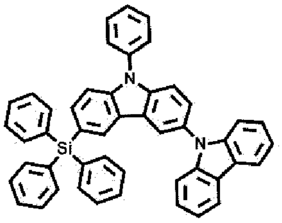

H32

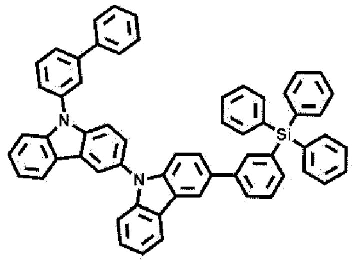

H33

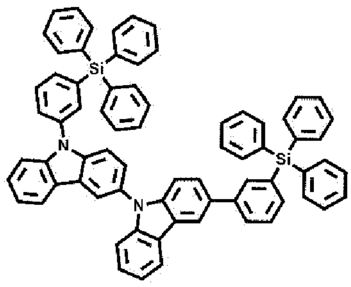

H34

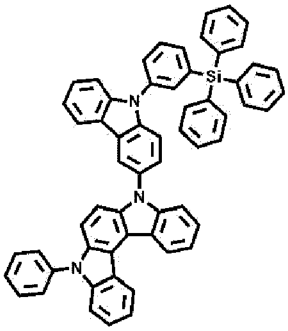

H35

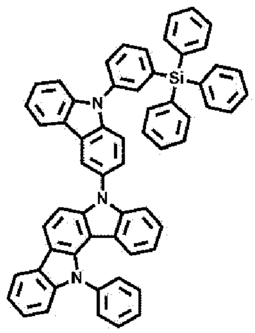

H36

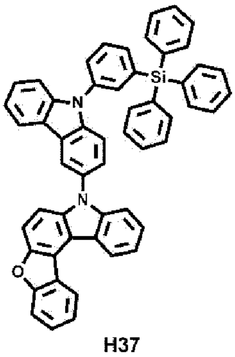

H37

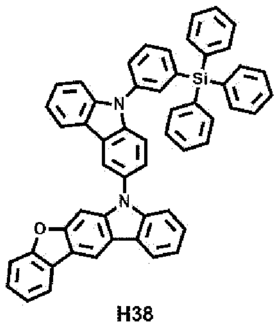

H38

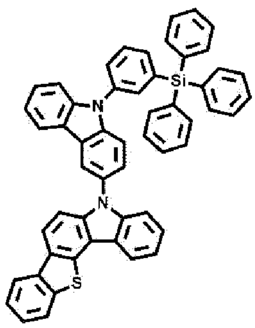

H39

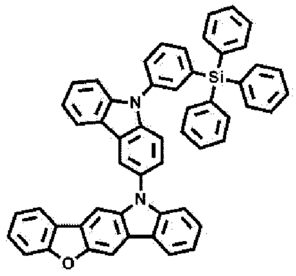
H40

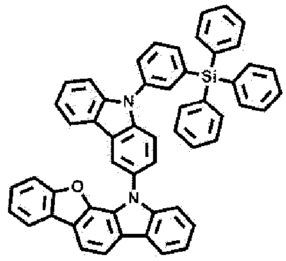
H41

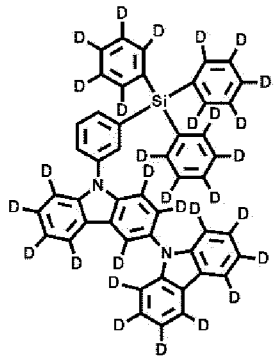
H42

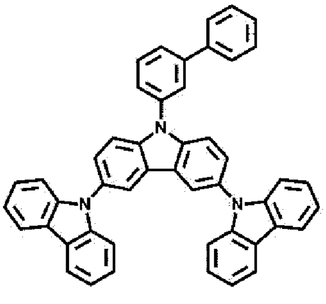
H43

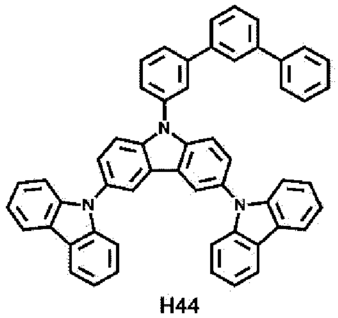
H44

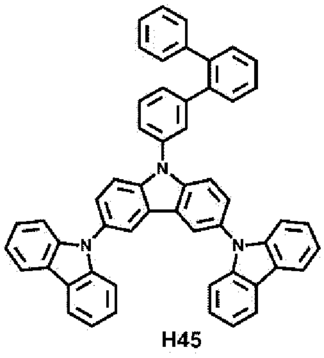
H45

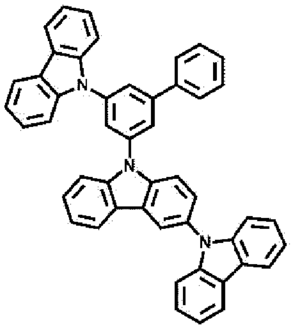
H46

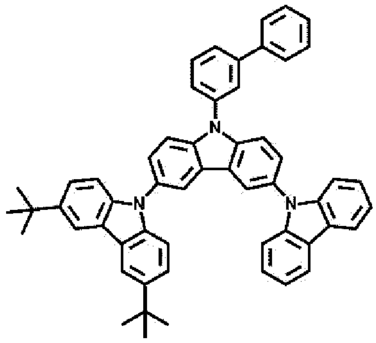
H47

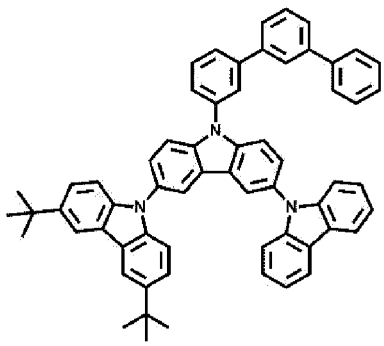
H48

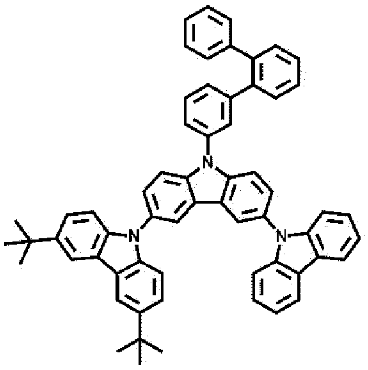
H49

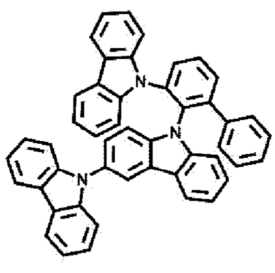
H50

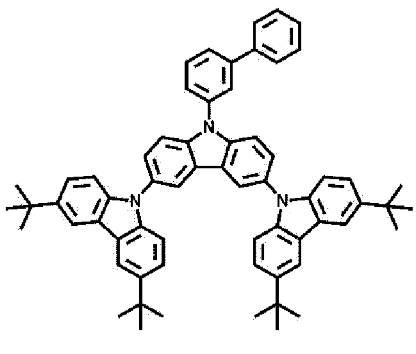
H51

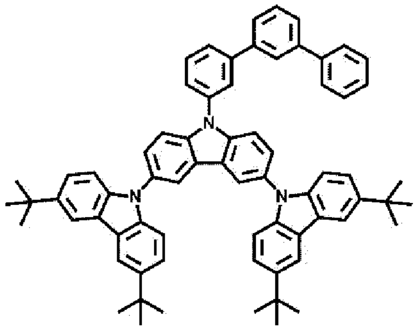

H52

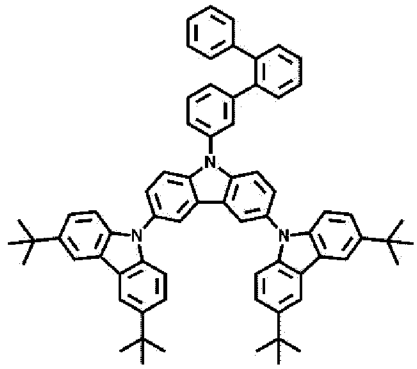

H53

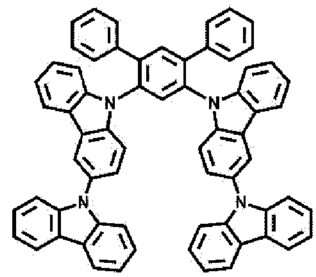

H54

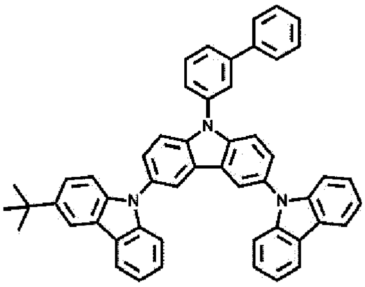

H55

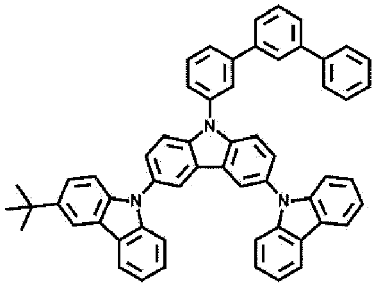

H56

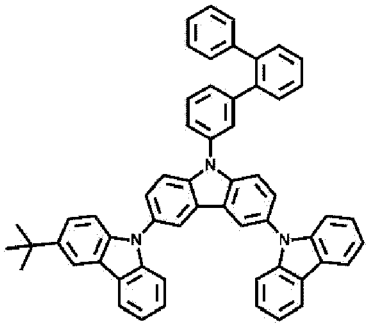

H57

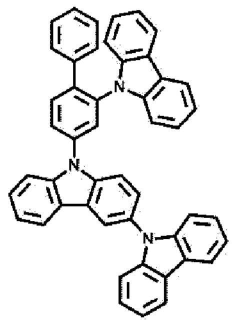

H58

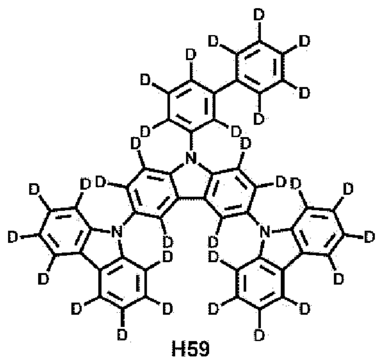

H59

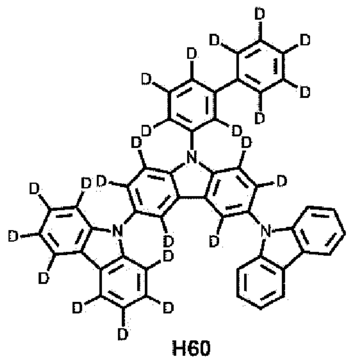

H60

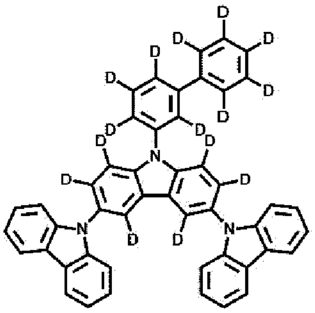

H61

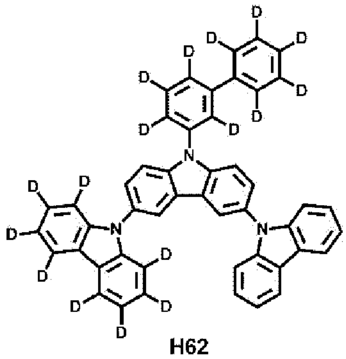

H62

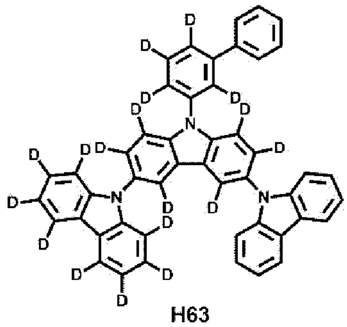

H63

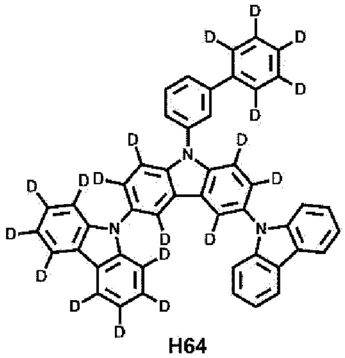

H64

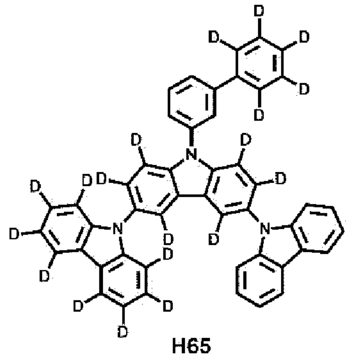

H65

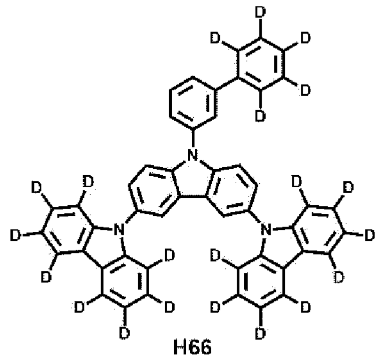

H66

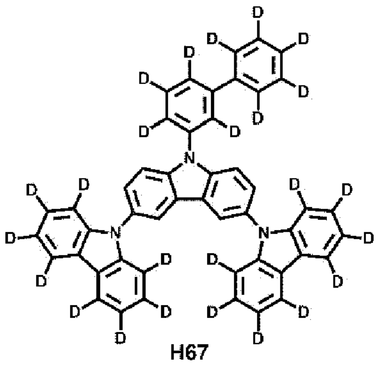

H67

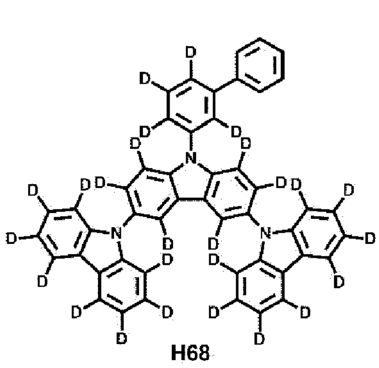

H68

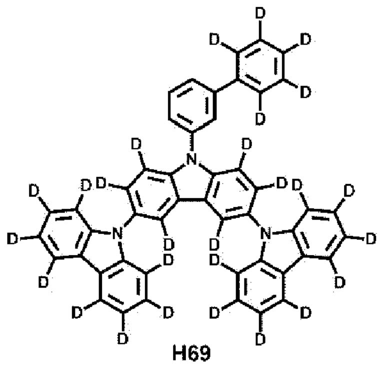

H69

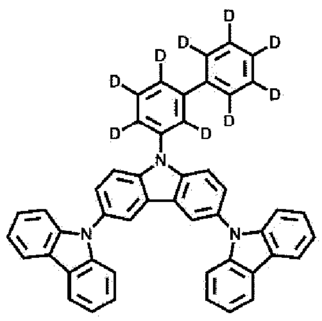

H70

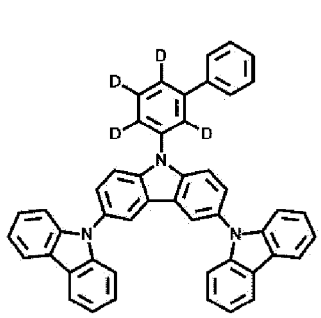

H71

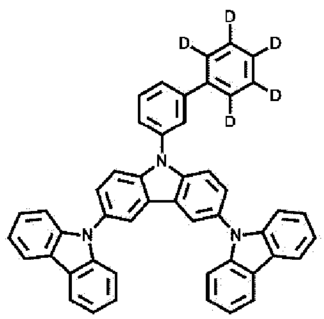

H72

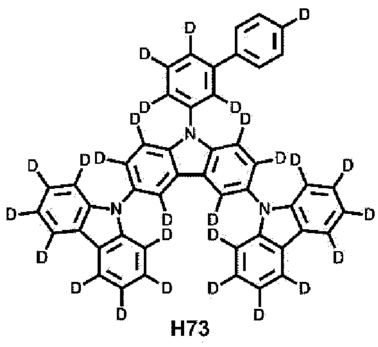

H73

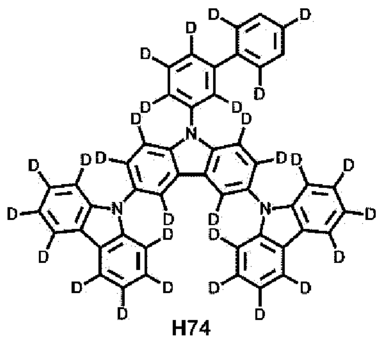

H74

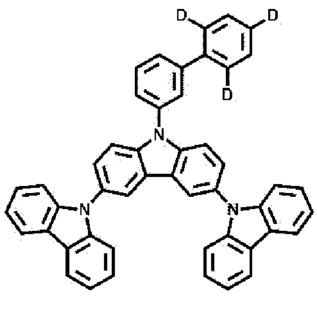

H75

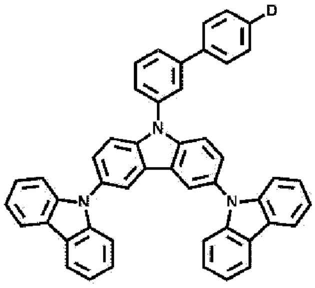
H76

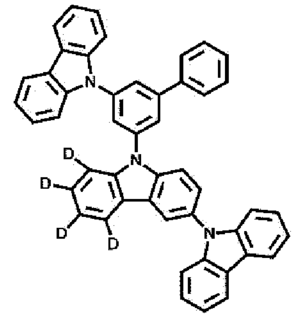
H77

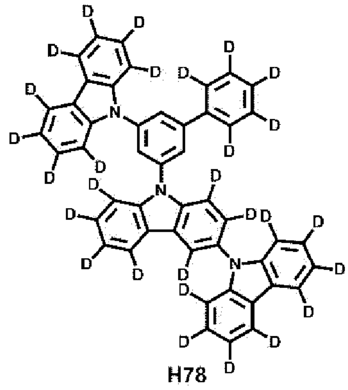
H78

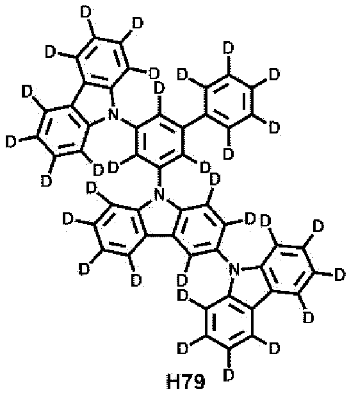
H79

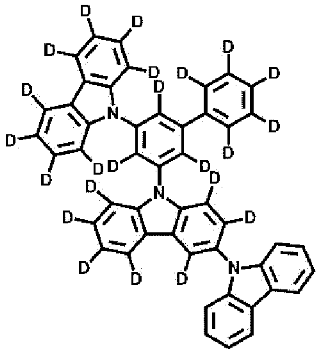
H80

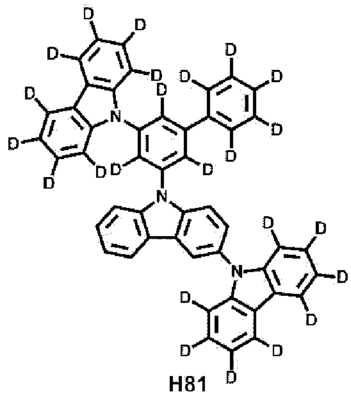
H81

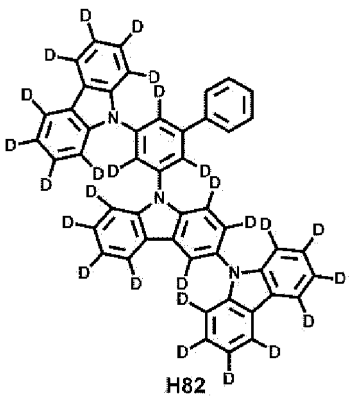
H82

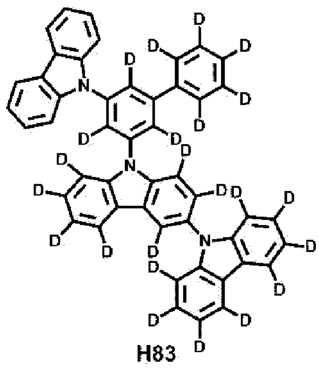
H83

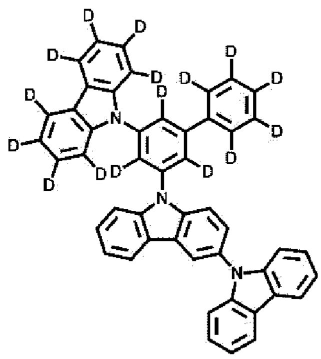
H84

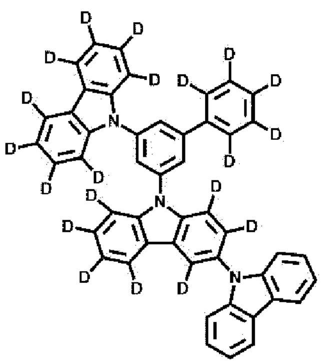
H85

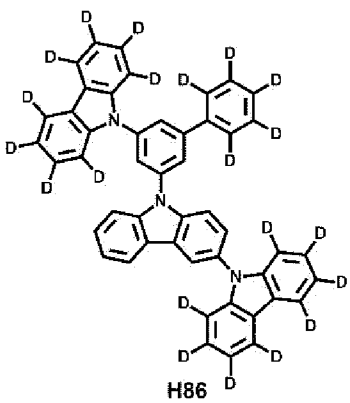
H86

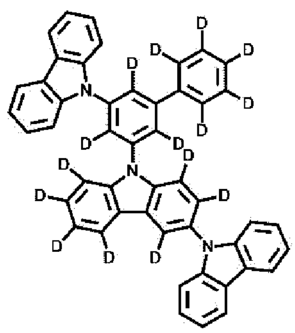
H87

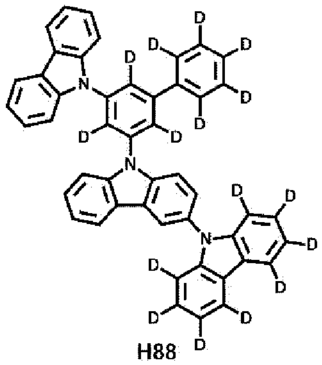
H88

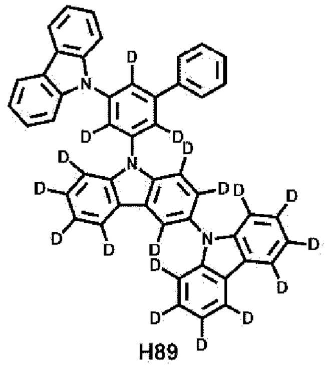
H89

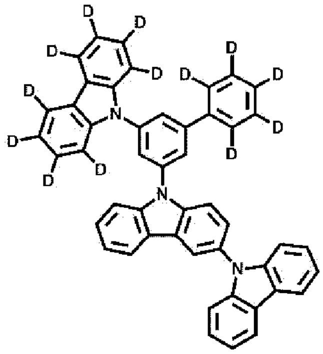
H90

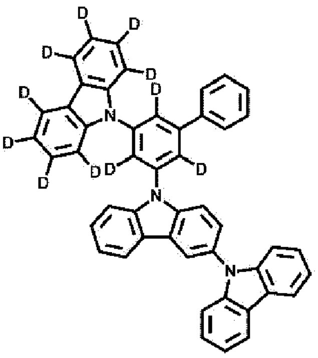
H91

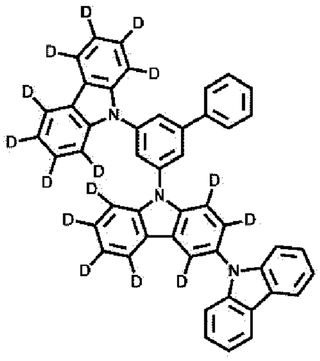
H92

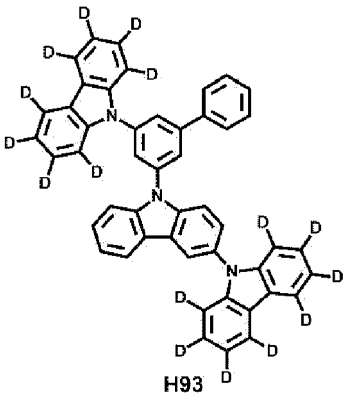
H93

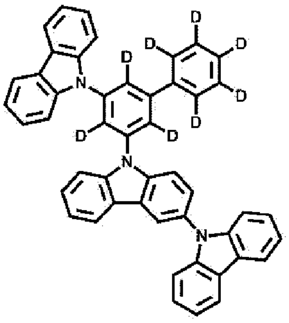
H94

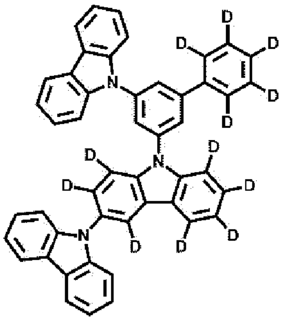
H95

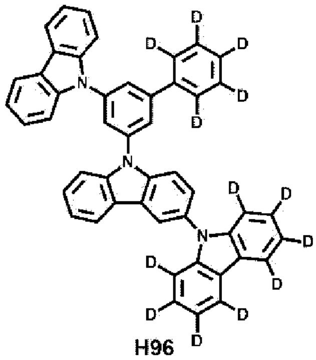
H96

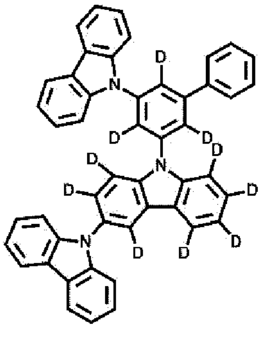
H97

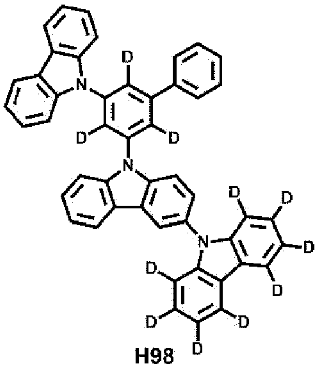
H98

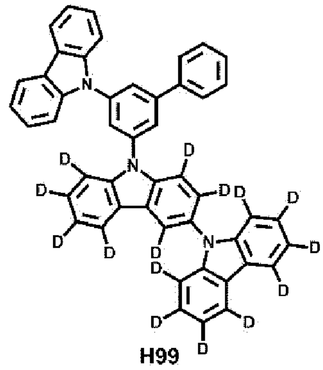
H99

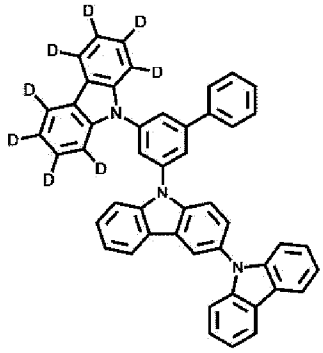

H100

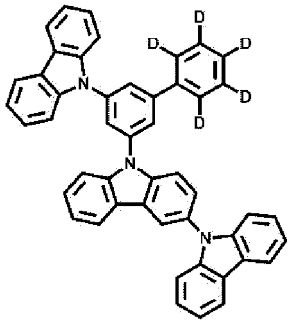

H101

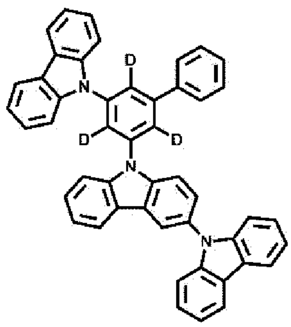

H102

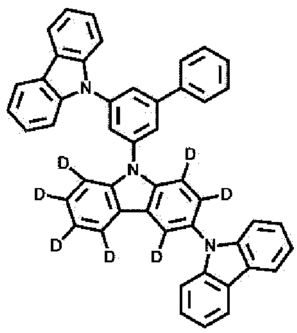

H103

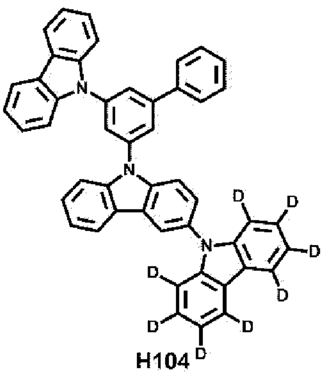

H104

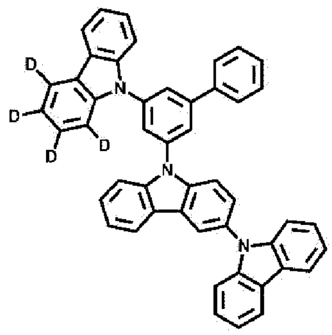

H105

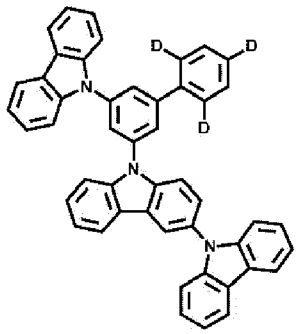

H106

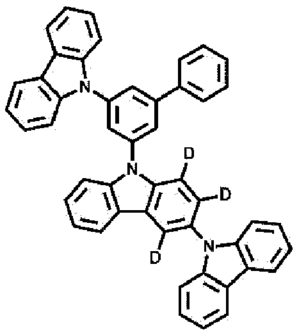

H107

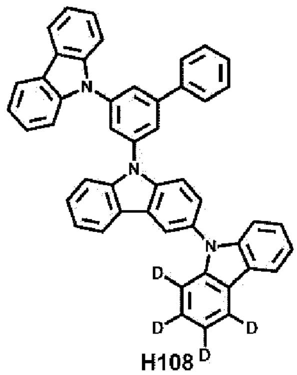

H108

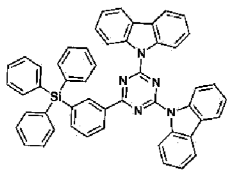

E1

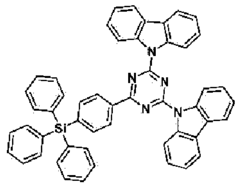

E2

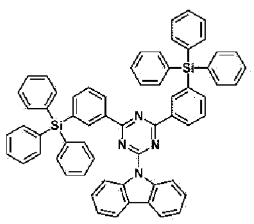

E3

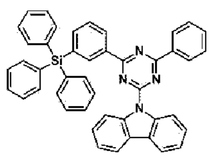

E4

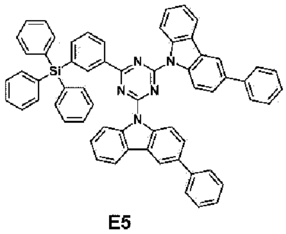
E5

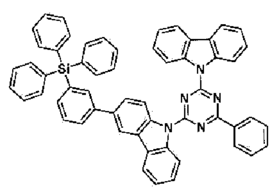
E6

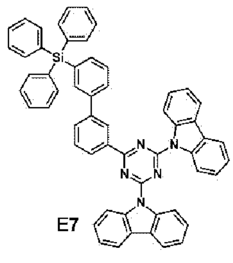
E7

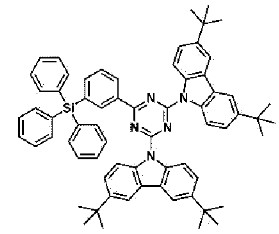
E8

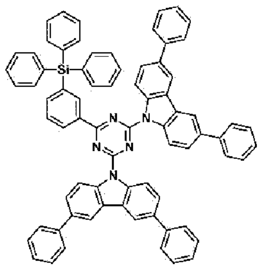
E9

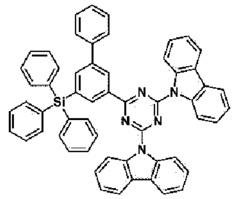
E10

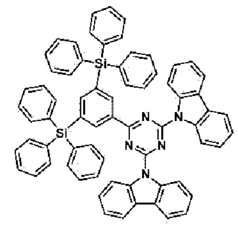
E11

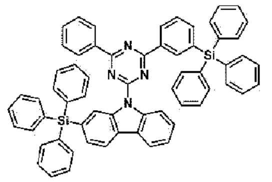
E12

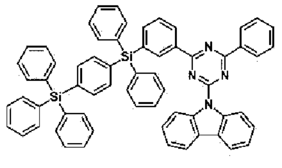
E13

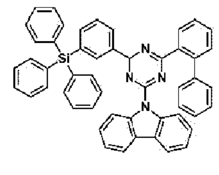
E14

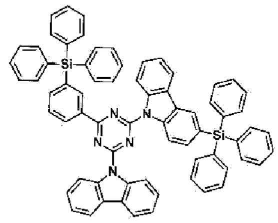
E15

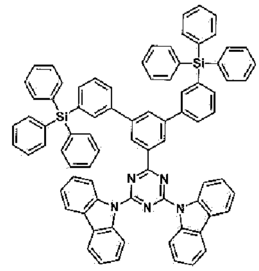
E16

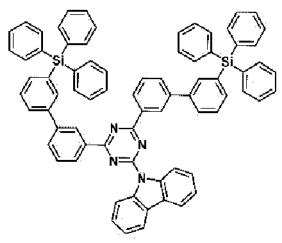
E17

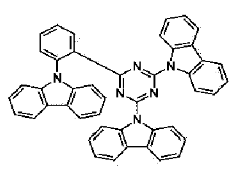
E18

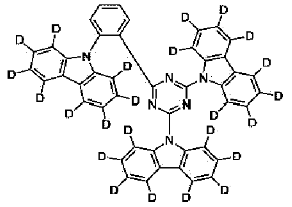
E19

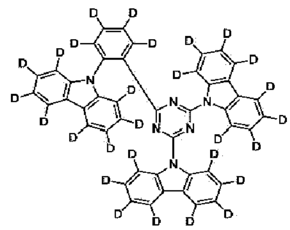
E20

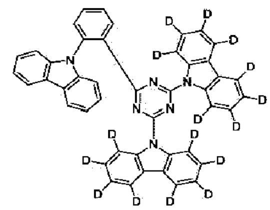
E21

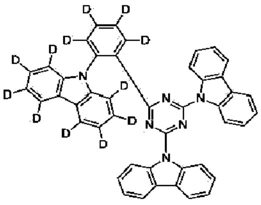
E22

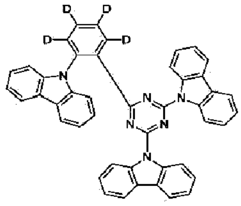
E23

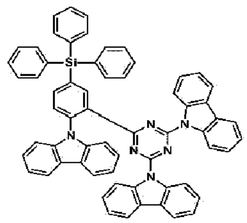
E24

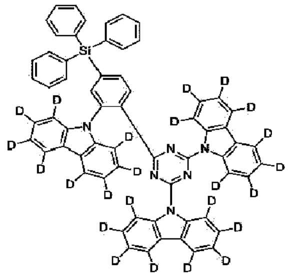
E25

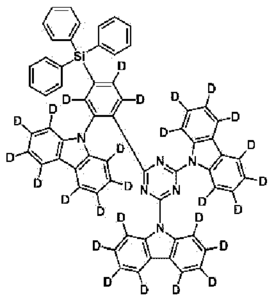
E26

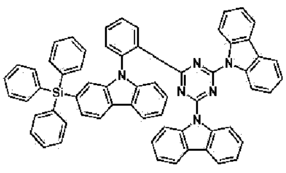
E27

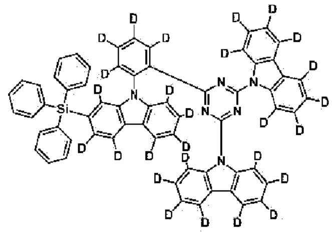
E28

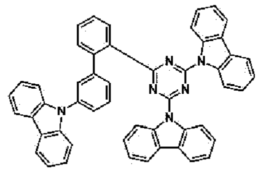
E29

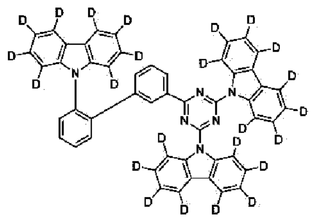
E30

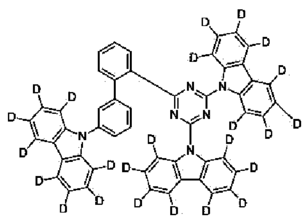
E31

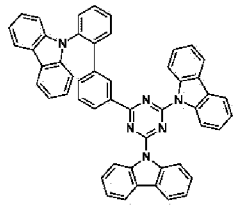
E32

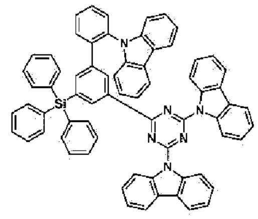
E33

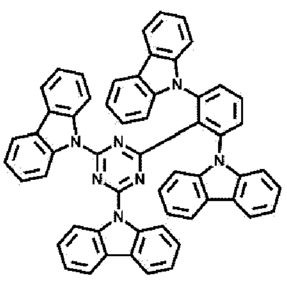
E34

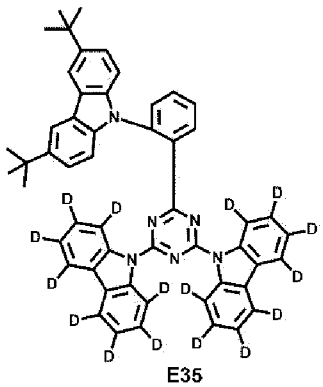
E35

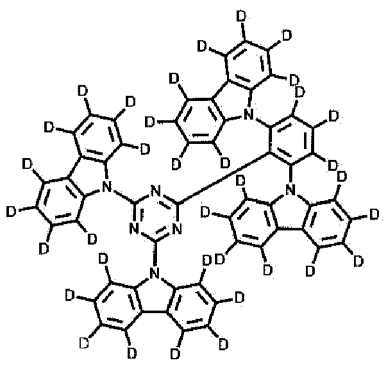
E36

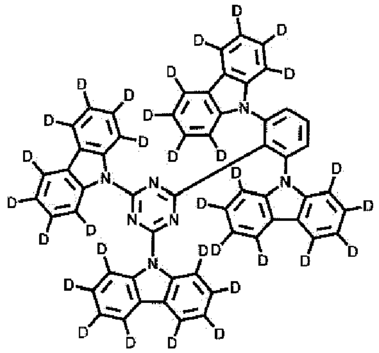

E37

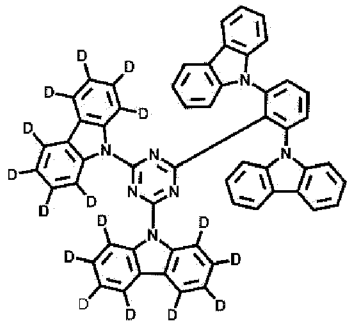

E38

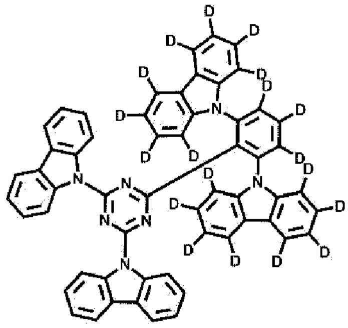

E39

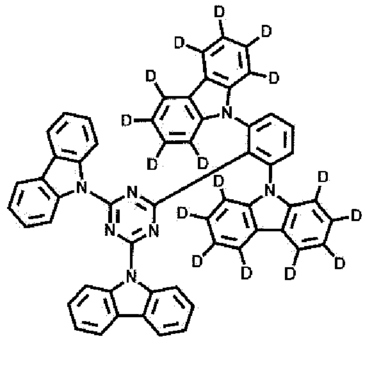

E40

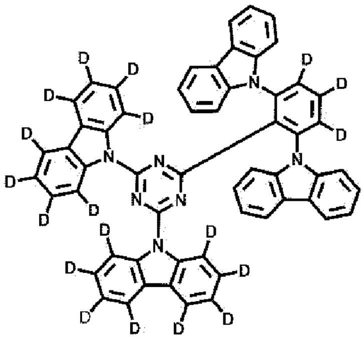

E41

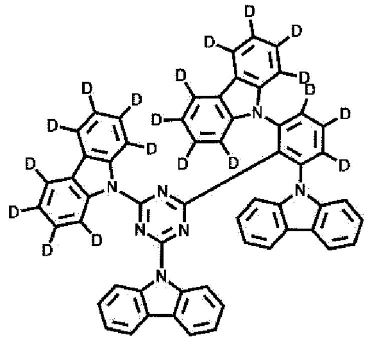

E42

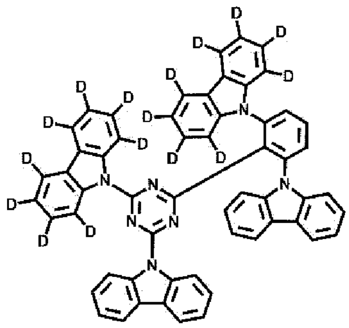

E43

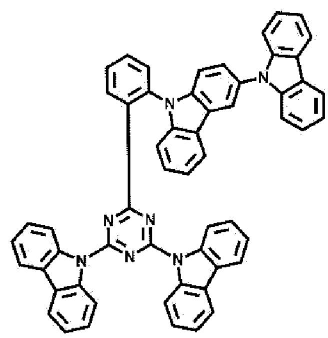

E44

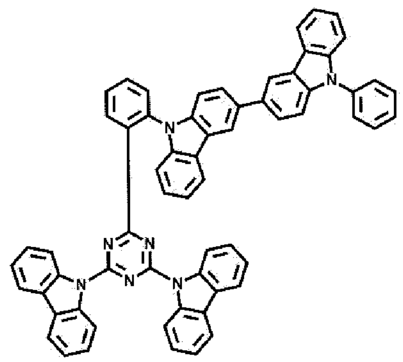

E45

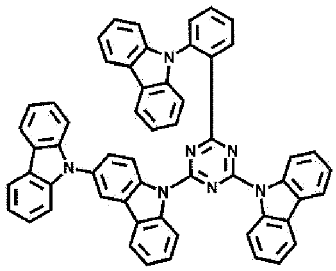

E46

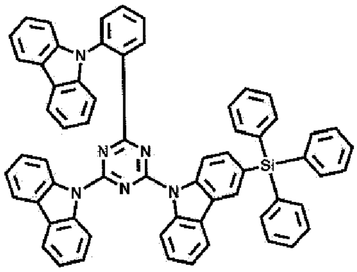

E47

In one or more embodiments, the host may consist of one type of compound. For example, the one type of compound may be optionally selected from the first material (e.g., a hole-transporting host) or the second material (e.g., an electron-transporting host).

In one or more embodiments, the host may include two or more types of compounds. For example, the host may

include: two or more types of different hole-transporting hosts; two or more types of different electron-transporting hosts; or a combination of one or more types of hole-transporting hosts and one or more types of electron-transporting hosts.

Emitter in emission layer

The emitter may emit a light.
In one or more embodiments, the emitter may include the at least one organometallic compound of Formula A or Formula 1.
In one or more embodiments, the emitter may be a fluorescent emitter and/or a delayed fluorescence emitter that emits fluorescence and/or delayed fluorescence, respectively. Accordingly, a decay time of the emitter ($T_{decay}$(E)) may be less than 100 microseconds (μs).
The $T_{decay}$(E) may be measured from a time-resolved photoluminescence (TRPL) spectrum at room temperature of a film having a thickness of 40 nm formed by vacuum-depositing the host and the emitter at a weight ratio of 90:10 included in the emission layer on a quartz substrate at a vacuum degree of $10^{-7}$ torr.
In one or more embodiments, the emitter may include a carbocyclic group having 4 or more rings, or a heterocyclic group having 4 or more rings.
In one or more embodiments, the emitter may be a metal-free organic compound.
In one or more embodiments, the emitter may be a compound represented by one of Formulae 51 to 54:

Formula 51

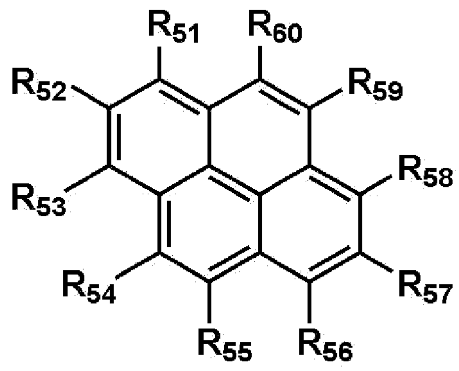

Formula 52

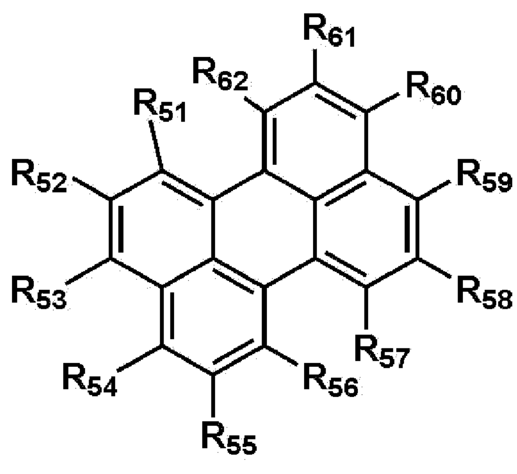

Formula 53

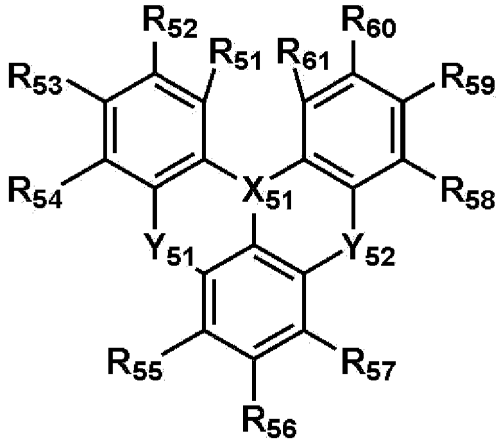

Formula 54

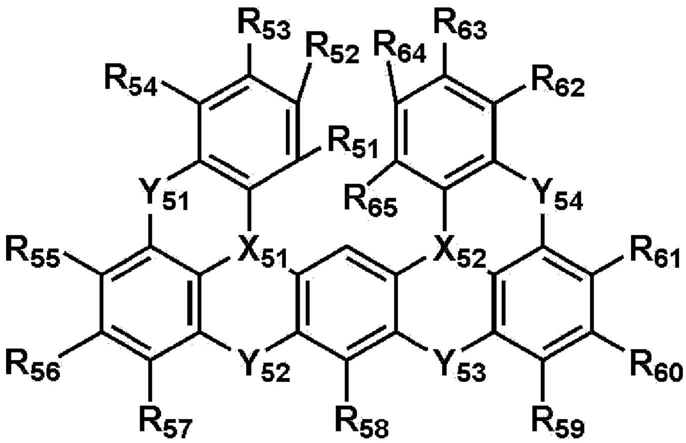

wherein, in Formulae 51 to 54,

$X_{51}$ and $X_{52}$ may each independently be N or B,
$Y_{51}$ may be a single bond, O, S, Se, $N(R_{501})$, $B(R_{501})$, $C(R_{501})(R_{502})$, or $Si(R_{501})(R_{502})$,
$Y_{52}$ may be a single bond, O, S, Se, $N(R_{503})$, $B(R_{503})$, $C(R_{503})(R_{504})$, or $Si(R_{503})(R_{504})$,
$Y_{53}$ may be a single bond, O, S, Se, $N(R_{505})$, $B(R_{505})$, $C(R_{606})(R_{606})$, or $Si(R_{505})(R_{506})$,
$Y_{54}$ may be a single bond, O, S, Se, $N(R_{507})$, $B(R_{507})$, $C(R_{507})(R_{508})$, or $Si(R_{507})(R_{508})$,
$R_{51}$ to $R_{65}$ and $R_{501}$ to $R_{508}$ may each independently be hydrogen, deuterium, -F, -Cl, -Br, -I, $-SF_5$, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$,
two or more of $R_{51}$ to $R_{66}$ and $R_{501}$ to $R_{508}$ may optionally be bonded together to form a $C_5$-$C_{30}$ carbocyclic group unsubstituted or substituted with at least one $R_5$ or a $C_1$-$C_{30}$ heterocyclic group unsubstituted or substituted with at

least one $R_5$,

at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may be:

deuterium, -F, -Cl, -Br, -I, -$SF_5$, -$CD_3$, -$CD_2H$, -$CDH_2$, -$CF_3$, -$CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, -Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, - $Si(Q_{11})(Q_{12})(Q_{13})$, -$Ge(Q_{11})(Q_{12})(Q_{13})$, -$N(Q_{14})(Q_{15})$, -$B(Q_{16})(Q_{17})$, -$P(Q_{18})(Q_{19})$, -$P(=O)(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, -$SF_5$, -$CD_3$, -$CD_2H$, - $CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -$Si(Q_{21})(Q_{22})(Q_{23})$, - $Ge(Q_{21})(Q_{22})(Q_{23})$, -$N(Q_{24})(Q_{25})$, -$B(Q_{26})(Q_{27})$, -$P(Q_{28})(Q_{29})$, -$P(=O)(Q_{28})(Q_{29})$, or a combination thereof; or

-$Si(Q_{31})(Q_{32})(Q_{33})$, -$Ge(Q_{31})(Q_{32})(Q_{33})$, -$N(Q_{34})(Q_{35})$, -$B(Q_{36})(Q_{37})$, - $P(Q_{38})(Q_{39})$, or -$P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ may each independently be hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

In one or more embodiments, $R_5$, $R_{51}$ to $R_{65}$ and $R_{501}$ to $R_{508}$ may each be the same as described herein in connection with $R_1$.

In one or more embodiments, the emitter may be a condensed polycyclic compound or a styryl compound.

In one or more embodiments, the emitter may include one of a naphthalene-containing core, a fluorene-containing core, a spiro-bifluorene-containing core, a benzofluorene-containing core, a dibenzofluorene-containing core, a phenanthrene-containing core, an anthracene-containing core, a fluoranthene-containing core, a triphenylene-containing core, a pyrene-containing core, a chrysene-containing core, a picene-containing core, a perylene-containing core, a pentacene-containing core, an indenoanthracene-containing core, a tetracene-containing core, a bisanthracene-containing core, or a core represented by one of Formulae 501-1 to 501-21:

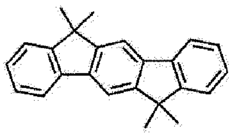

501-1

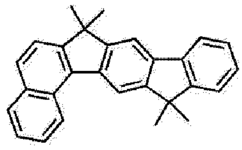

501-2

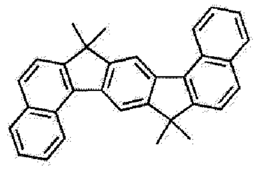

501-3

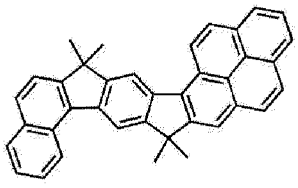

501-4

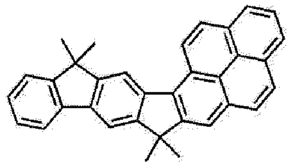

501-5

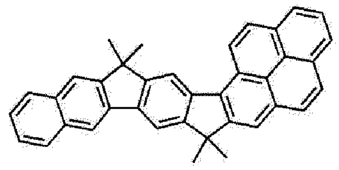

501-6

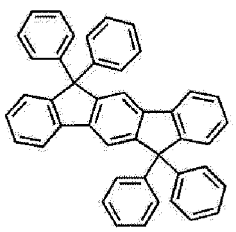

501-7

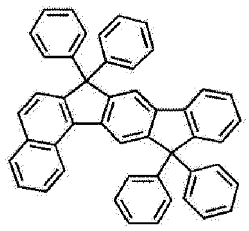

501-8

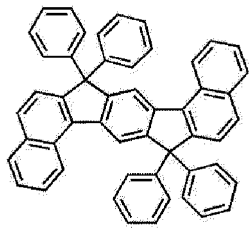

501-9

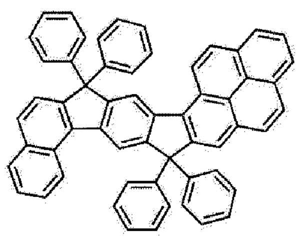

501-10

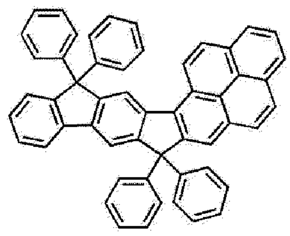

501-11

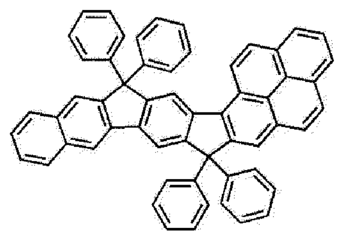

501-12

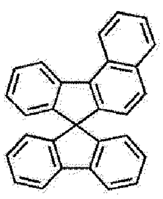

501-13

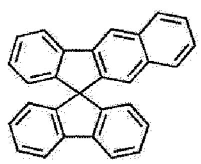

501-14

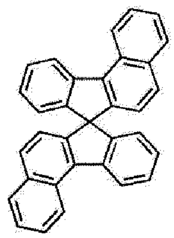

501-15

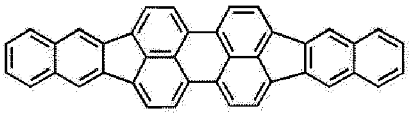

501-16

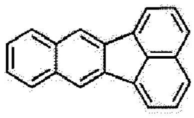

501-17

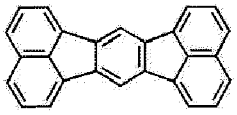

501-18

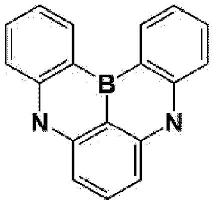

501-19

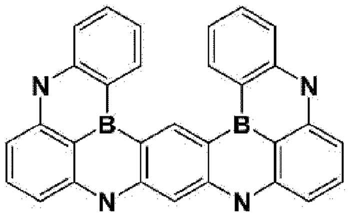

501-20

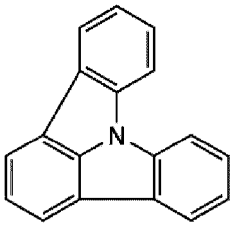

501-21

In one or more embodiments, the emitter may be represented by Formula 501:

Formula 501

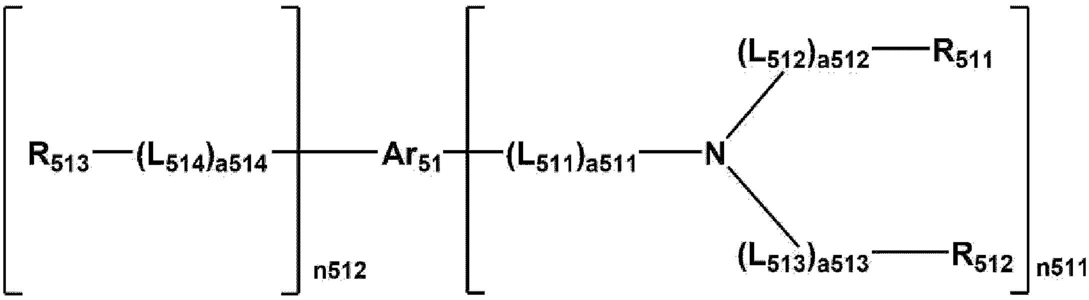

In Formula 501,

$Ar_{51}$ may be a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a picene group, a perylene group, a pentacene group, an indenoanthracene group, a tetracene group, a bisanthracene group, or a group represented by one of Formulae 501-1 to 501-21, each unsubstituted or substituted with deuterium, -F, -Cl, -Br, -I, $-SF_5$, a hydroxyl group, a cyano group, a nitro group, an amidino group, a hydrazine group, a hydrazone group, a sulfonic acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{511})(Q_{512})(Q_{513})$, $-Ge(Q_{511})(Q_{512})(Q_{513})$, $-B(Q_{511})(Q_{512})$, $-N(Q_{511})(Q_{512})$, $-P(Q_{511})(Q_{512})$, $-C(=O)(Q_{511})$, $-S(=O)(Q_{511})$, $-S(=O)_2(Q_{511})$, $-P(=O)(O_{511})(O_{512})$, $-P(=S)(Q_{511})(Q_{512})$, or a combination thereof:

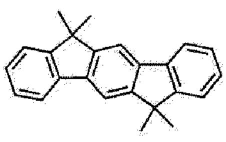

501-1

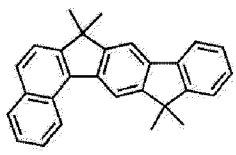

501-2

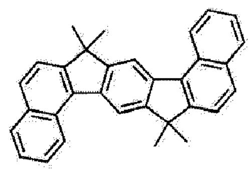

501-3

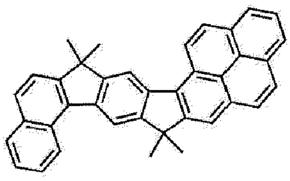
501-4

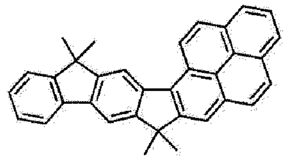
501-5

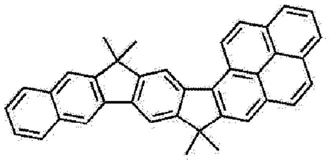
501-6

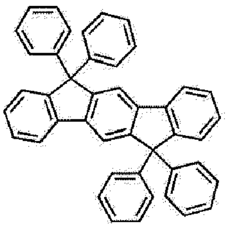
501-7

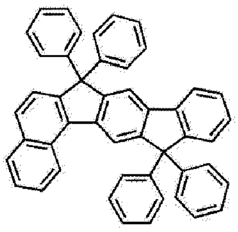
501-8

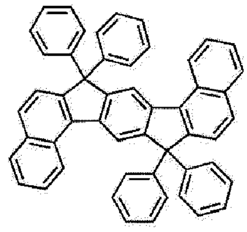
501-9

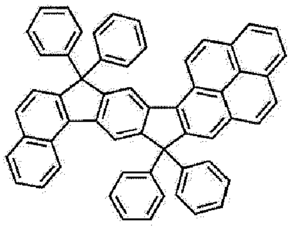
501-10

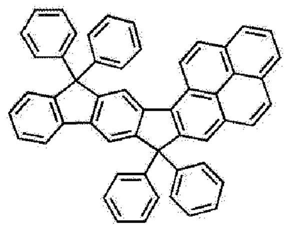
501-11

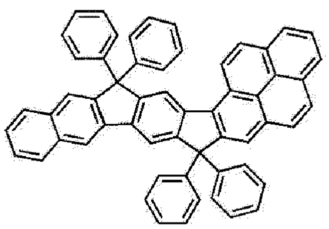
501-12

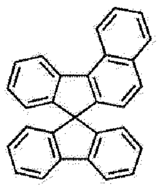
501-13

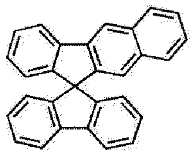
501-14

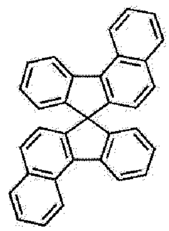
501-15

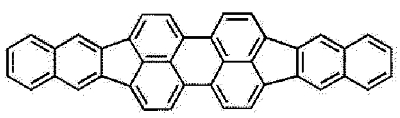
501-16

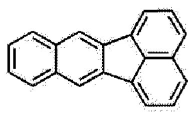
501-17

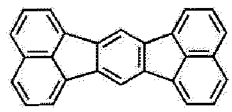
501-18

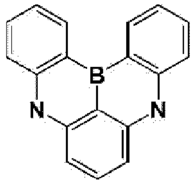
501-19

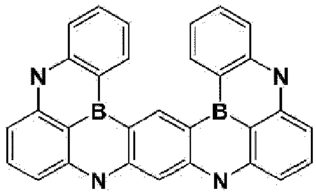
501-20

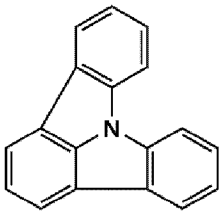
501-21

.

$L_{511}$ to $L_{514}$ may each independently be a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene

group, a substituted or unsubstituted $C_1$-$C_{60}$ heteroarylene group, a substituted or unsubstituted divalent non-aromatic condensed polycyclic group, or a substituted or unsubstituted divalent non-aromatic condensed heteropolycyclic group,

a511 to a514 may each independently be 0, 1, 2, or 3,

$R_{511}$ to $R_{513}$ may each independently be a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group,

wherein $Q_{511}$ to $Q_{513}$ may each independently be hydrogen, deuterium, -F, -Cl, -Br, -I, -$SF_5$, a hydroxyl group, a cyano group, a nitro group, an amino group, an amidino group, a hydrazine group, a hydrazone group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group, and

n511 and n512 may each independently be 0, 1, 2, 3, 4, 5, or 6.

In some embodiments, in Formula 501, a sum of n511 and n512 may be 1 or greater, but embodiments are not limited thereto.

In some embodiments, in Formula 501, $R_{511}$ and $R_{512}$ may each independently be:

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group.

In one or more embodiments, the emitter may be one of Compounds D1 to D30, or a compound of Group FD1, but embodiments are not limited thereto:

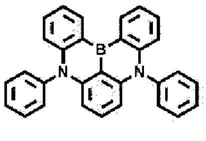

D1

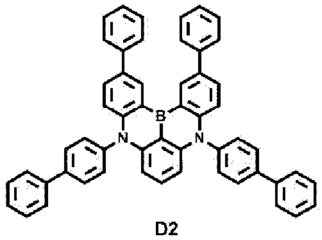

D2

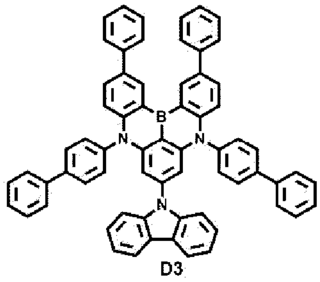

D3

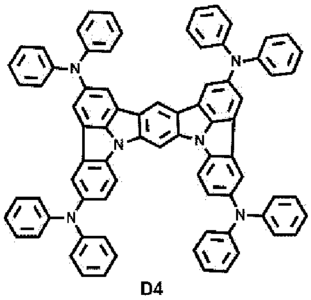

D4

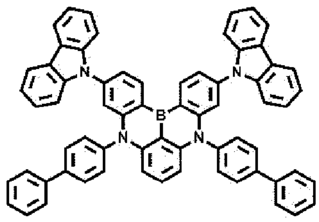

D5

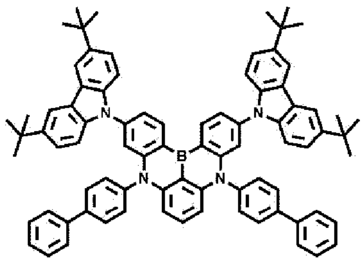

D6

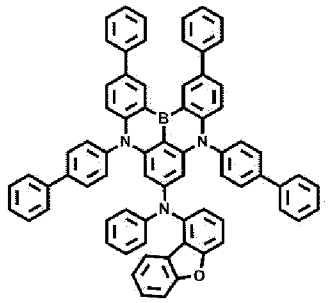

D7

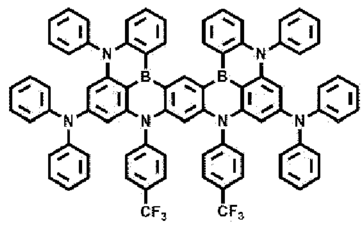

D8

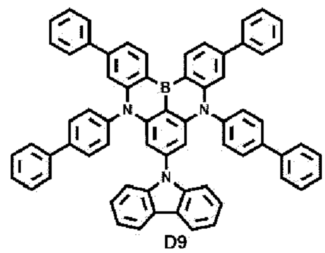

D9

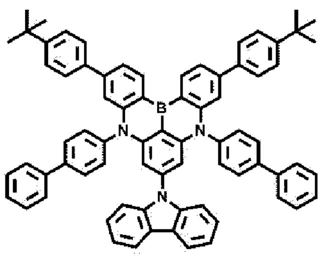

D10

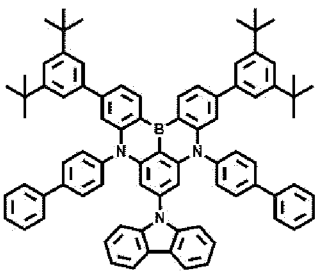

D11

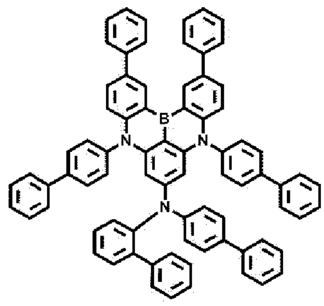

D12

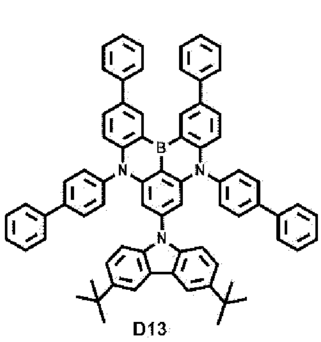

D13

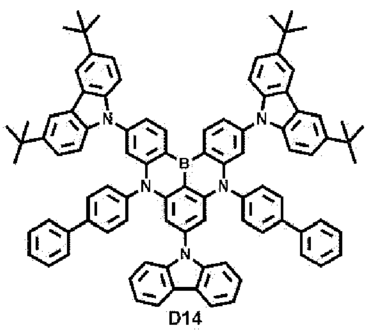

D14

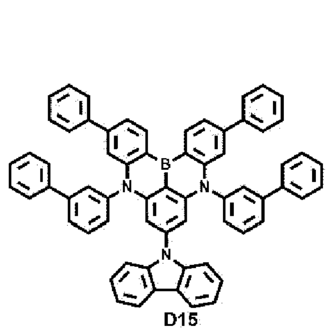

D15

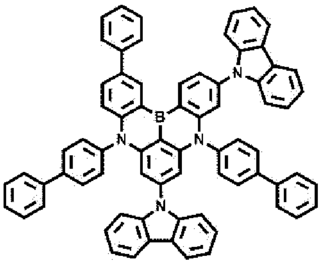

D16

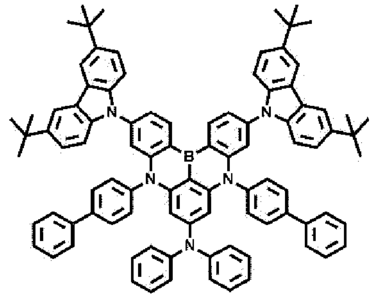

D17

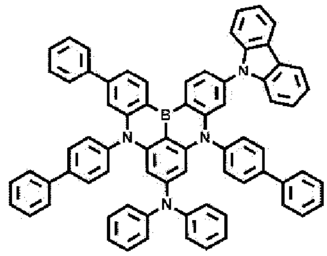

D18

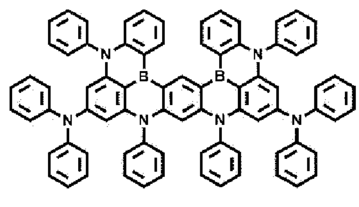

D19

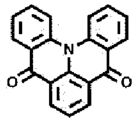

D20

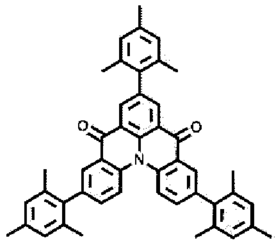

D21

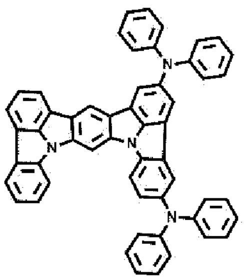

D22

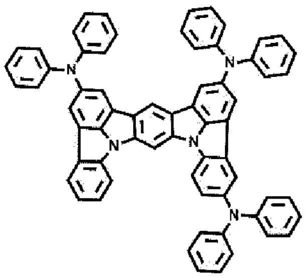

D23

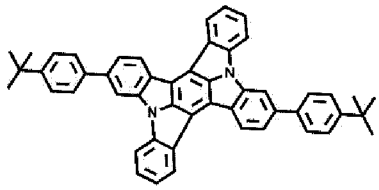

D24

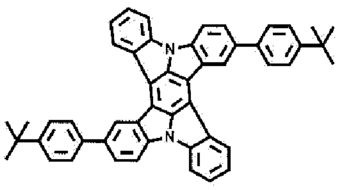

D25

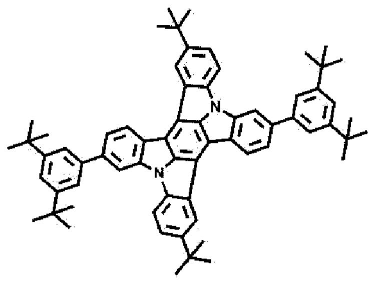

D26

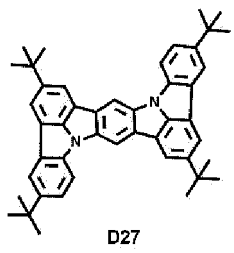

D27

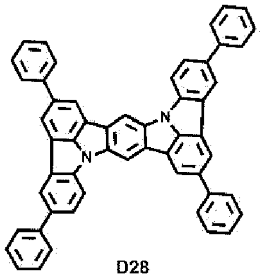

D28

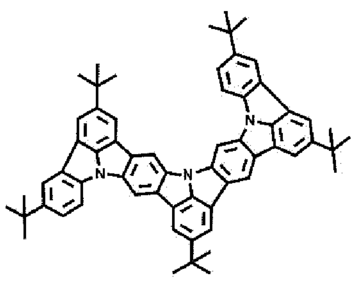

D29

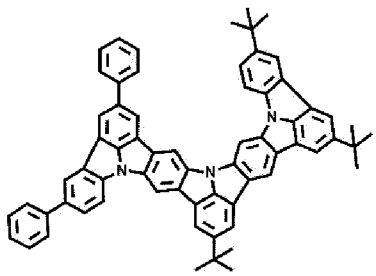

D30

Group FD1

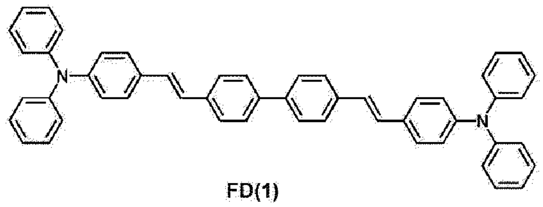

FD(1)

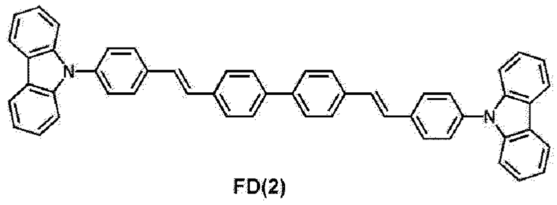

FD(2)

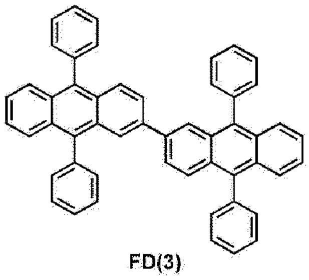

FD(3)

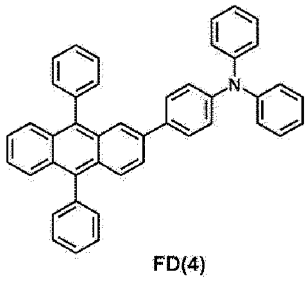

FD(4)

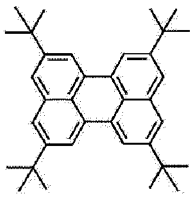

FD(5)

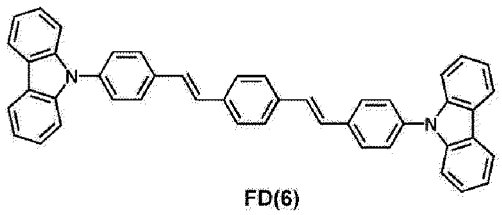

FD(6)

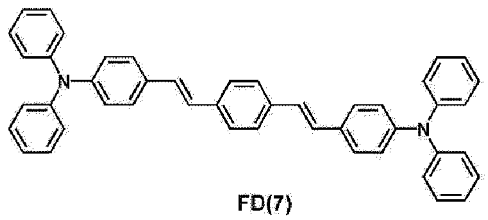

FD(7)

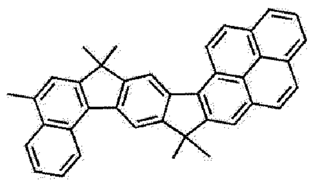

FD(8)

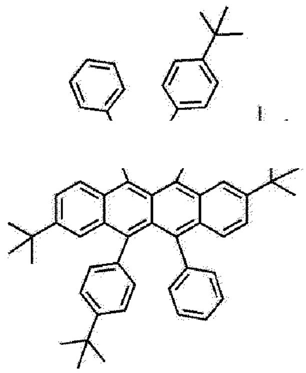

FD(9)

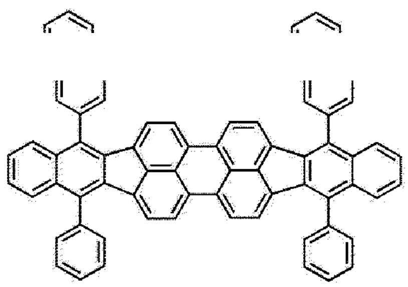

FD(10)

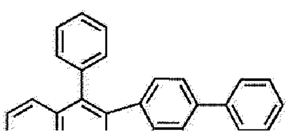

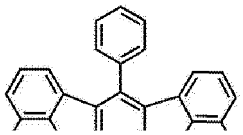

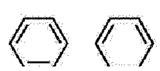

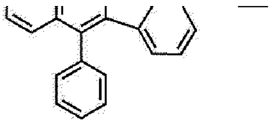

FD(11)

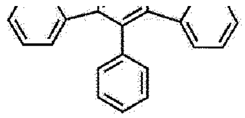

FD(12)

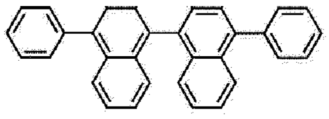

FD(13)

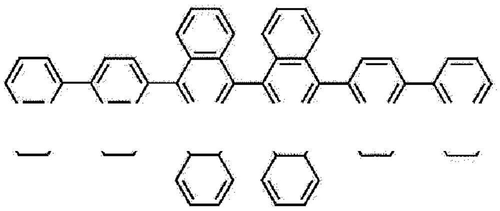

FD(14)

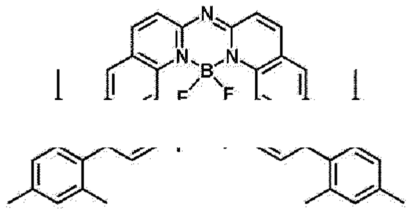

FD(15)

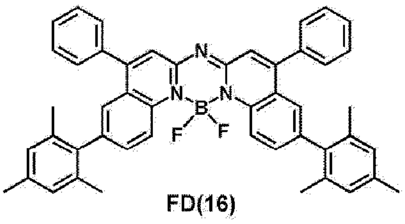

FD(16)

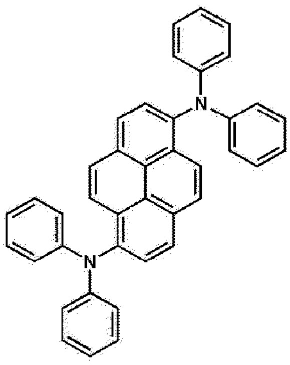

FD1

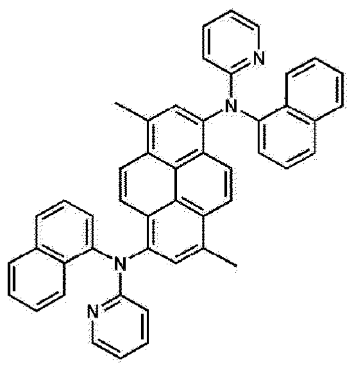

FD2

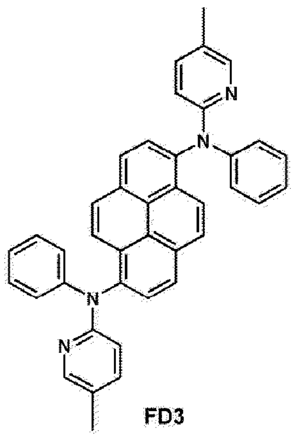

FD3

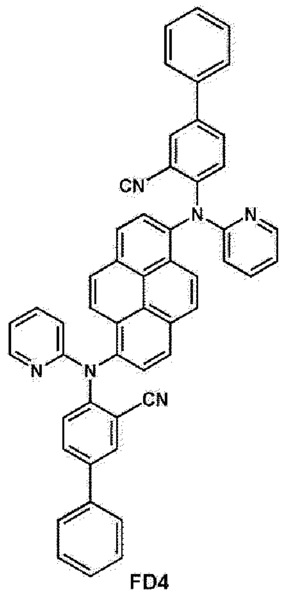

FD4

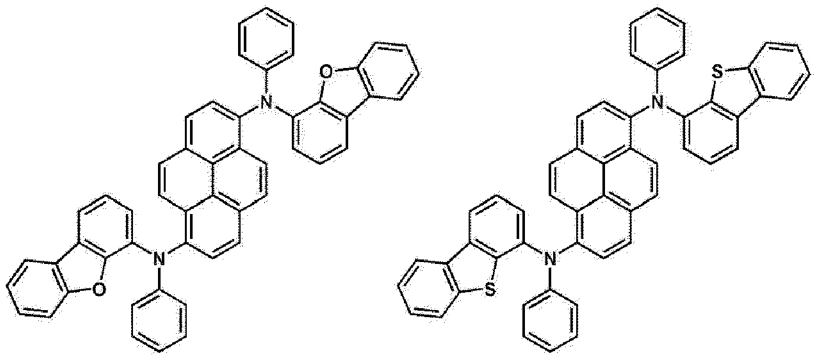

FD5

FD6

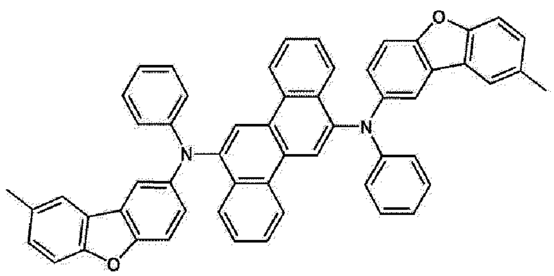

FD7

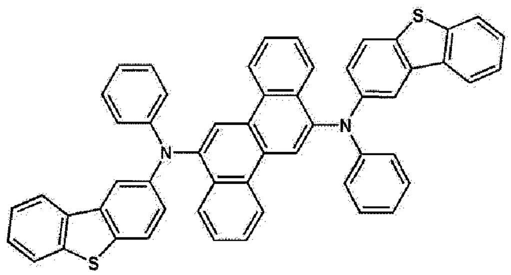

FD8

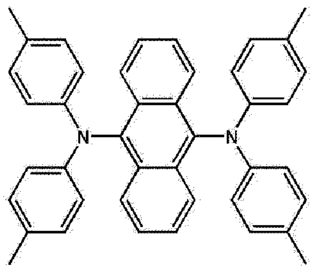

FD9

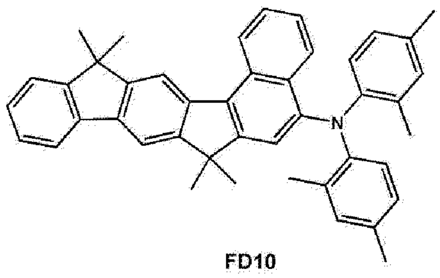

FD10

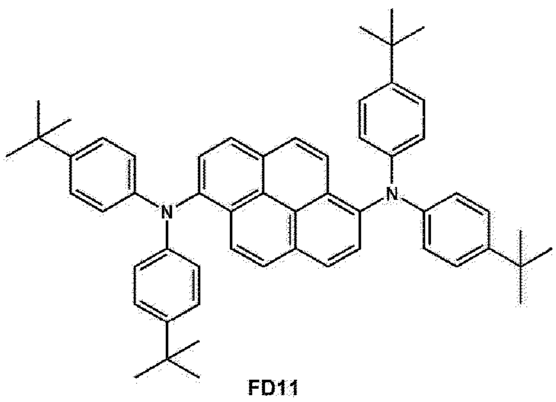

FD11

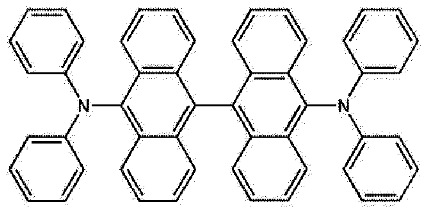

FD12

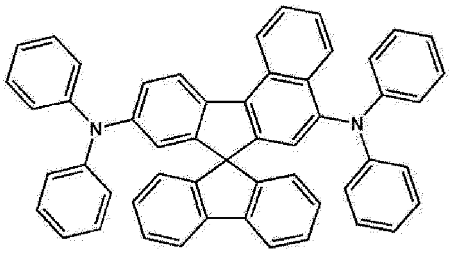

FD13

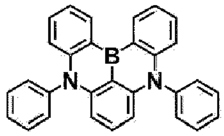

BD1-1

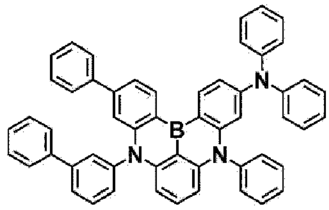

BD1-2

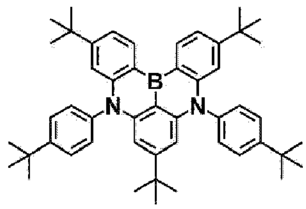

BD1-3

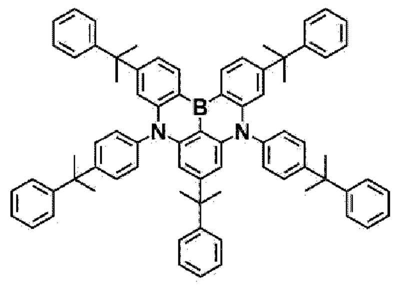

BD1-4

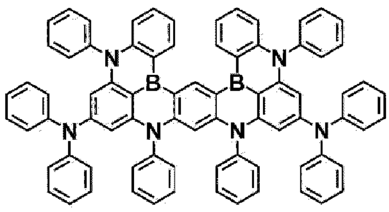

BD1-5

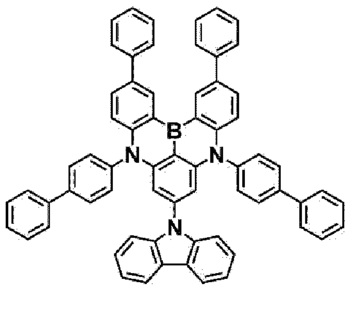

BD1-6

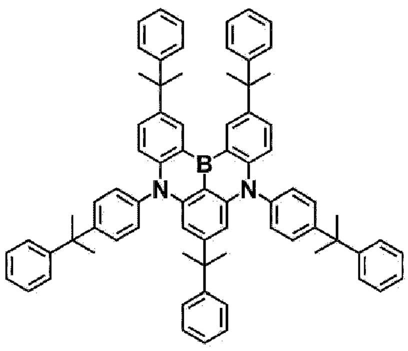

BD1-7

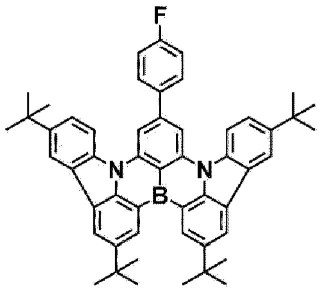

BD1-8

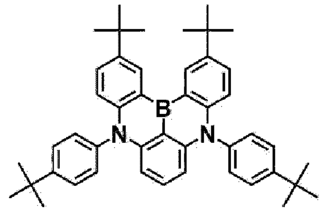

BD1-9

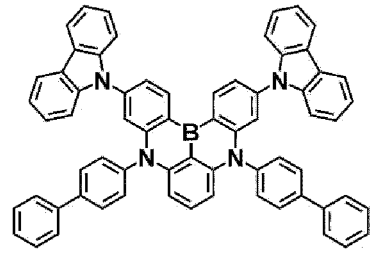

BD1-10

The maximum emission wavelength of an emission spectrum of the emitter may be about 400 nm or greater and about 650 nm or lower. In some embodiments, the maximum emission wavelength of an emission spectrum of the fluorescence emitter may be about 400 nm or greater and about 550 nm or lower, about 400 nm or greater and about 495 nm or lower, or about 450 nm or greater and about 495 nm or lower, but embodiments are not limited thereto. The emitter may emit a blue light to a green light, for example, a blue light, but embodiments are not limited thereto. The "maximum emission wavelength" as used herein refers to a wavelength of which the emission intensity is greatest. In other words, the "maximum emission wavelength" may be referred to as "peak emission wavelength".

The emission layer may have an emitter content in a range of about 0.01 wt% to about 15 wt%, based on total weight of the emission layer, but embodiments are not limited thereto.

In the emission layer, regarding a content of the host, a content of the sensitizer, and a content of the emitter, the content of the host may be greatest, and the content of the emitter may be smallest, but embodiments are not limited thereto.

The organic light-emitting device may satisfy Condition 1:

Condition 1

$$S_1(H) > S_1(S) \geq S_1(E)$$

In Condition 1,

$S_1(H)$ indicates a lowest excited singlet energy level of the host,
$S_1(S)$ indicates a lowest excited singlet energy level of the sensitizer, and
$S_1(E)$ indicates a lowest excited singlet energy level of the emitter.

$S_1(H)$, $S_1(S)$, and $S_1(E)$ may respectively be obtained by calculation from PL spectrum obtained from a film having a thickness of 40 nm formed by vacuum-depositing the host, sensitizer, or emitter each on a quartz substrate at a vacuum degree of $10^{-7}$ torr.

When Condition 1 is satisfied, the emitter may emit a light, and the organic light-emitting device may have improved efficiency.

For example, when Condition 1 is satisfied, the ratio of the luminescent component from the emitter in the organic light-emitting device to the total luminescent components of the emission layer may be 85 % or greater. That is, when the aforementioned range is satisfied, only the emitter may substantially emit a light, whereas the host and the sensitizer may not substantially emit a light in the organic light-emitting device.

When the singlet and/or triplet excitons formed in the host are transferred to the sensitizer and the triplet excitons are converted into singlet excitons in the sensitizer through RISC, the singlet excitons are transferred to the emitter through FRET. As singlet excitons and triplet excitons of the host may all be transferred to the emitter, the organic light-emitting device may have significantly improved lifespan and efficiency.

The host and the sensitizer may satisfy Condition 2:

Condition 2

$$T_1(H) \geq T_1(S)$$

In Condition 2,

$T_1(H)$ indicates a lowest excited triplet energy level of the host, and
$T_1(S)$ is the lowest excitation triplet energy level of the sensitizer.

Sensitizer in emission layer

The sensitizer may include at least one of the organometallic compounds of Formula A or Formula 1.

In one or more embodiments, the sensitizer may further include a phosphorescent compound.

In one or more embodiments, the phosphorescent compound may include one type of metal.

In one or more embodiments, the phosphorescent compound may include at least one type of metal ($M_{11}$) selected from transition metals and an organic ligand ($L_{11}$), wherein $L_{11}$ and $M_{11}$ may form 1, 2, 3, or 4 cyclometallated rings.

In one or more embodiments, the phosphorescent compound may be represented by Formula 101:

Formula 101 $M_{11}(L_{11})_{n11}(L_{12})_{n12}$

wherein, in Formula 101,

$M_{11}$ may be a transition metal,
$L_{11}$ may be a ligand represented by one of Formulae 1-1 to 1-4,
$L_{12}$ may be a monodentate ligand or a bidentate ligand,
n11 may be 1,
n12 may be 0, 1, or 2,

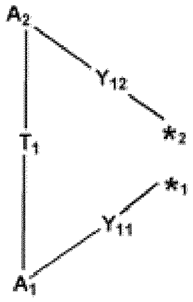

Formula 1-1

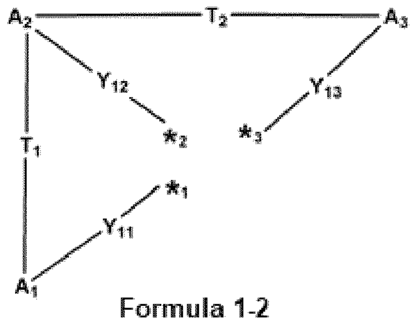

Formula 1-2

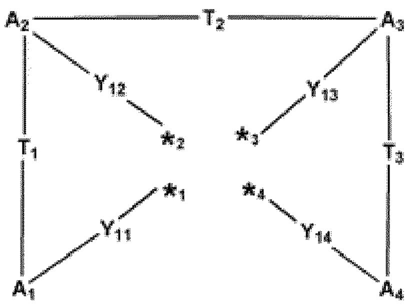

Formula 1-3

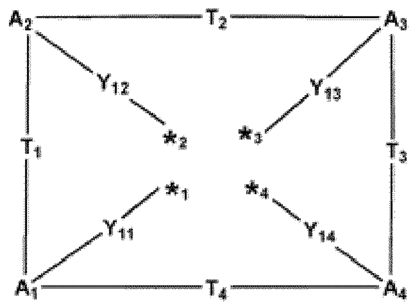

Formula 1-4

wherein, in Formulae 1-1 to 1-4,

$A_1$ to $A_4$ may each independently be a substituted or unsubstituted $C_5$-$C_{30}$ carbocyclic group, a substituted or unsubstituted $C_1$-$C_{30}$ heterocyclic group, or a non-cyclic group,
$Y_{11}$ to $Y_{14}$ may each independently be a chemical bond, O, S, $N(R_{91})$, $B(R_{91})$, $P(R_{91})$, or $C(R_{91})(R_{92})$,
$T_1$ to $T_4$ may each independently be a single bond, a double bond, *-N($R_{93}$)-*', *-B($R_{93}$)-*', *-P($R_{93}$)-*', *-C($R_{93}$)($R_{94}$)-*', *-Si($R_{93}$)($R_{94}$)-*', *-Ge($R_{93}$)($R_{94}$)-*', *-S-*', *-Se-*', *-O-*', *-C(=O)-*', *-S(=O)-*', *-S(=O)$_2$-*', *-C($R_{93}$)=*', *=C($R_{93}$)-*', *-C($R_{93}$)=C($R_{94}$)-*', *-C(=S)-*', or *-C≡C-*',
a substituent of the substituted $C_5$-$C_{30}$ carbocyclic group, a substituent of the substituted $C_1$-$C_{30}$ heterocyclic group, and $R_{91}$ to $R_{94}$ may each independently be hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent aromatic condensed polycyclic group, a substituted or unsubstituted

monovalent aromatic condensed heteropolycyclic group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$, wherein the substituent of the substituted $C_5$-$C_{30}$ carbocyclic group and the substituent of the substituted $C_1$-$C_{30}$ heterocyclic group are not hydrogen,

*1, *2, *3, and *4 each indicate a binding site to M11, and

$Q_1$ to $Q_3$ may each independently be hydrogen, deuterium, -F, -Cl, -Br, -I, $-SF_5$, a hydroxyl group, a cyano group, a nitro group, an amino group, an amidino group, a hydrazine group, a hydrazone group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent aromatic condensed polycyclic group, a substituted or unsubstituted monovalent aromatic condensed heteropolycyclic group, a substituted or unsubstituted monovalent non-aromatic condensed polycyclic group, or a substituted or unsubstituted monovalent non-aromatic condensed heteropolycyclic group;

a $C_1$-$C_{60}$ alkyl group that is substituted with at least one of deuterium, - F, a cyano group, a $C_1$-$C_{60}$ alkyl group, or a $C_6$-$C_{60}$ aryl group, or

a $C_6$-$C_{60}$ aryl group that is substituted with at least one of deuterium, -F, a cyano group, a $C_1$-$C_{60}$ alkyl group, or a $C_6$-$C_{60}$ aryl group.

In one or more embodiments, the transition metal may include platinum (Pt), palladium (Pd), gold (Au), iridium (Ir), osmium (Os), titanium (Ti), zirconium (Zr), hafnium (Hf), europium (Eu), terbium (Tb), thulium (Tm), or rhodium (Rh).

In one or more embodiments, the sensitizer may further include a delayed fluorescence compound.

In one or more embodiments, the delayed fluorescence compound may be represented by Formula 101 or 102:

Formula 101

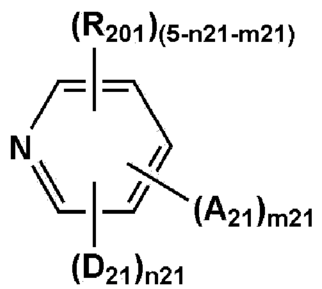

Formula 102

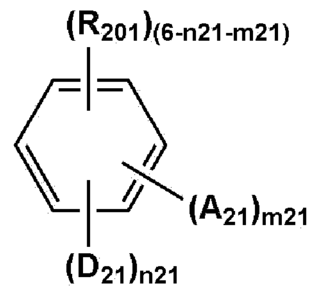

In Formulae 101 and 102,

$A_{21}$ may be an acceptor group,

$D_{21}$ may be a donor group,

m21 may be 1, 2, or 3, and n21 may be 1, 2, or 3,

a sum of n21 and m21 in Formula 101 may be 5 or less, and a sum of n21 and m21 in Formula 102 may be 6 or less,

$R_{201}$ may be hydrogen, deuterium, -F, -Cl, -Br, -I, $-SF_5$, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl

heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -Ge($Q_1$)($Q_2$)($Q_3$), - B($Q_1$)($Q_2$), -N($Q_1$)($Q_2$), -P($Q_1$)($Q_2$), -C(=O)($Q_1$), -S(=O)($Q_1$), -S(=O)$_2$($Q_1$), - P(=O)($Q_1$)($Q_2$), or -P(=S)($Q_1$)($Q_2$), wherein a plurality of $R_{201}$ may optionally be bonded together to form a substituted or unsubstituted $C_5$-$C_{30}$ carbocyclic group or a substituted or unsubstituted $C_1$-$C_{30}$ heterocyclic group, and

$Q_1$ to $Q_3$ may each independently be hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

In one or more embodiments, in Formulae 101 and 102, $A_{21}$ may be a substituted or unsubstituted $\pi$ electron-deficient nitrogen-free ring group.

In one or more embodiments, the $\pi$ electron-deficient nitrogen-free ring group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group; or a condensed ring group of two or more $\pi$ electron-deficient nitrogen-free ring groups, but embodiments of the disclosure are not limited thereto.

In one or more embodiments, in Formulae 101 and 102, $D_{21}$ may be:

-F, a cyano group, or $\pi$ electron-deficient nitrogen-containing ring group;

a $C_1$-$C_{60}$ alkyl group, an $\pi$-electron deficient nitrogen-containing ring group, or an $\pi$ electron-deficient nitrogen-free ring group, each substituted with at least one of -F or a cyano group; or

an $\pi$-electron deficient nitrogen-containing ring group, each substituted with at least one of deuterium, a $C_1$-$C_{60}$ alkyl group, an $\pi$ -electron deficient nitrogen-containing ring group, or an $\pi$ electron-deficient nitrogen-free ring group.

In one or more embodiments, the $\pi$ electron-deficient nitrogen-free ring group is the same as described herein.

The term "$\pi$ electron-deficient nitrogen-containing ring group" used herein refers to a ring group having at least one *-N=*' moiety, and, for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, a benzimidazole group; or a condensed ring group in which two or more $\pi$ electron-deficient nitrogen-containing ring groups are condensed with each other.

In one or more embodiments, an amount of the sensitizer in the organic layer (e.g. the emission layer) may be greater than an amount of the emitter in the organic layer (e.g. the emission layer), based on weight or volume. For example, a volume ratio of the sensitizer and the emitter may be in a range of about 30:0.1 to about 10:3 or about 10:0.1 to about 20:5. In one or more embodiments, a weight ratio of the sensitizer and the emitter may be in a range of about 10:0.1 to

about 20:5. In one or more embodiments, a weight ratio of the host and the sensitizer in the organic layer (e.g. the emission layer) may be in a range of about 60:40 to about 95:5 or about 70:30 to about 90:10. In one or more embodiments, the weight ratio of the host and the sensitizer in the organic layer (e.g. the emission layer) may be in a range of about 60:40 to about 95:5. When the amount is satisfied within the ranges above, the organic light-emitting device may have improved luminescence efficiency and/or long lifespan characteristics.

FIG. 1 is a schematic cross-sectional view of an organic light-emitting device 10 according to one or more embodiments. Hereinafter, the structure and manufacturing method of the organic light-emitting device 10 according to one or more embodiments will be described with reference to FIG. 1. The organic light-emitting device 10 may have a structure in which a first electrode 11, an organic layer 15, and a second electrode 19 are sequentially stacked.

A substrate may be further disposed under the first electrode 11 or on the second electrode 19. The substrate may be a substrate commonly used in organic light-emitting devices, e.g., a glass substrate or a transparent plastic substrate, which have excellent mechanical strength, thermal stability, transparency, surface smoothness, ease of handling, and/or water repellency.

The first electrode 11 may be formed by, for example, depositing or sputtering, onto the substrate, a material for forming the first electrode 11. The first electrode 11 may be an anode. The material for forming the first electrode 11 may be selected from materials with a high work function for easy hole injection. The first electrode 11 may be a reflective electrode, a transflective electrode, or a transmissive electrode. The material for forming the first electrode 11 may be indium tin oxide (ITO), indium zinc oxide (IZO), tin oxide ($SnO_2$), or zinc oxide (ZnO). In one or more embodiments, the material for forming the first electrode 11 may be a metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The organic layer 15 may be disposed on the first electrode 11.

The organic layer 15 may include an emission layer, and may further include a hole transport region, an emission layer, and an electron transport region.

The hole transport region may be disposed between the first electrode 11 and the emission layer.

The hole transport region may include a hole injection layer (HIL), a hole transport layer, an electron blocking layer, a buffer layer, or a combination thereof.

The hole transport region may include only either an HIL or a hole transport layer. In one or more embodiments, the hole transport region may have a HIL/hole transport layer structure or a HIL/hole transport layer/electron blocking layer structure, in which respective layers of each structure are sequentially stacked in the stated order from the first electrode 11.

When the hole transport region includes an HIL, the HIL may be formed on the first electrode 11 by using various methods, for example, vacuum deposition, spin coating, casting, and/or Langmuir-Blodgett (LB) deposition, but embodiments are not limited thereto.

When the hole injection layer is formed by a vacuum deposition method, deposition conditions may vary depending on a compound used as a material for forming the hole injection layer, a structure and thermal characteristics of the desired hole injection layer, and the like. For example, a deposition temperature may be about 100 °C to about 500 °C, a vacuum degree may be about $10^{-8}$ torr to about $10^{-3}$ torr, and a deposition rate may be about 0.01 angstroms per second Å/sec to about 100 Å/sec, but embodiments are not limited thereto.

When the hole injection layer is formed by a spin coating method, coating conditions may vary depending on a compound used as a material for forming the hole injection layer, a structure and thermal characteristics of the desired hole injection layer, and the like. For example, a coating rate may be about 2,000 revolutions per minute (rpm) to about 5,000 rpm, and a temperature at which heat treatment is performed to remove a solvent after coating may be about 80 °C to about 200 °C, but embodiments are not limited thereto.

The conditions for forming the hole transport layer and the electron blocking layer may be referred to the description provided for the conditions for forming the HIL.

The hole transport region may include at least one of 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), Spiro-TPD, Spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, or a compound represented by Formula 202, but embodiments are not limited thereto:

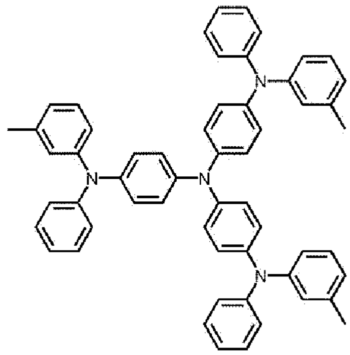

m-MTDATA

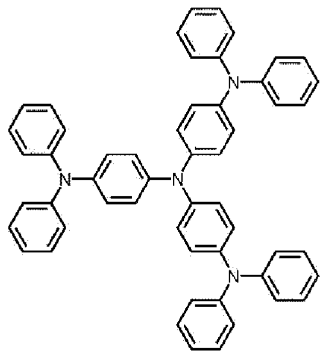

TDATA

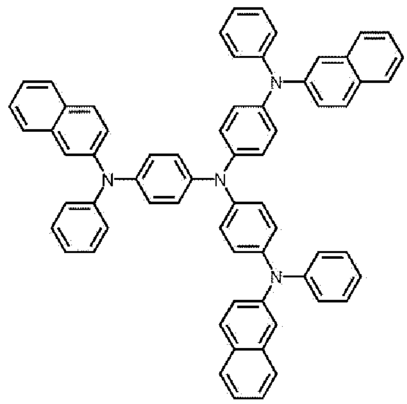

2-TNATA

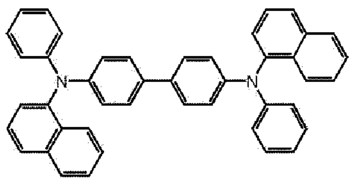

NPB

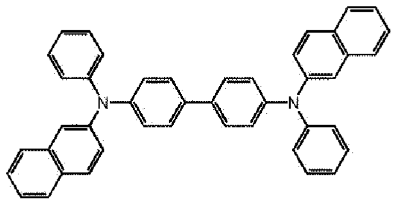

β-NPB

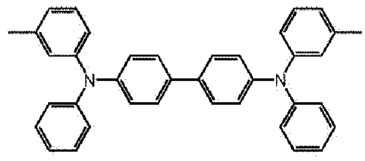

TPD

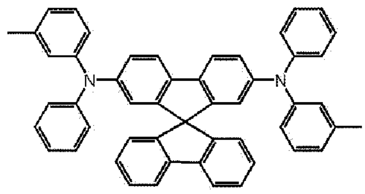

Spiro-TPD

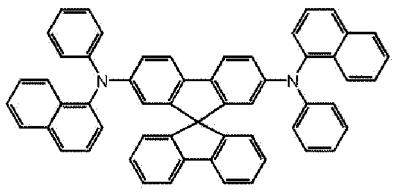

Spiro-NPB

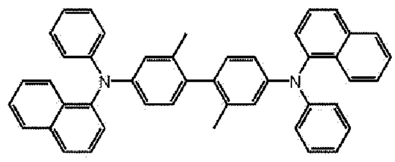

methylated NPB

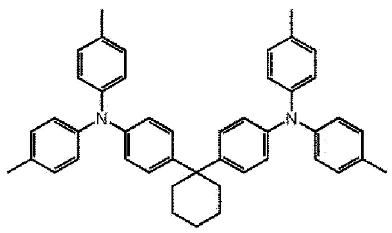

TAPC

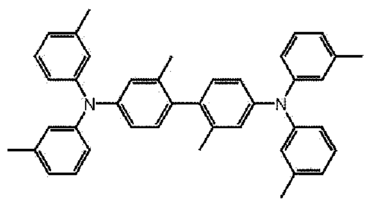

HMTPD

Formula 201

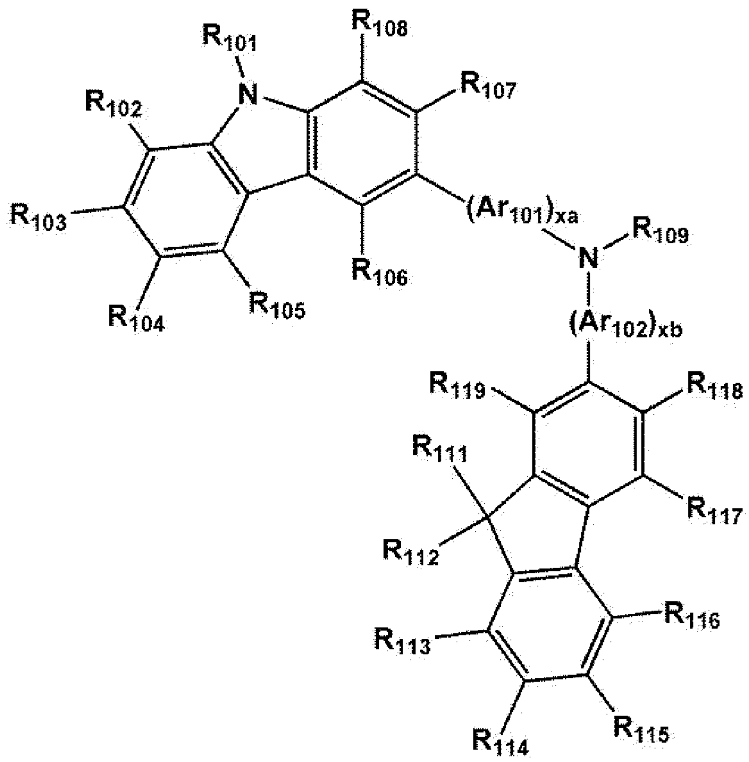

Formula 202

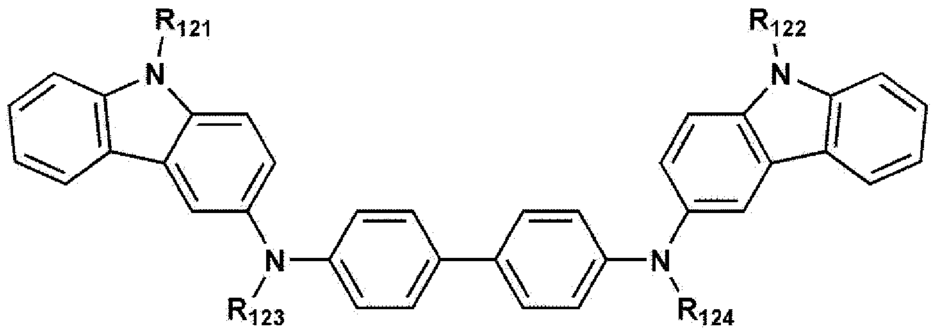

.

$Ar_{101}$ and $Ar_{102}$ in Formula 201 may each independently be:

a phenylene group, a pentalenylene group, an indenylene group, a naphthylene group, an azulenylene group, a heptalenylene group, an acenaphthenylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group; or

a phenylene group, a pentalenylene group, an indenylene group, a naphthylene group, an azulenylene group, a heptalenylene group, an acenaphthenylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each substituted with at least one of deuterium, -F, -Cl, - Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$

heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. For example, xa may be 1, and xb may be 0, but xa and xb are not limited thereto.

$R_{101}$ to $R_{108}$, $R_{111}$ to $R_{119}$, and $R_{121}$ to $R_{124}$ in Formulae 201 and 202 may each independently be:

hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (e.g., a methyl group, an ethyl group, a propyl group, a butyl group, pentyl group, a hexyl group, or the like), a $C_1$-$C_{10}$ alkoxy group (e.g., a methoxy group, an ethoxy group, a propoxy group, a butoxy group, a pentoxy group, or the like), or a $C_1$-$C_{10}$ alkylthio group;

a $C_1$-$C_{10}$ alkyl group, a $C_1$-$C_{10}$ alkoxy group, or a $C_1$-$C_{10}$ alkylthio group, each substituted with deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof;

a phenyl group, a naphthyl group, an anthracenyl group, a fluorenyl group, or a pyrenyl group; or

a phenyl group, a naphthyl group, an anthracenyl group, a fluorenyl group, or a pyrenyl group, each substituted with deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, a $C_1$-$C_{10}$ alkylthio group, or a combination thereof, but embodiments are not limited thereto. $R_{109}$ in Formula 201 may be:

a phenyl group, a naphthyl group, an anthracenyl group, or a pyridinyl group; or

a phenyl group, a naphthyl group, an anthracenyl group, or a pyridinyl group, each substituted with deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a naphthyl group, an anthracenyl group, a pyridinyl group, or a combination thereof.

In one or more embodiments, the compound represented by Formula 201 may be represented by Formula 201A, but embodiments are not limited thereto:

Formula 201A

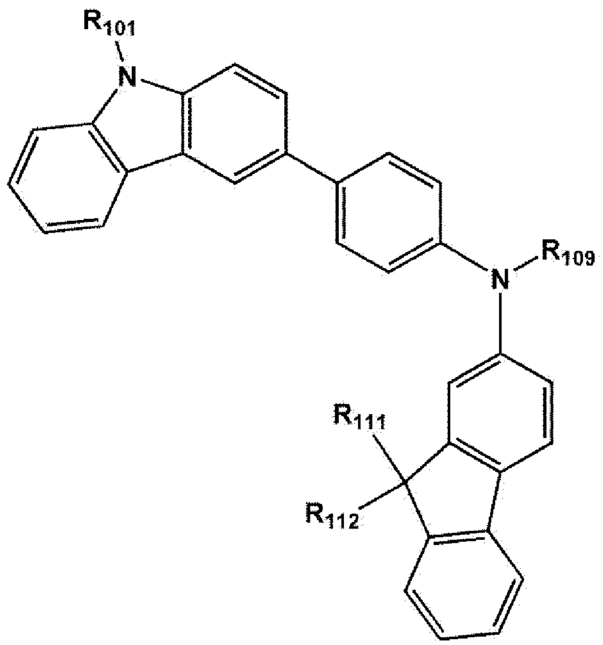

.

$R_{101}$, $R_{111}$, $R_{112}$, and $R_{109}$ in Formula 201A may each be as described herein.

For example, the compound represented by Formula 201 and the compound represented by Formula 202 may include, but are not limited to, compounds HT1 to HT20:

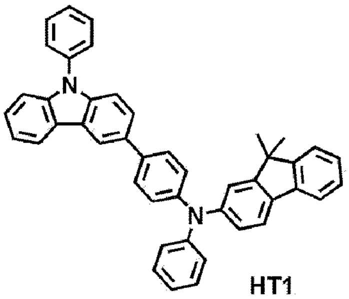

HT1

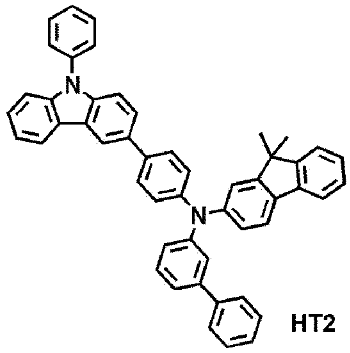

HT2

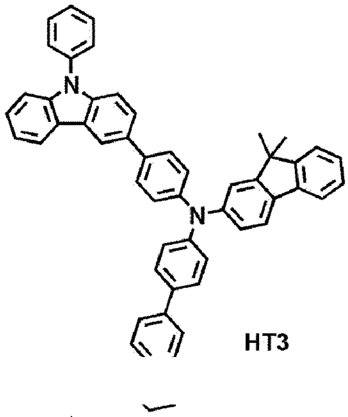

HT3

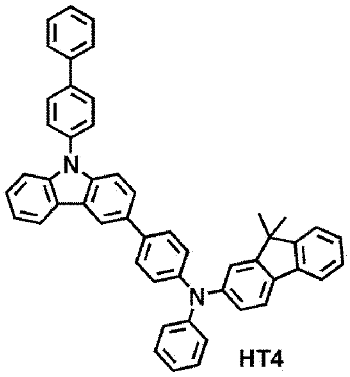

HT4

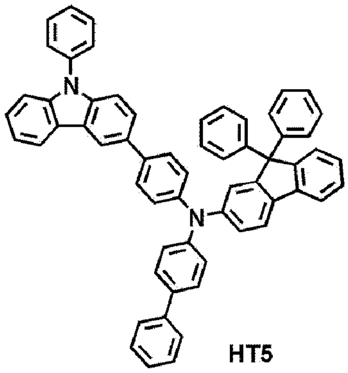

HT5

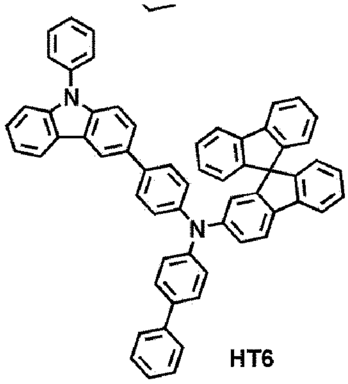

HT6

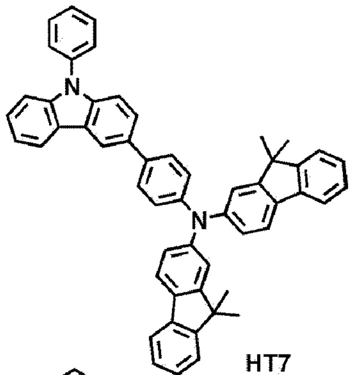

HT7

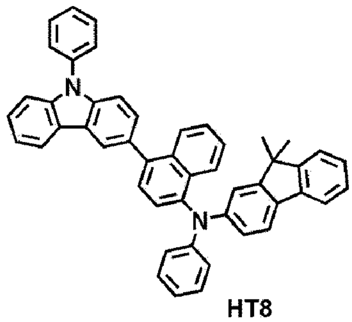

HT8

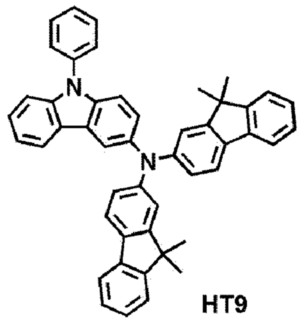

HT9

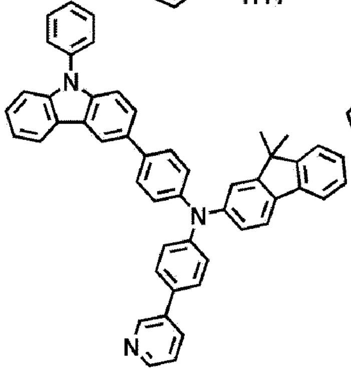

HT10

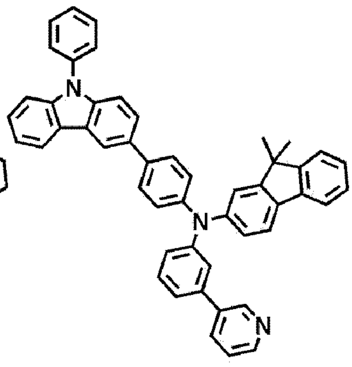

HT11

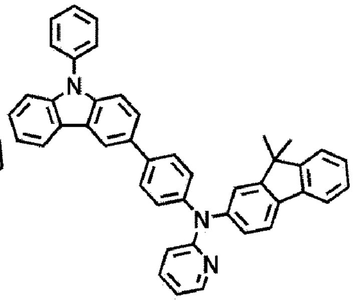

HT12

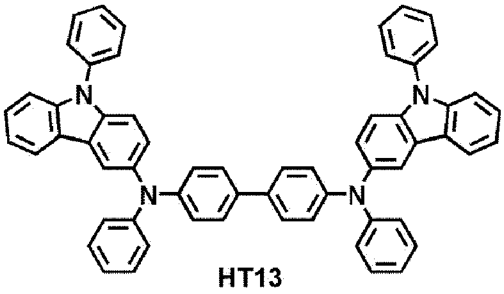
HT13

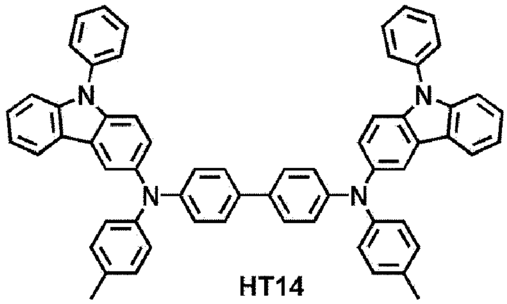
HT14

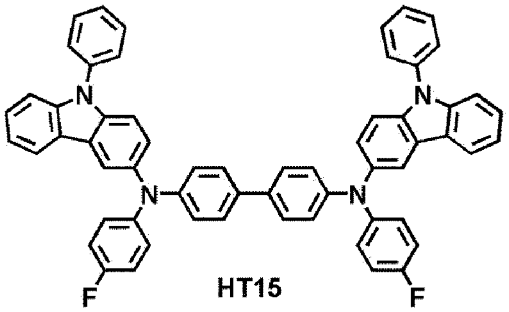
HT15

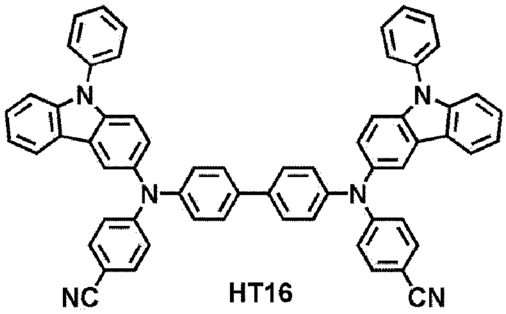
HT16

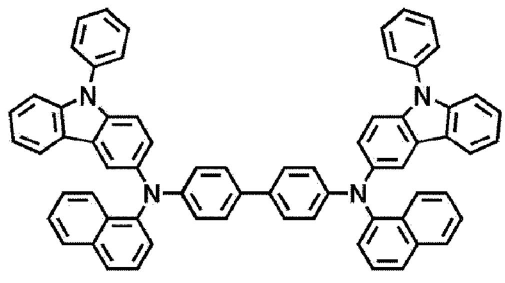
HT17

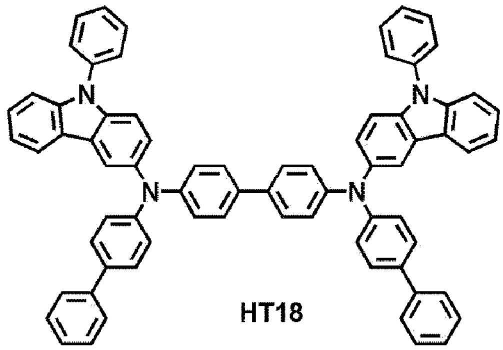
HT18

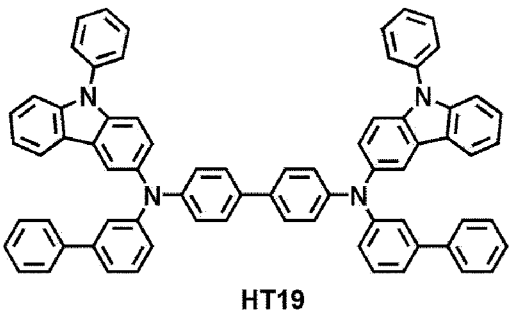
HT19

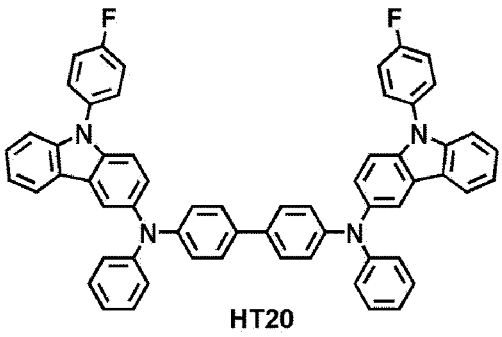
HT20

A thickness of the hole transport region may be about 100 Å to about 10,000 Å, for example, about 100 Å to about 1,000 Å. When the hole transport region includes at least one of a hole injection layer and a hole transport layer, a thickness of the hole injection layer may be about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the HIL, and the hole transport layer are within these ranges, satisfactory hole transporting characteristics may be obtained without a substantial increase in driving voltage.

The hole transport region may further include, in addition to the above-described materials, a charge-generation material for improving conductivity. The charge-generation material may be homogeneously or non-homogeneously dispersed in the hole transport region.

The charge-generation material may be, for example, a p-dopant. The p-dopant may be, but is not limited to, one of a quinone derivative, a metal oxide, or a cyano group-containing compound. Non-limiting examples of the p-dopant

include a quinone derivative, such as tetracyanoquinonedimethane (TCNQ), 2,3,5,6-tetrafluoro-tetracyano-1,4-benzoquinonedimethane (F4-TCNQ), or the like; a metal oxide, such as a tungsten oxide, a molybdenum oxide, or the like; or a cyano group-containing compound, such as Compound HT-D1 or F12, but embodiments are not limited thereto:

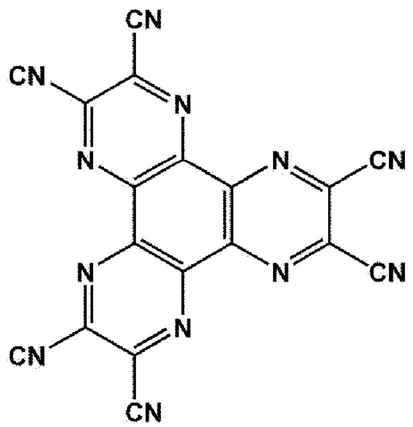

HT-D1

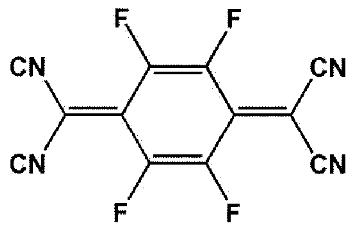

F4-TCNQ

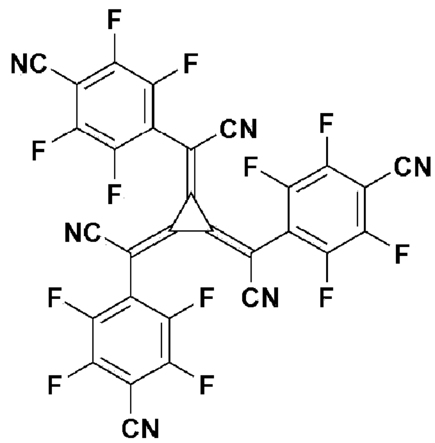

F12

The hole transport region may include a buffer layer.

The buffer layer may compensate for an optical resonance distance according to a wavelength of light emitted from the emission layer 15, and thus, efficiency of a formed organic light-emitting device may be improved.

The emission layer (EML) may be formed on the hole transport region by vacuum deposition, spin coating, casting, LB deposition, or the like. When the emission layer is formed by vacuum deposition or spin coating, the deposition or coating conditions may generally be similar to those applied in forming the HIL although the deposition or coating conditions may vary according to a material that is used to form the emission layer.

In some embodiments, when the hole transport region includes an electron blocking layer, a material for forming the electron blocking layer may be selected from, but is not limited to, the above-described materials that may be used in the hole transport region and a host material described below. For example, when the hole transport region includes an electron blocking layer, a material for forming the electron blocking layer may be mCP, which will be described below.

When the organic light-emitting device is a full-color organic light-emitting device, the emission layer may be patterned into a red emission layer, a green emission layer, and/or a blue emission layer. In one or more embodiments, the emission layer may have a structure in which a red emission layer, a green emission layer, and/or a blue emission layer are stacked, and thus, various modifications such as emission of white light are possible.

When the emission layer includes a host and a dopant, the amount of the dopant may generally be about 0.01 parts by weight to about 15 parts by weight with respect to 100 parts by weight of the host, but embodiments are not limited thereto.

A thickness of the emission layer may be about 100 Å to about 1,000 Å, for example, about 200 Å to about 600 Å. When the thickness of the emission layer is within the range described above, excellent luminescence characteristics may

be obtained without a substantial increase in driving voltage.

Next, an electron transport region may be located on the emission layer.

The electron transport region may include a hole blocking layer, an electron transport layer, an electron injection layer (EIL), or a combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be referred to the description provided for the conditions for forming the HIL.

When the electron transport region includes a hole blocking layer, the hole blocking layer may include, for example, at least one of 2,9-dimethyl-4,7-diphenyl-1,10-phenanthroline (BCP), 4,7-diphenyl-1,10-phenanthroline (Bphen), or bis(2-methyl-8-quinolinolato-N1,O8)-(1,1'-biphenyl-4-olato)aluminum (BAlq), but embodiments are not limited thereto:

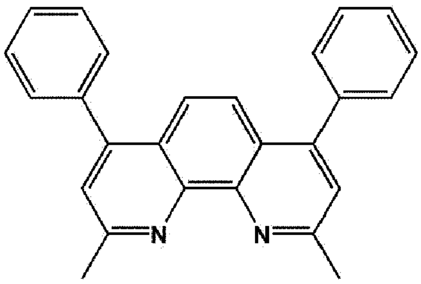

BCP

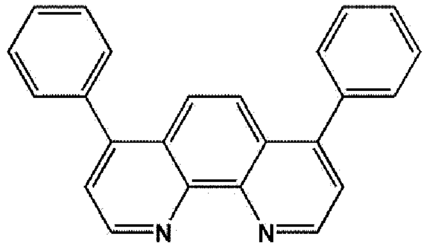

Bphen .

A thickness of the hole blocking layer may be about 20 Å to about 1,000 Å, for example, about 30 Å to about 300 Å. When the thickness of the hole blocking layer is within these ranges, excellent hole blocking characteristics may be obtained without a substantial increase in driving voltage.

The electron transport layer may further include at least one of 2,9-dimethyl-4,7-diphenyl-1,10-phenanthroline (BCP), 4,7-diphenyl-1,10-phenanthroline (Bphen), tris(8-hydroxy-quinolinato)aluminum ($Alq_3$), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), or 4-(naphthalen-1-yl)-3,5-diphenyl-4H-1,2,4-triazole (NTAZ), but embodiments are not limited thereto:

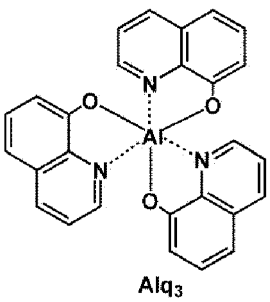

$Alq_3$

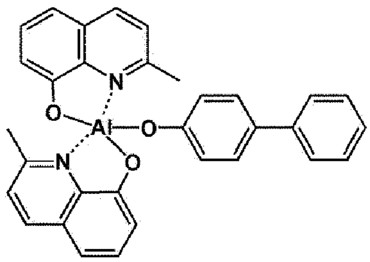

BAlq

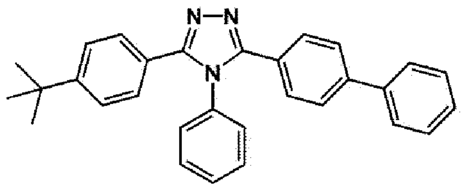

TAZ

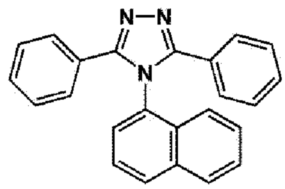

NTAZ .

In one or more embodiments, the electron transport layer may include at least one of compounds ET1 to ET25, but embodiments are not limited thereto:

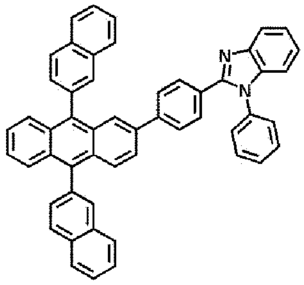

ET1

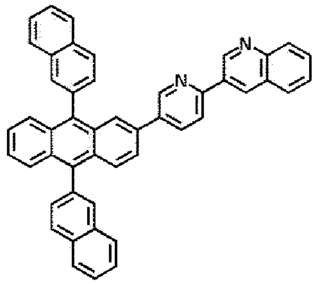

ET2

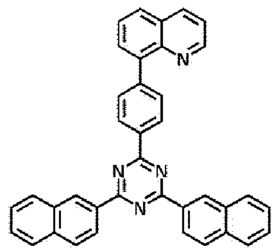

ET3

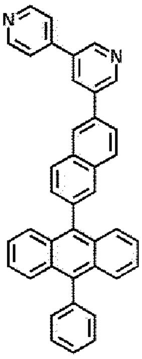

ET4

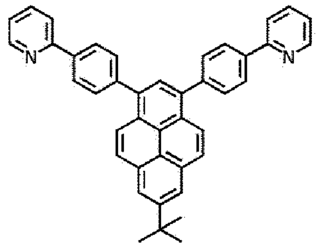

ET5

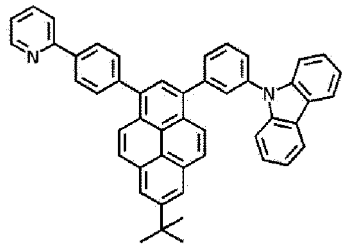

ET6

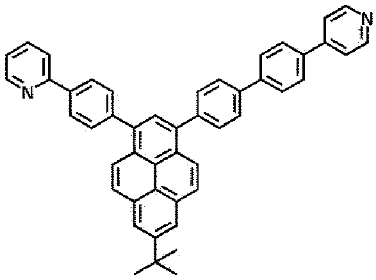

ET7

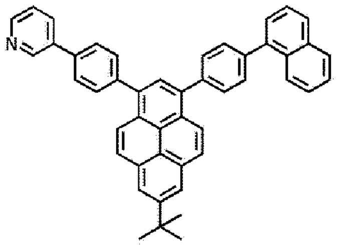

ET8

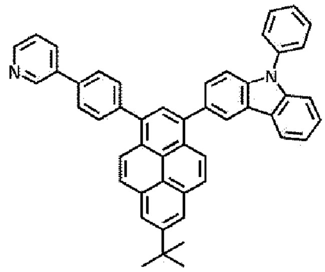

ET9

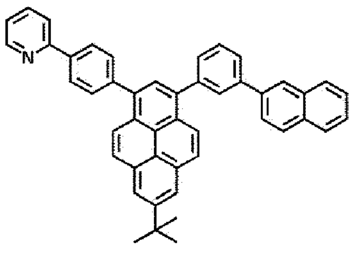

ET10

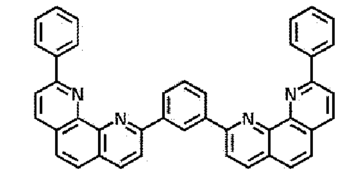

ET11

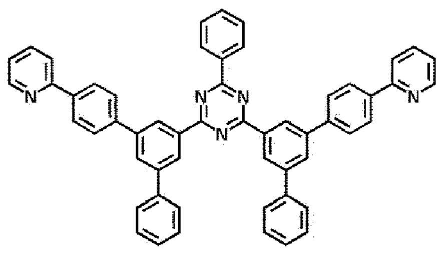

ET12

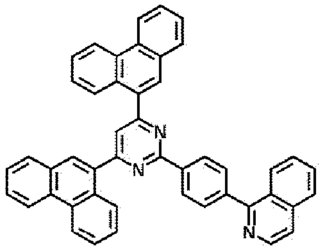
ET13

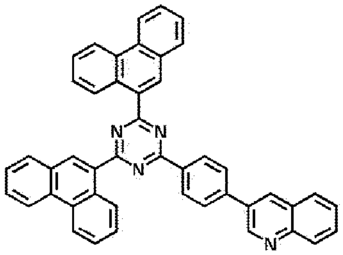
ET14

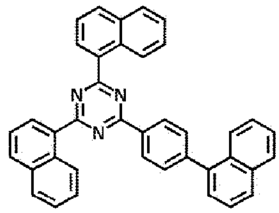
ET15

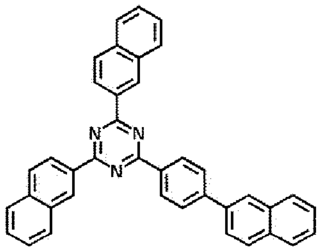
ET16

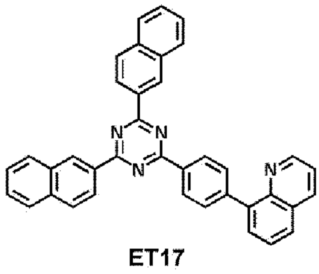
ET17

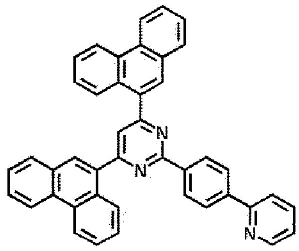
ET18

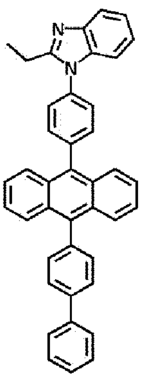
ET19

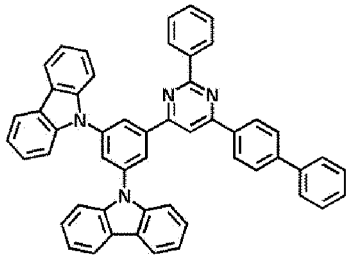
ET20

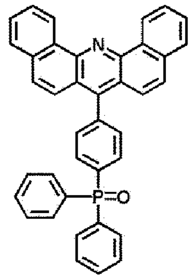
ET21

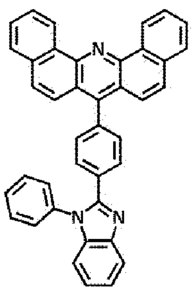
ET22

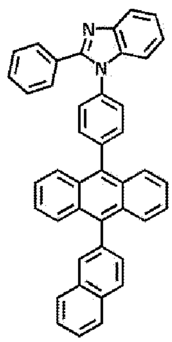
ET23

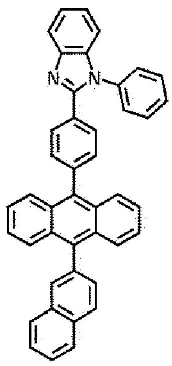
ET24

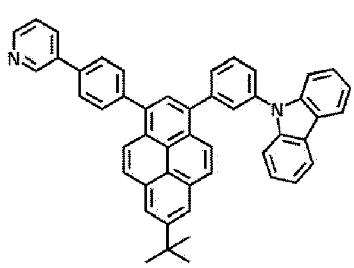
ET25

.

A thickness of the electron transport layer may be about 100 Å to about 1,000 Å, for example, about 150 Å to about 500 Å. When the thickness of the electron transport layer is within these ranges, satisfactory electron transporting characteristics may be obtained without a substantial increase in driving voltage.

The electron transport layer may further include a metal-containing material, in addition to the material as described herein.

The metal-containing material may include a Li complex. The Li complex may include, for example, Compound

ET-D1 (lithium quinolate, LiQ) or ET-D2, but embodiments are not limited thereto:

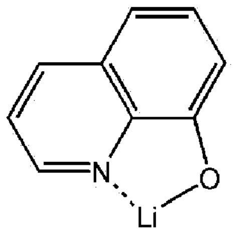

ET-D1

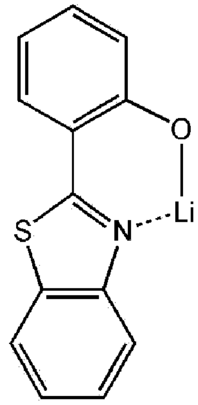

ET-D2

The electron transport region may include an EIL that facilitates the injection of electrons from the second electrode 19.

The EIL may include LiF, NaCl, CsF, $Li_2O$, BaO, or a combination thereof.

A thickness of the electron injection layer may be about 1 Å to about 100 Å, for example, about 3 Å to about 90 Å. When the thickness of the electron injection layer is within the range as described above, satisfactory electron injection characteristics may be obtained without a substantial increase in driving voltage.

Second electrode 19

The second electrode 19 may be disposed on the organic layer 15. The second electrode 19 may be a cathode. A material for forming the second electrode 19 may be a metal, an alloy, an electrically conductive compound, or a combination thereof, which have a relatively low work function. For example, lithium (Li), magnesium (Mg), aluminum (Al), silver (Ag), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, various modifications, such as formation of a transmissive second electrode using ITO or IZO, is possible.

The organic light-emitting device has been described with reference to FIG. 1, but embodiments are not limited thereto.

Another aspect provides an electronic apparatus including the organic light-emitting device.

The electronic apparatus may further include a thin-film transistor in addition to the organic light-emitting device as described herein. The thin-film transistor may include a source electrode, a drain electrode, and an active layer, wherein any one of the source electrode and the drain electrode may be electrically connected to any one of the first electrode and the second electrode of the organic light-emitting device.

Another aspect provides a diagnostic composition including at least one of the organometallic compounds represented by Formula A or Formula 1.

The diagnostic composition may include at least one type of organometallic compound represented by Formula A or Formula 1.

The organometallic compound represented by Formula A or Formula 1 provides high luminescence efficiency, and accordingly, the diagnostic composition including the at least one organometallic compound may have high diagnostic efficiency.

The diagnostic composition may be used in various applications including a diagnosis kit, a diagnosis reagent, a biosensor, a biomarker, or the like, but embodiments are not limited thereto.

The term "$C_1$-$C_{60}$ alkyl group" as used herein refers to a linear or branched saturated aliphatic hydrocarbon monovalent group having 1 to 60 carbon atoms. The term "$C_1$-$C_{60}$ alkylene group" as used herein refers to a divalent group having the same structure as the $C_1$-$C_{60}$ alkyl group.

Non-limiting examples of the $C_1$-$C_{60}$ alkyl group, the $C_1$-$C_{20}$ alkyl group, and/or the $C_1$-$C_{10}$ alkyl group include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl

group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched $C_6$ alkyl group, for example, a tert-butyl group that is substituted with two methyl groups.

The term "$C_1$-$C_{60}$ alkoxy group" as used herein refers to a monovalent group represented by $-OA_{101}$ (wherein $A_{101}$ is the $C_1$-$C_{60}$ alkyl group).

Non-limiting examples of the $C_1$-$C_{60}$ alkoxy group, a $C_1$-$C_{20}$ alkoxy group or $C_1$-$C_{10}$ alkoxy group include a methoxy group, an ethoxy group, an n-propoxy group, an isopropyloxy group, a butoxy group, a pentoxy group, or the like.

The term "$C_1$-$C_{60}$ alkylthio group" as used herein refers to a monovalent group represented by $-SA_{101'}$ (wherein $A_{101'}$ is the $C_1$-$C_{60}$ alkyl group).

The term "$C_2$-$C_{60}$ alkenyl group" as used herein refers to a structure containing at least one carbon-carbon double bond in the middle or at the end of the $C_2$-$C_{60}$ alkyl group, and non-limiting examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and non-limiting examples thereof include an ethynyl group, a propynyl group, or the like. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon ring group having 3 to 10 carbon atoms. The term "$C_3$-$C_{10}$ cycloalkylene group" as used herein refers to a divalent ring group having the same structure as the $C_3$-$C_{10}$ cycloalkyl group.

Non-limiting examples of the $C_3$-$C_{10}$ cycloalkyl group include a cyclopropyl group, a cyclobutyl group, a cyclopentyl group, a cyclohexyl group, a cycloheptyl group, a cyclooctyl group, an adamantanyl group, a bicyclo[1.1.1]pentyl group, a bicyclo[2.1.1]hexyl group, a bicyclo[2.2.1]heptyl(norbornanyl) group, a bicyclo[2.2.2]octyl group, or the like.

The term "$C_1$-$C_{10}$ heterocycloalkyl group" as used herein refers to a monovalent saturated ring group having at least one heteroatom selected from B, N, O, P, Si, S, Se, and Ge as a ring-forming atom and 1 to 10 carbon atoms as ring-forming atom(s). The term "$C_1$-$C_{10}$ heterocycloalkylene group" as used herein refers to a divalent group having the same structure as the $C_1$-$C_{10}$ heterocycloalkyl group.

Non-limiting examples of the $C_1$-$C_{10}$ heterocycloalkyl group include a silolanyl group, a silinanyl group, tetrahydrofuranyl group, a tetrahydro-2H-pyranyl group, a tetrahydrothiophenyl group, or the like.

The term "$C_3$-$C_{10}$ cycloalkenyl group" as used herein refers to a monovalent ring group that has 3 to 10 carbon atoms and at least one carbon-carbon double bond in the ring thereof and no aromaticity, and non-limiting examples thereof include a cyclopentenyl group, a cyclohexenyl group, a cycloheptenyl group, or the like. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent ring group that has at least one heteroatom selected from B, N, O, P, Si, S, Se, and Ge, as a ring-forming atom, 1 to 10 carbon atoms as ring-forming atom(s), and at least one double bond in its ring. Non-limiting examples of the $C_1$-$C_{10}$ heterocycloalkenyl group include a 2,3-dihydrofuranyl group, a 2,3-dihydrothiophenyl group, or the like. The term "$C_1$-$C_{10}$ heterocycloalkenylene group" as used herein refers to a divalent ring group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, a chrysenyl group, or the like. When the $C_6$-$C_{60}$ aryl group and the $C_6$-$C_{60}$ arylene group each include two or more rings, the rings may be fused with each other.

The term "$C_7$-$C_{60}$ alkyl aryl group" as used herein refers to a $C_6$-$C_{60}$ aryl group that is substituted with at least one $C_1$-$C_{60}$ alkyl group. The term "$C_7$-$C_{60}$ aryl alkyl group" as used herein refers to a $C_1$-$C_{60}$ alkyl group that is substituted with at least one $C_6$-$C_{60}$ aryl group.

The term "$C_1$-$C_{60}$ heteroaryl group" as used herein refers to a monovalent group having a heteroaromatic ring system that has at least one heteroatom selected from B, N, O, P, Si, S, Se, and Ge as a ring-forming atom, and 1 to 60 carbon atoms as ring-forming atom(s). The term "$C_1$-$C_{60}$ heteroarylene group" as used herein refers to a divalent group having a heteroaromatic ring system that has at least one heteroatom selected from B, N, O, P, Si, S, Se, and Ge as a ring-forming atom, and 1 to 60 carbon atoms as ring-forming atom(s). Non-limiting examples of the $C_1$-$C_{60}$ heteroaryl group include a pyridinyl group, a pyrimidinyl group, a pyrazinyl group, a pyridazinyl group, a triazinyl group, a quinolinyl group, an isoquinolinyl group, or the like. When the $C_1$-$C_{60}$ heteroaryl group and the $C_1$-$C_{60}$ heteroarylene group each include two or more rings, the rings may be fused with each other.

The term "$C_2$-$C_{60}$ alkyl heteroaryl group" as used herein refers to a $C_1$-$C_{60}$ heteroaryl group that is substituted with at least one $C_1$-$C_{60}$ alkyl group. The term "$C_2$-$C_{60}$ heteroaryl alkyl group" as used herein refers to a $C_1$-$C_{60}$ alkyl group that is substituted with at least one $C_1$-$C_{60}$ heteroaryl group.

The term "$C_6$-$C_{60}$ aryloxy group" as used herein refers to $-OA_{102}$ (wherein $A_{102}$ is the $C_6$-$C_{60}$ aryl group), and the term "$C_6$-$C_{60}$ arylthio group" as used herein refers to $-SA_{103}$ (wherein $A_{103}$ is the $C_6$-$C_{60}$ aryl group).

The term "$C_1$-$C_{60}$ heteroaryloxy group" as used herein indicates $-OA_{104}$ (wherein $A_{104}$ is a $C_1$-$C_{60}$ heteroaryl group), and the term "$C_1$-$C_{60}$ heteroarylthio group" as used herein indicates $-SA_{105}$ (wherein $A_{105}$ is the $C_1$-$C_{60}$ heteroaryl group).

The term "monovalent non-aromatic condensed polycyclic group" as used herein refers to a monovalent group (for example, having 8 to 60 carbon atoms) having two or more rings condensed with each other, only carbon atoms as ring-forming atoms, and no aromaticity in its entire molecular structure. Non-limiting examples of the monovalent non-aromatic condensed polycyclic group include a fluorenyl group or the like. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed with each other, a heteroatom selected from B, N, O, P, Si, S, Se, and Ge, other than carbon atoms, as a ring-forming atom, and no aromaticity in its entire molecular structure. Non-limiting examples of the monovalent non-aromatic condensed heteropolycyclic group include a carbazolyl group or the like. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated ring group having, as a ring-forming atom, 5 to 30 carbon atoms only. The $C_5$-$C_{30}$ carbocyclic group may be a monocyclic group or a polycyclic group. Non-limiting examples of the "$C_5$-$C_{30}$ carbocyclic group (unsubstituted or substituted with at least one $R_{1a}$)" as used herein may include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, an indene group and a fluorene group (each unsubstituted or substituted with at least one $R_{1a}$).

The term "$C_1$-$C_{30}$ heterocyclic group" as used herein refers to a saturated or unsaturated ring group having, as a ring-forming atom, at least one heteroatom selected from B, N, O, Si, P, S, Se, and Ge, other than 1 to 30 carbon atoms as ring-forming atom(s). The $C_1$-$C_{30}$ heterocyclic group may be a monocyclic group or a polycyclic group. Non-limiting examples of the "$C_1$-$C_{30}$ heterocyclic group (unsubstituted or substituted with at least one $R_{1a}$)" as used herein may include a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, or the like (each unsubstituted or substituted with at least one $R_{1a}$).

In the present specification, "TMS" represents $*-Si(CH_3)_3$, and "TMG" represents $*-Ge(CH_3)_3$.

At least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ hetero-

cycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may be:

deuterium, -F, -Cl, -Br, -I, $-SF_5$, $-CD_3$, $-CD_2H$, $-CDH_2$, $-CF_3$, $-CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;
a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, - $Si(Q_{11})(Q_{12})(Q_{13})$, $-Ge(Q_{11})(Q_{12})(Q_{13})$, $-N(Q_{14})(Q_{15})$, $-B(Q_{16})(Q_{17})$, $-P(Q_{18})(Q_{19})$, $-P(=O)(Q_{18})(Q_{19})$, or a combination thereof;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, $-SF_5$, $-CD_3$, $-CD_2H$, - $CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{21})(Q_{22})(Q_{23})$, - $Ge(Q_{21})(Q_{22})(Q_{23})$, $-N(Q_{24})(Q_{25})$, $-B(Q_{26})(Q_{27})$, $-P(Q_{28})(Q_{29})$, $-P(=O)(Q_{28})(Q_{29})$, or a combination thereof; or
$-Si(Q_{31})(Q_{32})(Q_{33})$, $-Ge(Q_{31})(Q_{32})(Q_{33})$, $-N(Q_{34})(Q_{35})$, $-B(Q_{36})(Q_{37})$, - $P(Q_{38})(Q_{39})$, or $-P(=O)(Q_{38})(Q_{39})$, and
$Q_1$ to $Q_9$, $Q_{11}$ to $Q_{19}$, $Q_{21}$ to $Q_{29}$, and $Q_{31}$ to $Q_{39}$ may each independently be hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a $C_1$-$C_{60}$ heteroaryloxy group, a $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

A term "($C_1$-$C_{20}$ alkyl) X group" (e.g., ($C_1$-$C_{20}$ alkyl) phenyl group) used herein refers to an X group (e.g., a phenyl group) substituted with at least one $C_1$-$C_{20}$ alkyl group.
Hereinafter, compounds and organic light-emitting devices, according to one or more embodiments, will be described in further detail with reference to Synthesis Example and Examples. However, the following examples are not

intended to limit the scope of the disclosure. The wording "'B' was used instead of 'A'" used in describing Synthesis Examples means that an amount of 'A' used was identical to an amount of 'B' used, in terms of a molar equivalent.

EXAMPLES

Synthesis Examples

Synthesis Example 1: Synthesis of Compound 1

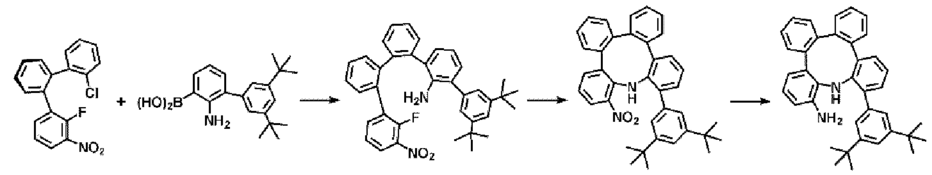

1-A 1-B 1-C 1-D 1-E

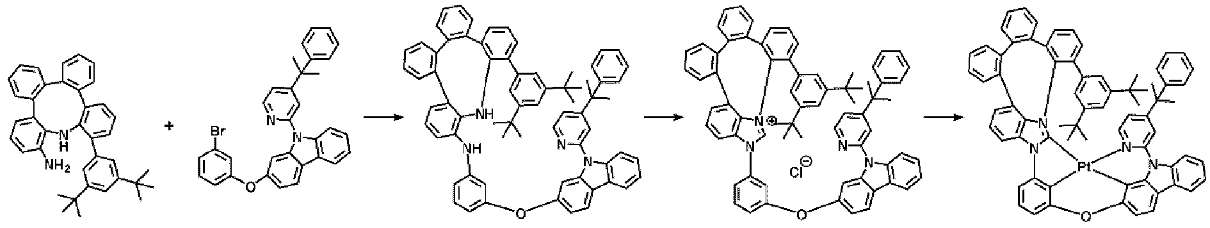

1-E 1-F 1-G 1-H 1

1) Synthesis of Compound 1-C

In a round-bottom flask, Compound 1-A (10.7 grams (g), 32.7 millimoles (mmol)), compound 1-B (15.6 g, 49.1 mmol), tris(dibenzylideneacetone)dipalladium(0) ($Pd_2(dba)_3$) (2.79 g, 3.27 mmol), 2-dicyclohexylphosphino-2',6'-dimethoxybiphenyl (SPhos) (2.50 g, 6.54 mmol), and $K_2CO_3$ (5.48 g, 42.5 mmol) were added and mixed with 1,4-dioxane/$H_2O$ (100 mL/25 mL). The mixed solution was stirred under reflux at 110 °C for 12 hours. After completion of the reaction, the temperature was lowered to room temperature, and then, ethyl acetate and a saturated aqueous ammonium chloride solution were added to the reaction mixture. An organic solution layer was obtained by an extraction process using ethyl acetate, dried by using anhydrous $MgSO_4$, and then filtered. The filtrate was concentrated and purified by silica gel chromatography, so as to obtain 18.2 g (yield of 97 %) of Compound 1-C.

HPLC-MS: 573.23 $[M+H]^+$.

(2) Synthesis of Compound 1-D

In a round-bottom flask, Compound 1-C (18.2 g, 31.8 mmol) and $K_2CO_3$ (13.2 g, 95.3 mmol) were added and mixed with dimethylformamide (DMF) (300 mL). The mixed solution was stirred at 100 °C for 12 hours. After completion of the reaction, the temperature was lowered to room temperature, and then, ethyl acetate and a saturated aqueous ammonium chloride solution were added to the reaction mixture. An organic solution layer was obtained by an extraction process using ethyl acetate, dried by using anhydrous $MgSO_4$, and then filtered. The filtrate was concentrated and purified by silica gel chromatography, so as to obtain 11.5 g (yield of 65 %) of Compound 1-D.

HPLC-MS: 553.23 $[M+H]^+$.

(3) Synthesis of Compound 1-E

In a round-bottom flask, Compound 1-D (11.5 g, 20.8 mmol), palladium on carbon (Pd/C) (10 wt% on carbon, 1.15 g), and ammonium formate (26.2 g, 415 mmol) were added and mixed with methanol (100 mL). The mixed solution was stirred under reflux at 80 °C for 12 hours. After completion of the reaction, the temperature was lowered to room temperature, and then, ethyl acetate and a saturated aqueous ammonium chloride solution were added to the reaction mixture. An organic solution layer was obtained by an extraction process using ethyl acetate, dried by using anhydrous

$MgSO_4$, and then filtered. The filtrate was concentrated and purified by silica gel chromatography, so as to obtain 9.5 g (yield of 87 %) of Compound 1-E.

HPLC-MS: 523.25 $[M+H]^+$.

(4) Synthesis of Compound 1-G

In a round-bottom flask, Compound 1-E (3 g, 5.7 mmol), Compound 1-F (3.06 g, 5.7 mmol), $Pd_2(dba)_3$ (0.26 g, 0.29 mmol), SPhos (0.23 g, 0.57 mmol), and sodium t-butoxide (NaOtBu) (1.1 g, 11.5 mmol) were added and mixed with toluene (100 mL). The mixed solution was stirred under reflux at 110 °C for 12 hours. After completion of the reaction, the temperature was lowered to room temperature, and then, ethyl acetate and a saturated aqueous ammonium chloride solution were added to the reaction mixture. An organic solution layer was obtained by an extraction process using ethyl acetate, dried by using anhydrous $MgSO_4$, and then filtered. The filtrate was concentrated and purified by silica gel chromatography, so as to obtain 4.8 g (yield of 86 %) of Compound 1-G.

HPLC-MS: 975.39 $[M+H]^+$.

(5) Synthesis of Compound 1-H

In a round-bottom flask, Compound 1-G (4.8 g, 4.95 mmol) and p-toluenesulfonic acid (0.085 g, 0.906 mmol) were added and mixed with triethylorthoformate (40 mL). The mixed solution was stirred under reflux at 80 °C for 12 hours. After completion of the reaction, the temperature was lowered to room temperature, and then, ethyl acetate and a saturated aqueous ammonium chloride solution were added to the reaction mixture. An organic solution layer was obtained by an extraction process using ethyl acetate, dried by using anhydrous $MgSO_4$, and then filtered. The filtrate was concentrated and purified by silica gel chromatography, so as to obtain 4.8 g (yield of 95 %) of Compound 1-H.

HPLC-MS: 985.37 $[M+H]^+$.

(6) Synthesis of Compound 1

In a round-bottom flask, Compound 1-H (4.85 g, 4.70 mmol), $K_2PtCl_4$ (2.15 g, 5.17 mmol), and sodium acetate (NaOAc) (1.16 g, 14.1 mmol) were added and mixed with dioxane (80 mL). The mixed solution was stirred under reflux at 100 °C for 12 hours. After completion of the reaction, the temperature was lowered to room temperature, and then, ethyl acetate and a saturated aqueous ammonium chloride solution were added to the reaction mixture. An organic solution layer was obtained by an extraction process using ethyl acetate, dried by using anhydrous $MgSO_4$, and then filtered. The filtrate was concentrated and purified by silica gel chromatography, so as to obtain 1.6 g (yield of 29 %) of Compound 1.

HPLC-MS: 1178.42 $[M+H]^+$.

Synthesis Example 2: Synthesis of Compound 2

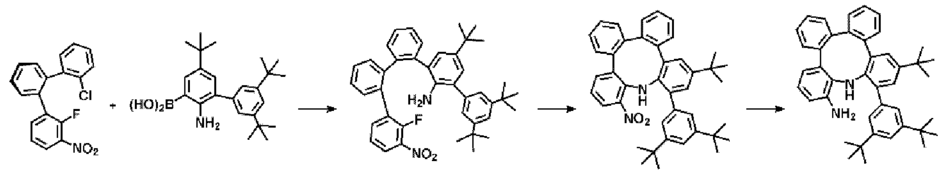

2-A 2-B 2-C 2-D 2-E

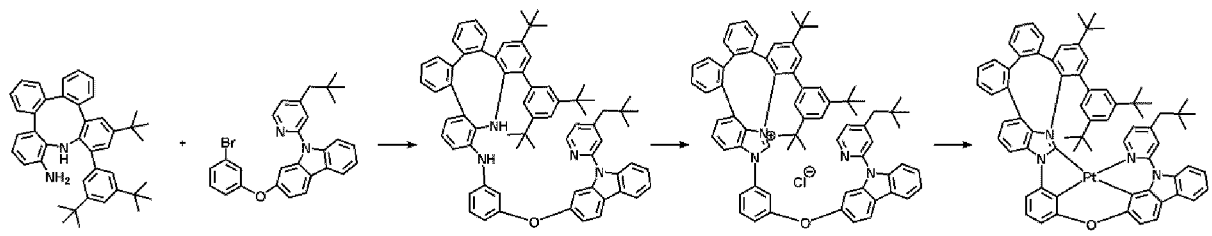

2-E 2-F 2-G 2-H 2

1) Synthesis of Compound 2-C

Compound 2-C (yield of 74 %) was synthesized in a similar manner as in the synthesis of Compound 1-C in Synthesis Example 1, except that Compound 2-B was used instead of Compound 1-B.

HPLC-MS: 629.33 $[M+H]^+$.

(2) Synthesis of Compound 2-D

Compound 2-D (yield of 64 %) was synthesized in a similar manner as in the synthesis of Compound 1-D in Synthesis Example 1, except that Compound 2-C was used instead of Compound 1-C.

HPLC-MS: 609.33 $[M+H]^+$.

(3) Synthesis of Compound 2-E

Compound 2-E (yield of 95 %) was synthesized in a similar manner as in the synthesis of Compound 1-E in Synthesis Example 1, except that Compound 2-D was used instead of Compound 1-D.

HPLC-MS: 579.35 $[M+H]^+$.

(4) Synthesis of Compound 2-G

Compound 2-G (yield of 69 %) was synthesized in a similar manner as in the synthesis of Compound 1-G in Synthesis Example 1, except that Compound 2-G and Compound 2-F were used instead of Compound 1-G and Compound 1-F, respectively.

HPLC-MS: 983.52 $[M+H]^+$.

(5) Synthesis of Compound 2-H

Compound 2-H (yield of 96 %) was synthesized in a similar manner as in the synthesis of Compound 1-H in Synthesis Example 1, except that Compound 2-G was used instead of Compound 1-G.

HPLC-MS: 993.44 $[M+H]^+$.

(6) Synthesis of Compound 2

Compound 2 (yield of 33 %) was synthesized in a similar manner as in the synthesis of Compound 1 in Synthesis Example 1, except that Compound 2-H was used instead of Compound 1-H.

HPLC-MS: 1186.47 $[M+H]^+$.

Synthesis Example 3: Synthesis of Compound 3

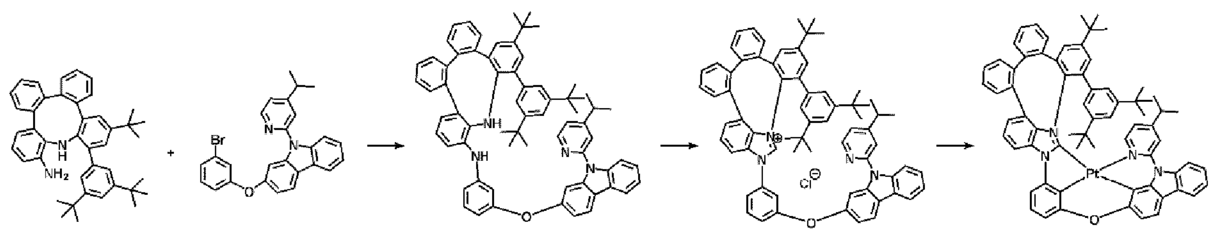

2-B 3-A 3-B 3-C 3

(1) Synthesis of Compound 3-B

Compound 3-B (yield of 88 %) was synthesized in a similar manner as in the synthesis of Compound 1-G in Synthesis Example 1, except that Compound 2-B and Compound 3-A were used instead of Compound 1-E and Compound 1-F, respectively.

HPLC-MS: 955.47 $[M+H]^+$.

(2) Synthesis of Compound 3-C

Compound 3-C (yield of 93 %) was synthesized in a similar manner as in the synthesis of Compound 1-H in Synthesis Example 1, except that Compound 3-B was used instead of Compound 1-G.
HPLC-MS: 965.55 $[M+H]^+$.

(3) Synthesis of Compound 3

Compound 3 (yield of 37 %) was synthesized in a similar manner as in the synthesis of Compound 1 in Synthesis Example 1, except that Compound 3-C was used instead of Compound 1-H.
HPLC-MS: 1158.43 $[M+H]^+$.

Synthesis Example 4: Synthesis of Compound 4

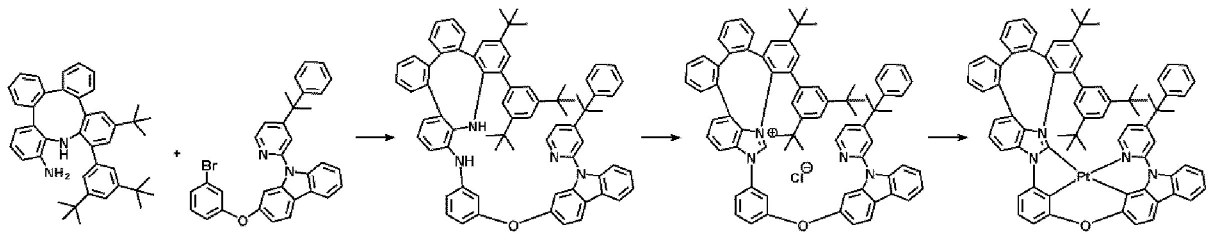

2-B 1-F 4-A 4-B 4

(1) Synthesis of Compound 4-A

Compound 4-A (yield of 83 %) was synthesized in a similar manner as in the synthesis of Compound 1-G in Synthesis Example 1, except that Compound 2-B was used instead of Compound 1-E.
HPLC-MS: 1031.50 $[M+H]^+$.

(2) Synthesis of Compound 4-B

Compound 4-B (yield of 83 %) was synthesized in a similar manner as in the synthesis of Compound 1-H in Synthesis Example 1, except that Compound 4-A was used instead of Compound 1-G.
HPLC-MS: 1040.55 $[M+H]^+$.

(3) Synthesis of Compound 4

Compound 4 (yield of 29 %) was synthesized in a similar manner as in the synthesis of Compound 1 in Synthesis Example 1, except that Compound 4-B was used instead of Compound 1-H.
HPLC-MS: 1234.48 $[M+H]^+$.

Evaluation Example 1: Calculation of LUNTO contribution

To calculate values of LUNTO(A1) and LUNTO(A2), the DFT calculation (B3LYP/6-31G(d,p)) was performed first for each of Compounds 1 to 4 and Compounds A and B to optimize structures of the compounds in a $T_1$ state, and then, based on the optimized structures of the compounds, the excited state from $S_0$ to $T_1$ was calculated according to TD-DFT. The calculation results are shown in Table 1. Here, the LUNTO(A1) denotes contribution of benzimidazole condensed ring portions of each compound to the LUNTO, and the LUNTO(A2) denotes contribution of pyridine ring portions of each compound to the LUNTO. For the calculation of the LUNTO contribution, the software, Multiwfn, was used.

Evaluation Example 2: Evaluation of photoluminescence quantum yield (PLQY)

Poly(methyl methacrylate) (PMMA) in a methylene chloride ($CH_2Cl_2$) solution, 5 wt% of 4,4'-bis(N-carbazolyl)-1,1'-biphenyl (CBP), and Compound 1 were mixed, and the resulting product was applied onto a quartz substrate by a spin-coating method using a spin coater. The substrate was heat-treated in an 80 °C oven, and then cooled to room

temperature to produce a film.

To evaluate PLQYs in the film, a Hamamatsu Photonics absolute PL quantum yield measurement system equipped with a xenon light source, a monochromator, a photonic multichannel analyzer, and an integrating sphere and utilizing the PLQY measurement software (Hamamatsu Photonics, Ltd., Shizuoka, Japan) was used to evaluate PLQY for Compound 1, and this was repeated for Compounds 2 to 4 and Compounds A to D. The evaluation results are shown in Table 1.

Example 1

A glass substrate on which a 50 nm-thickness ITO electrode (also referred to as a first electrode or an anode) was deposited was cleaned with deionized (DI) water by ultrasonication. Following the ultrasonication using DI water, ultrasonication using isopropyl alcohol, acetone, and methane in the stated order were performed again on the glass substrate. Then, the glass substrate was dried, and then transferred to a plasma cleaner. The glass substrate was cleaned by using oxygen plasma for 5 minutes, and then transferred to a vacuum laminator.

Subsequently, Compound HT3 was vacuum-deposited on the ITO electrode of the glass substrate to form a hole injection layer having a thickness of 350 nm, and Compound HT-D1 was vacuum-deposited on the hole injection layer to form a hole transport layer having a thickness of 30 nm. TAPC was vacuum-deposited on the hole transport layer to form an electron blocking layer having a thickness of 10 nm.

Compound H26, Compound E1 (the weight ratio of compounds H26 and E1 was 6:4), and Compound 1 (10 wt%) were co-deposited on the electron blocking layer to form an emission layer having a thickness of 30 nm.

Compound ET3 was vacuum-deposited on the emission layer to form an electron transport layer having a thickness of 25 nm, and Compound ET-D1 (LiQ) was deposited on the electron transport layer to form an electron injection layer having a thickness of 0.5 nm. Al was formed on the electron injection layer to form a second electrode (cathode) having a thickness of 100 nm, thereby completing the manufacture of an organic light-emitting device.

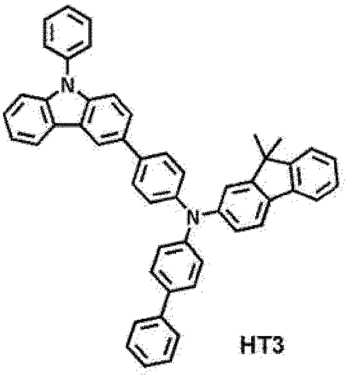
HT3

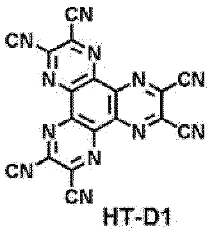
HT-D1

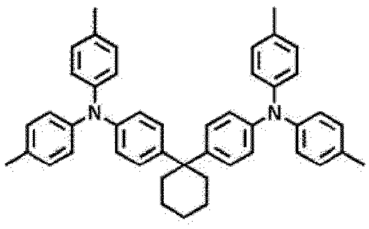
TAPC

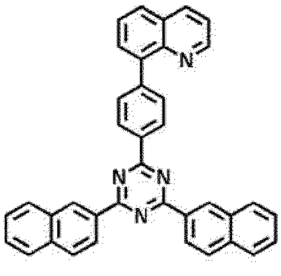
ET3

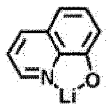
ET-D1

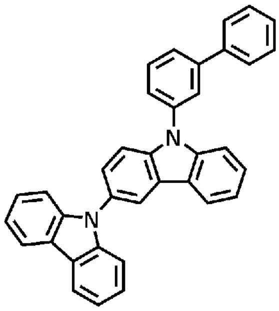

H26

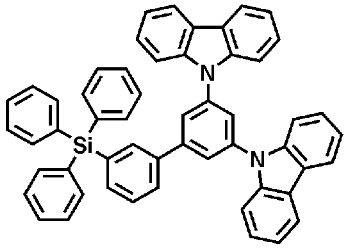

E1

Examples 2 to 4 and Comparative Examples 1 to 4

Organic light-emitting devices were manufactured in a similar manner as in Example 1, except that compounds shown in Table 1 were each used as an emitter in an emission layer.

Evaluation Example 3: Characterization of organic light-emitting devices

For the organic light-emitting devices of Examples 1 to 4 and Comparative Examples 1 to 4, maximum external quantum efficiency (Max EQE) was measured and evaluated by using a current-voltage meter (Keithley 2400) and a luminance meter (Minolta Cs-1000A). The measurement and evaluation results are shown in Table 1.

Table 1

| | Emitter in emission layer | LUNTO(A1) (%) | LUNTO(A2) (%) | PLQY (relative value, %) | Max EQE (relative value, %) |
|---|---|---|---|---|---|
| Example 1 | Compound 1 | 26.49 | 43.93 | 109 | 108 |
| Example 2 | Compound 2 | 19.54 | 52.65 | 127 | 108 |
| Example 3 | Compound 3 | 24.56 | 41.76 | 114 | 115 |
| Example 4 | Compound 4 | 20.48 | 52.58 | 125 | 111 |
| Comparative Example 1 | Compound A | 29.28 | 34.98 | 100 | 100 |
| Comparative Example 2 | Compound B | 45.54 | 17.37 | 90 | 84 |
| Comparative Example 3 | Compound C | 39.20 | 22.55 | 98 | 97 |
| Comparative Example 4 | Compound D | 34.56 | 27.85 | 93 | 96 |

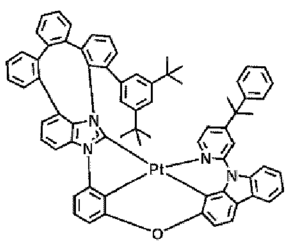

1

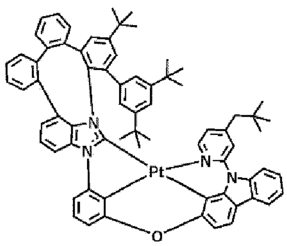

2

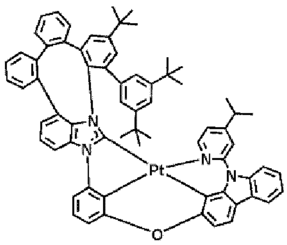

3

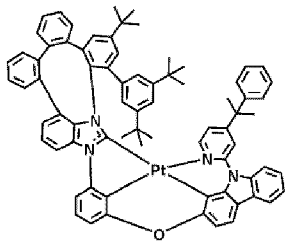

4

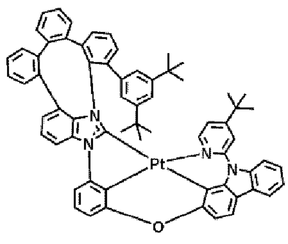

A

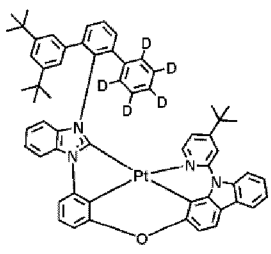

B

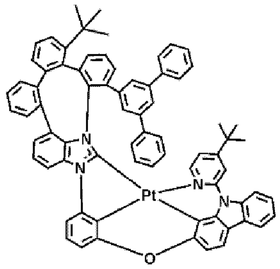

C

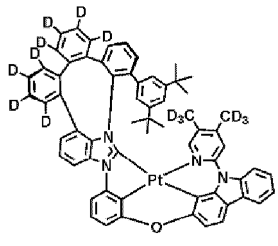

D

Referring Table 1, it was confirmed that the organic light-emitting devices according to one or more embodiments had excellent luminescence efficiency. Also, it was confirmed that the organic light-emitting devices of Examples 1 to 4 had significant superior luminescence efficiency to the organic light-emitting devices of Comparative Examples 1 to 4.

According to the one or more embodiments, an organometallic compound has excellent luminescence characteristics and excellent charge transfer characteristics, and thus an electronic device, e.g., an organic light-emitting device, including at least one of the organometallic compounds described herein may have a low driving voltage, high efficiency, and/or long lifespan characteristics. Accordingly, a high-quality organic light-emitting device may be implemented by using the organometallic compound as described herein.

In addition, a high-quality electronic apparatus including the organic light-emitting device may be provided.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An organometallic compound represented by Formula A and satisfying Inequality 1:

Formula A

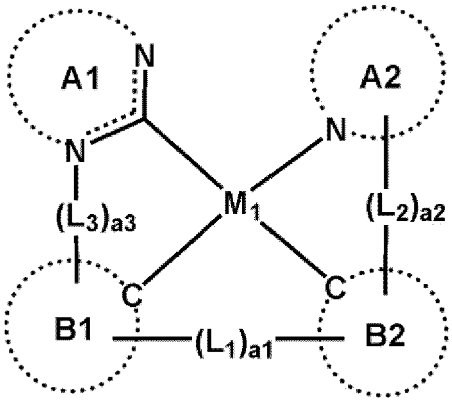

wherein, in Formula A,

$M_1$ is a metal or metalloid,
ring A1 and ring A2 are each independently a $C_1$-$C_{60}$ heterocyclic group unsubstituted or substituted with at least one $R_{10a}$,
ring B1 and ring B2 are each independently a $C_5$-$C_{60}$ carbocyclic group unsubstituted or substituted with at least one $R_{10a}$, or a $C_1$-$C_{60}$ heterocyclic group unsubstituted or substituted with at least one $R_{10a}$,
$L_1$ to $L_3$ are each independently a single bond, O, S, Se, $N(R_{11a})$, $B(R_{11a})$, $C(R_{11a})(R_{12a})$, or $Si(R_{11a})(R_{12a})$,
a1 to a3 are each independently 1, 2, 3, 4, or 5,
$R_{10a}$, $R_{11a}$, and $R_{12a}$ are each independently hydrogen, deuterium, -F, -Cl, -Br, -I, $-SF_5$, a hydroxyl group, a cyano group, a nitro group, an amidino group, a hydrazino group, a hydrazono group, a substituted or unsubstituted

$C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -Ge($Q_1$)($Q_2$)($Q_3$), -B($Q_1$)($Q_2$), -N($Q_1$)($Q_2$), -P($Q_1$)($Q_2$), - C(=O)($Q_1$), -S(=O)($Q_1$), -S(=O)$_2$($Q_1$), -P(=O)($Q_1$)($Q_2$), or -P(=S)($Q_1$)($Q_2$),

at least two neighboring groups of $R_{10a}$, $R_{11a}$, and $R_{12a}$ are optionally bonded together to form a substituted or unsubstituted $C_5$-$C_{30}$ carbocyclic group or a substituted or unsubstituted $C_1$-$C_{30}$ heterocyclic group,

at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group is:

deuterium, -F, -Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, -Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -Si($Q_{11}$)($Q_{12}$)($Q_{13}$), - Ge($Q_{11}$)($Q_{12}$)($Q_{13}$), -N($Q_{14}$)($Q_{15}$), -B($Q_{16}$)($Q_{17}$), -P($Q_{18}$)($Q_{19}$), -P(=O)($Q_{18}$)($Q_{19}$), or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group,

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$

heteroaryloxy group, a $C_1$-$C_{60}$ heteroarylthio group, a monovalent non-aromatic condensed polycyclic group, a monovalent non-aromatic condensed heteropolycyclic group, -Si($Q_{21}$)($Q_{22}$)($Q_{23}$), -Ge($Q_{21}$)($Q_{22}$)($Q_{23}$), -N($Q_{24}$)($Q_{25}$), -B($Q_{26}$)($Q_{27}$), - P(=O)($Q_{28}$)($Q_{29}$), -P(=O)($Q_{28}$)($Q_{29}$), or a combination thereof; or -Si($Q_{31}$)($Q_{32}$)($Q_{33}$), -Ge($Q_{31}$)($Q_{32}$)($Q_{33}$), -N($Q_{34}$)($Q_{35}$), -B($Q_{36}$)($Q_{37}$), - P(=O)($Q_{38}$)($Q_{39}$), or -P(=O)($Q_{38}$)($Q_{39}$), and

$Q_1$ to $Q_9$, $Q_{11}$ to $Q_{19}$, $Q_{21}$ to $Q_{29}$, and $Q_{31}$ to $Q_{39}$ are each independently: hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group:

Inequality 1

$$\mathrm{LUNTO(A1)} < \mathrm{LUNTO(A2)}$$

wherein, in Inequality 1,

LUNTO(A1) denotes a percentage of contribution of ring A1 to lowest unoccupied natural transition orbital (LUNTO) distribution of the organometallic compound in a triplet ($T_1$) state,

LUNTO(A2) denotes a percentage of contribution of ring A2 to LUNTO distribution of the organometallic compound in a $T_1$ state, and

the LUNTO distribution of the organometallic compound in a $T_1$ state represents LUNTO distribution for the organometallic compound excited from a ground state ($S_0$) to a $T_1$ state, as calculated by time-dependent density function theory.

**2.** The organometallic compound of claim 1, wherein the organometallic compound further satisfies Inequalities 2 and 3:

Inequality 2

$$15 < \mathrm{LUNTO(A1)} < 28$$

Inequality 3

$$40 < \mathrm{LUNTO(A2)} < 80$$

wherein, in Inequalities 2 and 3,

LUNTO(A1) and LUNTO(A2) are as defined in claim 1.

**3.** The organometallic compound of claims 1 or 2, wherein $M_1$ is beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au); and/or wherein ring A1 comprises at least two electron-donating groups, and ring A2 comprises at least one electron-donating group.

**4.** The organometallic compound of any of claims 1-3, wherein the organometallic compound is represented by Formula 1:

Formula 1

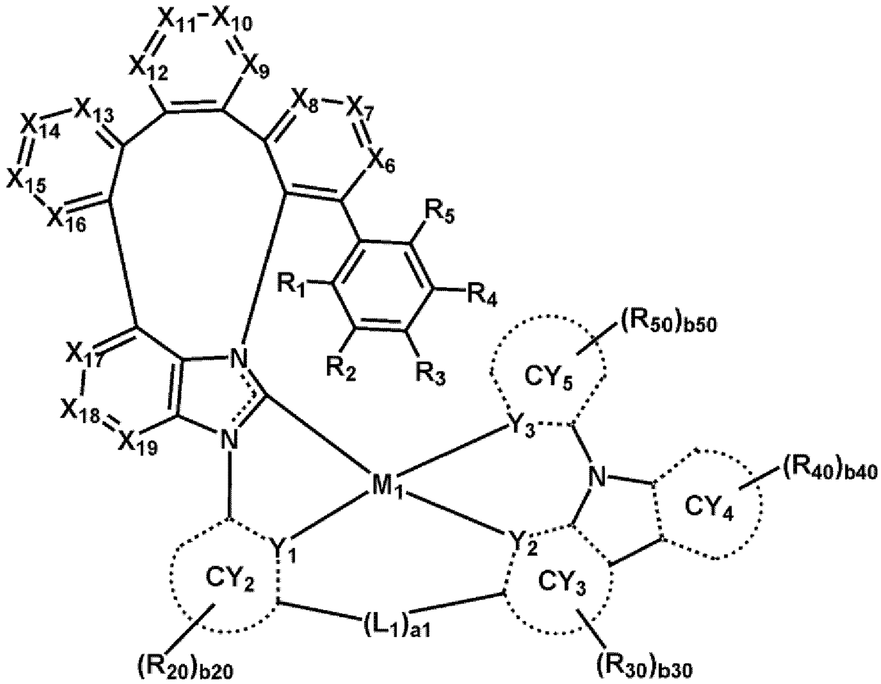

wherein, in Formula 1,

$M_1$ and a1 are each as defined in claim 1,
ring $CY_2$ to ring $CY_5$ are each independently a $C_5$-$C_{60}$ carbocyclic group or a $C_1$-$C_{60}$ heterocyclic group,
$Y_1$ to $Y_3$ are each independently C or N,
$X_6$ is $C(R_6)$ or N, $X_7$ is $C(R_7)$ or N, and $X_8$ is $C(R_8)$ or N,
$X_9$ is $C(R_9)$ or N, $X_{10}$ is $C(R_{10})$ or N, $X_{11}$ is $C(R_{11})$ or N, and $X_{12}$ is $C(R_{12})$ or N,
$X_{13}$ is $C(R_{13})$ or N, $X_{14}$ is $C(R_{14})$ or N, $X_{15}$ is $C(R_{15})$ or N, and $X_{16}$ is $C(R_{16})$ or N,
$X_{17}$ is $C(R_{17})$ or N, $X_{18}$ is $C(R_{18})$ or N, and $X_{19}$ is $C(R_{19})$ or N,
$L_1$ is a single bond, O, S, Se, $N(R_{61})$, $B(R_{61})$, $C(R_{61})(R_{62})$, or $Si(R_{61})(R_{62})$,
$R_1$ to $R_{20}$, $R_{30}$, $R_{40}$, $R_{50}$, $R_{61}$, and $R_{62}$ are each independently hydrogen, deuterium, -F, -Cl, -Br, -I, $-SF_5$, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$,
at least two neighboring groups among $R_1$ to $R_{20}$, $R_{30}$, $R_{40}$, $R_{50}$, $R_{61}$, and $R_{62}$ are optionally bonded together to form a substituted or unsubstituted $C_5$-$C_{30}$ carbocyclic group or a substituted or unsubstituted $C_1$-$C_{30}$ heterocyclic group,
b20, b30, b40, and b50 are each independently 1, 2, 3, 4, 5, 6, 7, 8, 9, or 10,
at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group,

the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group is:

deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{11})(Q_{12})(Q_{13})$, $-Ge(Q_{11})(Q_{12})(Q_{13})$, $-N(Q_{14})(Q_{15})$, $-B(Q_{16})(Q_{17})$, $-P(Q_{18})(Q_{19})$, $-P(=O)(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{21})(Q_{22})(Q_{23})$, $-Ge(Q_{21})(Q_{22})(Q_{23})$, $-N(Q_{24})(Q_{25})$, $-B(Q_{26})(Q_{27})$, $-P(Q_{28})(Q_{29})$, $-P(=O)(Q_{28})(Q_{29})$, or a combination thereof; or

$-Si(Q_{31})(Q_{32})(Q_{33})$, $-Ge(Q_{31})(Q_{32})(Q_{33})$, $-N(Q_{34})(Q_{35})$, $-B(Q_{36})(Q_{37})$, $-P(Q_{38})(Q_{39})$, or $-P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ are each independently: hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$

heteroarylthio group, a substituted or unsubstituted monovalent non-aromatic condensed polycyclic group, or a substituted or unsubstituted monovalent non-aromatic condensed heteropolycyclic group.

**5.** The organometallic compound of claim 4, wherein ring $CY_2$ to ring $CY_5$ are each independently a benzene group, a naphthalene group, a phenanthrene group, a furan group, a thiophene group, a pyrrole group, a cyclopentene group, a silole group, a germole group, a benzofuran group, a benzothiophene group, an indole group, an indene group, a benzosilole group, a benzogermole group, a dibenzofuran group, a dibenzothiophene group, a carbazole group, a fluorene group, a dibenzosilole group, a dibenzogermole group, a pyridine group, a pyrimidine group, a pyridazine group, or a pyrazine group; and/or wherein

at least two of $R_1$ to $R_{19}$ are each independently a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, or a substituted or unsubstituted $C_1$-$C_{60}$ alkylthio group, and/or at least one of $R_{50}$ is a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

**6.** The organometallic compound of claims 4 or 5, wherein $R_1$ to $R_{20}$, $R_{30}$, $R_{40}$, $R_{50}$, $R_{61}$, and $R_{62}$ are each independently:

hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, or a $C_1$-$C_{20}$ alkylthio group;

a $C_1$-$C_{20}$ alkyl group, a $C_1$-$C_{20}$ alkoxy group, or a $C_1$-$C_{20}$ alkylthio group, each substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_1$-$C_{20}$ alkyl group, a fluorinated $C_1$-$C_{20}$ alkyl group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group (also known as a norbornanyl group), a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a pyridinyl group, a pyrimidinyl group, or a combination thereof;

a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a

benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, - Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_1$-$C_{20}$ alkyl group, a fluorinated $C_1$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or **$-N(Q_1)(Q_2)$,** $-Si(Q_3)(Q_4)(Q_5)$, $-Ge(Q_3)(Q_4)(Q_5)$, $-B(Q_6)(Q_7)$, $-P(=O)(Q_8)(Q_9)$, or - $P(Q_8)(Q_9)$.

**7.** The organometallic compound of any of claims 1-6, wherein the organometallic compound is represented by Formula 11:

Formula 11

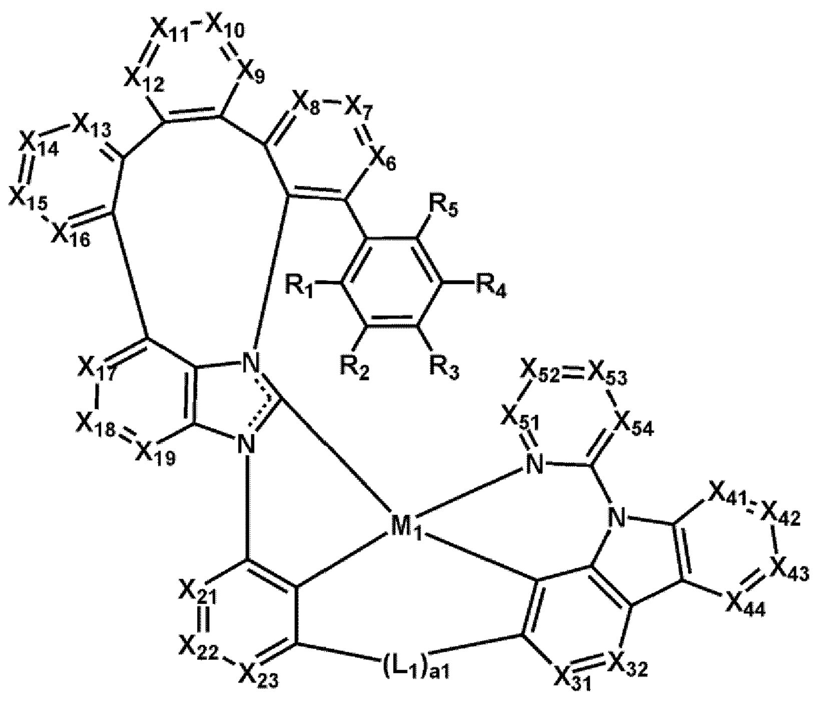

wherein, in Formula 11,

$M_1$, $X_6$ to $X_{19}$, $L_1$, a1, and $R_1$ to $R_5$ are each as defined in claim 4,
$X_{21}$ is C($R_{21}$) or N, $X_{22}$ is C($R_{22}$) or N, and $X_{23}$ is C($R_{23}$) or N,
$X_{31}$ is C($R_{31}$) or N, and $X_{32}$ is C($R_{32}$) or N,
$X_{41}$ is C($R_{41}$) or N, $X_{42}$ is C($R_{42}$) or N, $X_{43}$ is C($R_{43}$) or N, and $X_{44}$ is C($R_{44}$) or N,
$X_{51}$ is C($R_{51}$) or N, $X_{52}$ is C($R_{52}$) or N, $X_{53}$ is C($R_{53}$) or N, and $X_{54}$ is C($R_{54}$) or N,
$R_{21}$ to $R_{23}$ are each defined as for $R_{20}$ in claim 4,
$R_{31}$ and $R_{32}$ are each defined as for $R_{30}$ in claim 4,
$R_{41}$ to $R_{44}$ are each defined as for $R_{40}$ in claim 4, and
$R_{51}$ to $R_{54}$ are each defined as for $R_{50}$ in claim 4.

**8.** The organometallic compound of any of claims 1-7, wherein the organometallic compound is represented by one of Compounds 1 to 53:

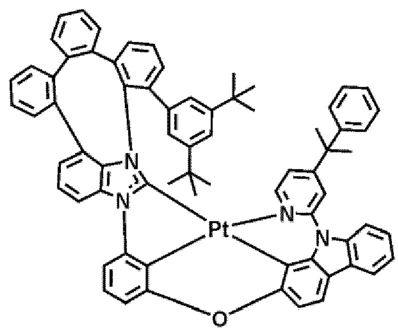

**1**

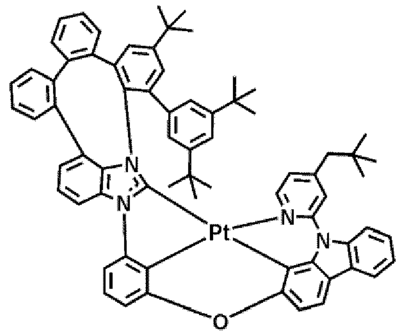

**2**

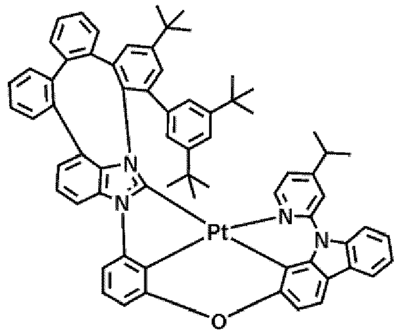

**3**

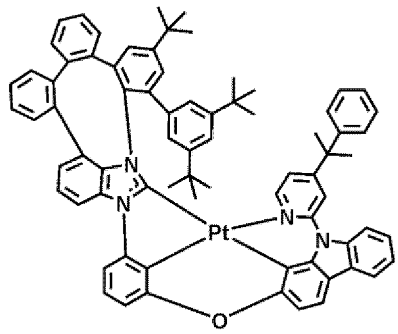

**4**

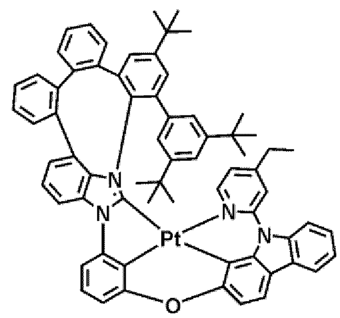

**5**

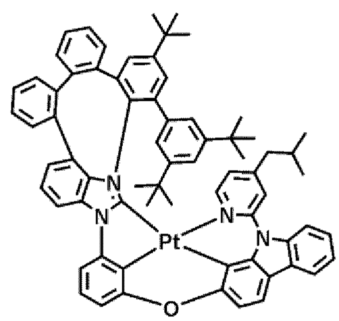

**6**

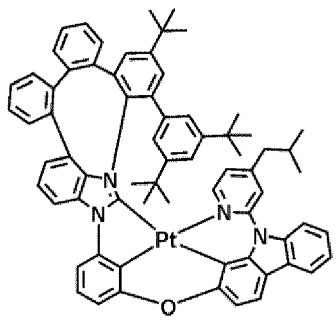

**7**

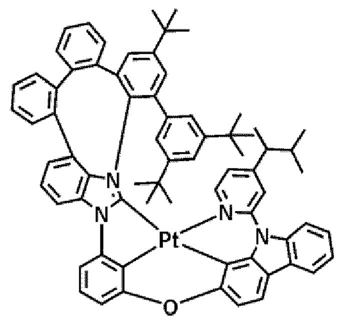

**8**

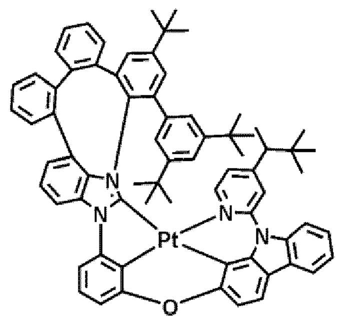

**9**

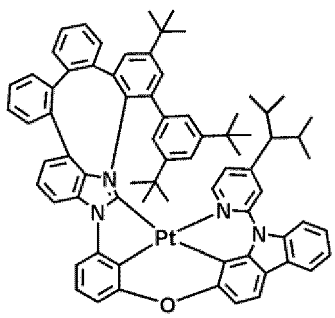

10

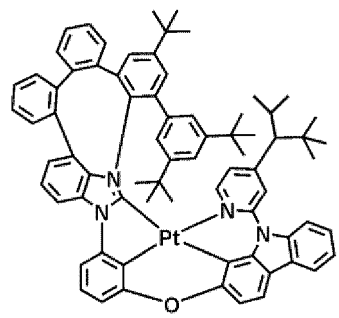

11

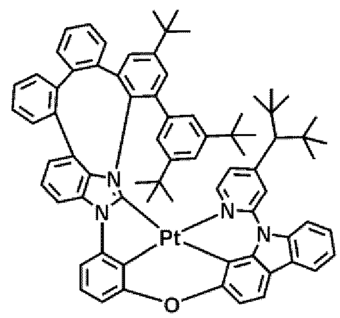

12

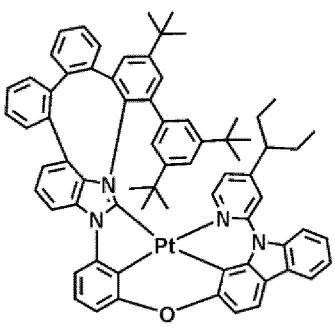

13

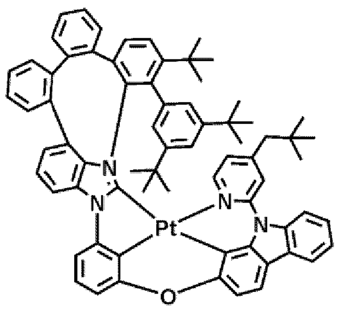

14

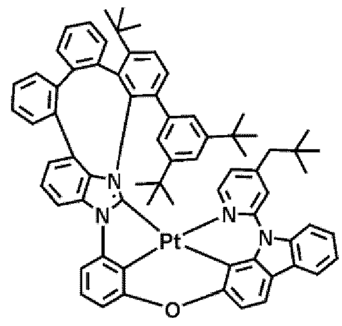

15

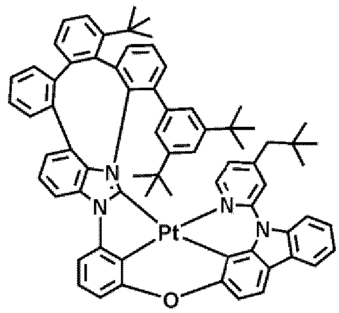

16

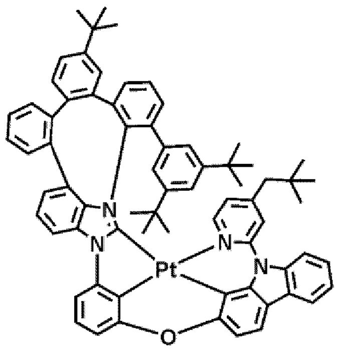

17

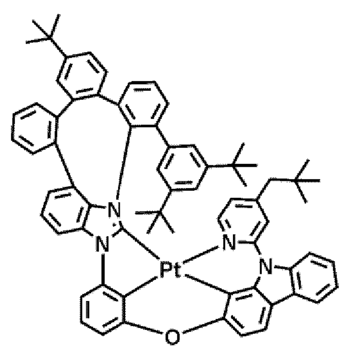

18

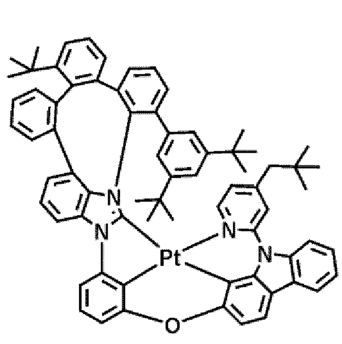

19

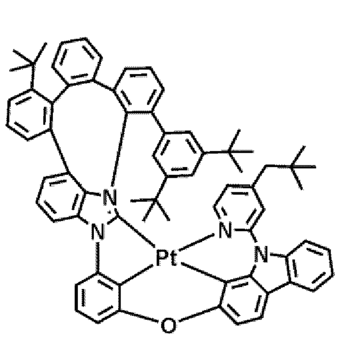

20

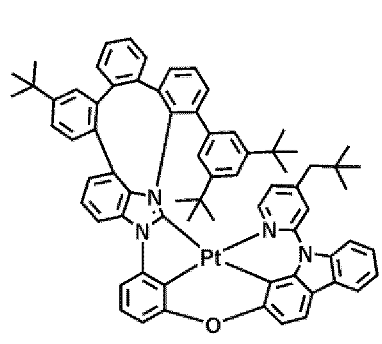

21

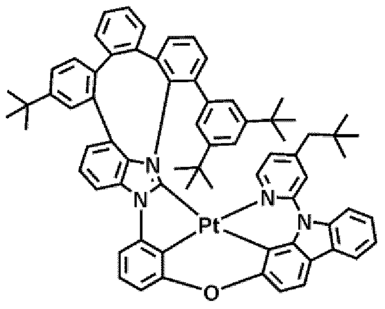

**22**

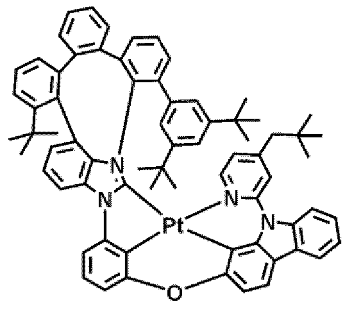

**23**

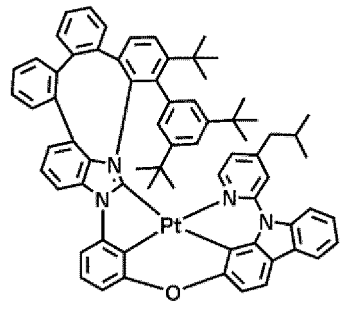

**24**

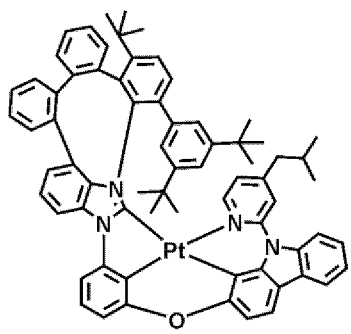

**25**

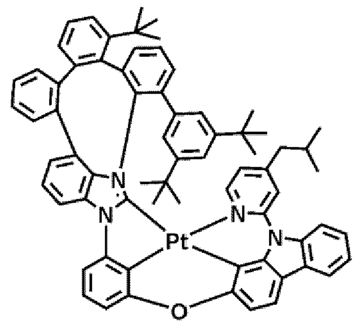

**26**

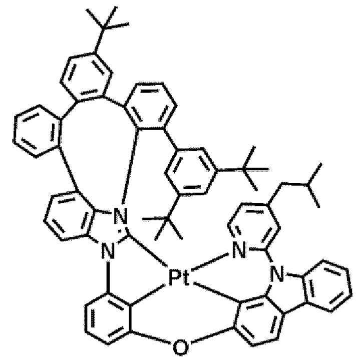

**27**

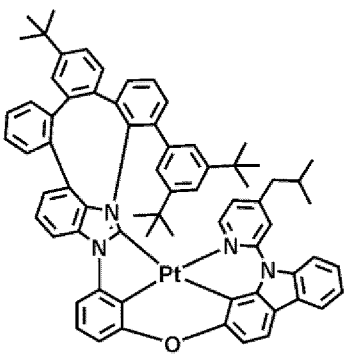

**28**

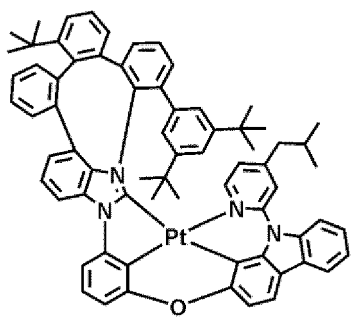

**29**

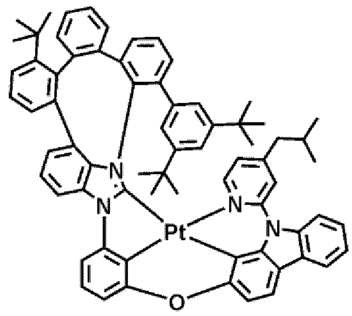

**30**

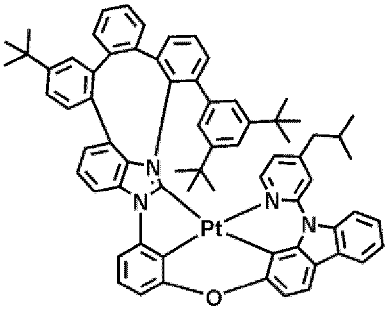

**31**

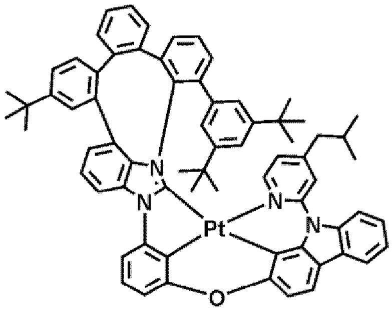

**32**

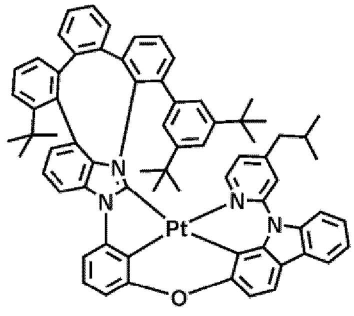

**33**

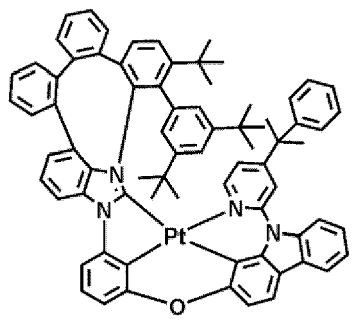
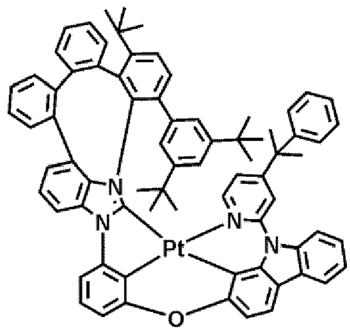
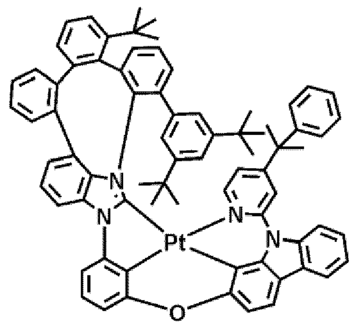

**34** **35** **36**

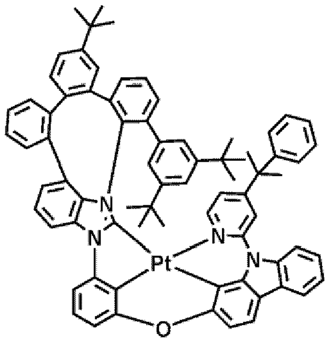
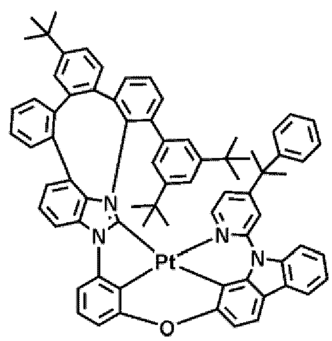
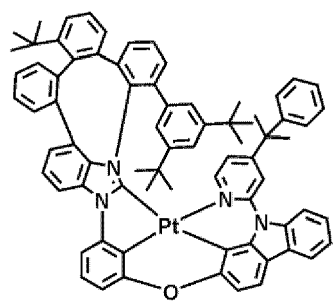

**37** **38** **39**

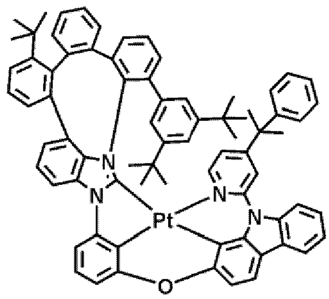
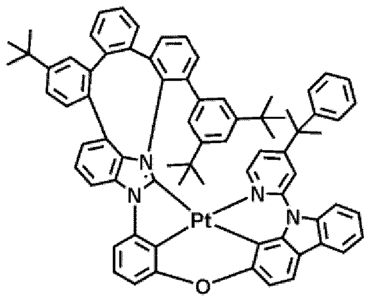
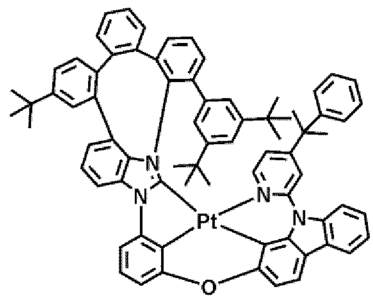

**40** **41** **42**

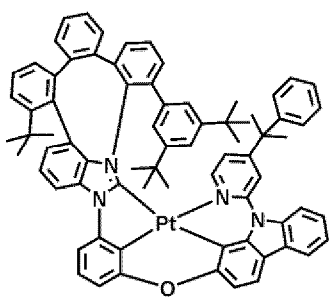
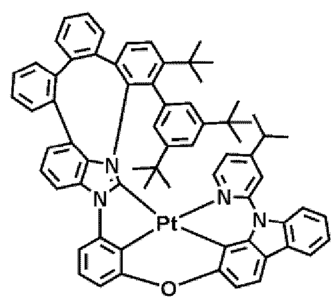
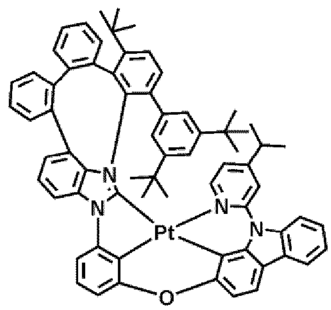

**43** **44** **45**

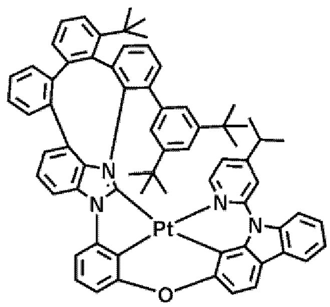

46

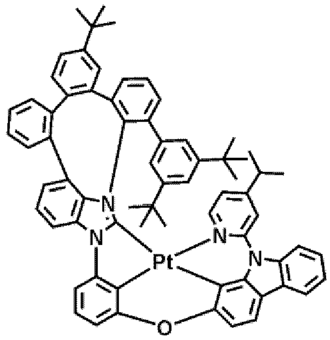

47

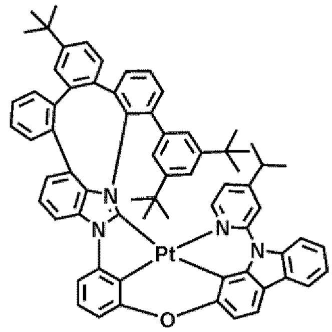

48

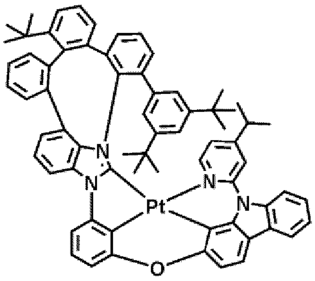

49

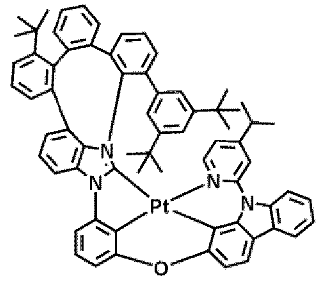

50

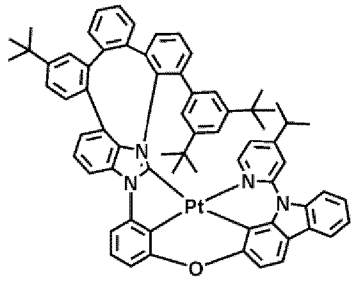

51

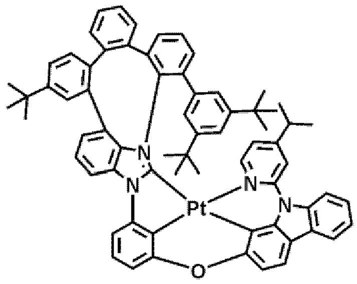

52

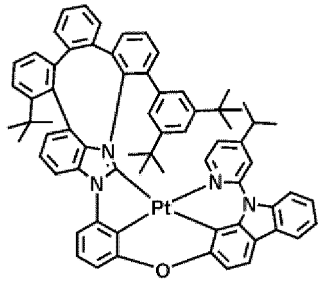

53

**9.** An organic light-emitting device, comprising:

a first electrode;
a second electrode, and
an organic layer arranged between the first electrode and the second electrode,
wherein the organic layer comprises an emission layer, and
wherein the organic layer further comprises at least one of the organometallic compound of any of claims 1-8.

**10.** The organic light-emitting device of claim 9, wherein

the organic layer comprises the emission layer, and
the emission layer comprises the at least one of the organometallic compound.

**11.** The organic light-emitting device of claim 9, wherein

the emission layer comprises a host and an emitter, and
the emitter comprises the at least one of the organometallic compound.

**12.** The organic light-emitting device of claim 9, wherein

the emission layer comprises a host, a sensitizer, and an emitter, and
the sensitizer comprises the at least one of the organometallic compound.

**13.** The organic light-emitting device of claim 11, wherein the host comprises a hole-transporting host, an electron-transporting host, a bipolar host, or a combination thereof; and/or

wherein the emitter is a metal-free organic compound; and/or
wherein the host and the sensitizer substantially do not emit a light, and wherein the emitter emits a light; and/or
wherein the host has a triplet ($T_1$) energy level of 2.8 electron Volts or more.

**14.** An electronic apparatus, comprising the organic light-emitting device of any of claims 9-13.

**15.** An organometallic compound represented by Formula 1:

Formula 1

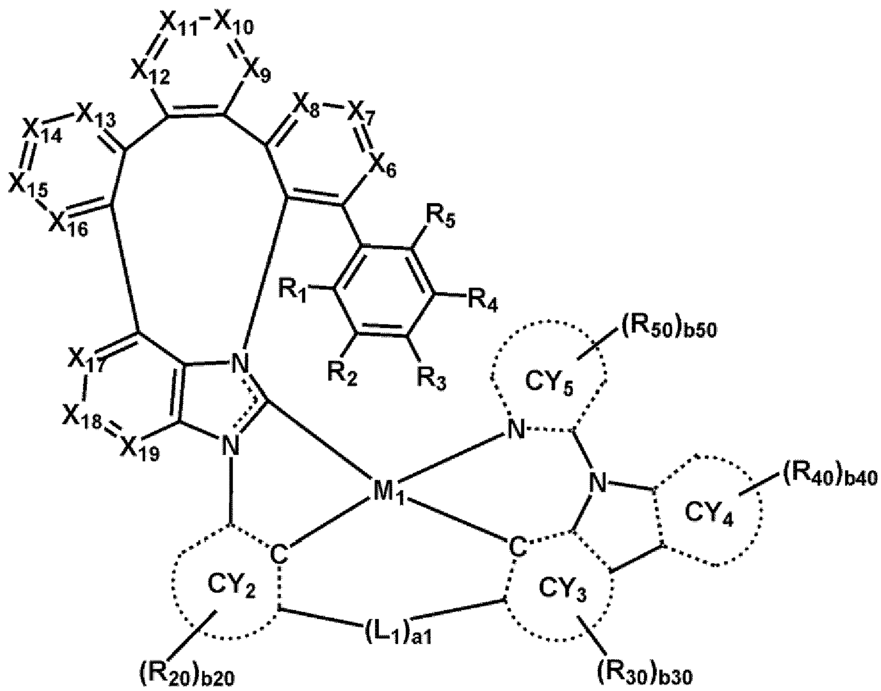

wherein, in Formula 1,

$M_1$ is a metal or a metalloid,
ring $CY_2$ to ring $CY_5$ are each independently a $C_5$-$C_{60}$ carbocyclic group or a $C_1$-$C_{60}$ heterocyclic group,
$X_6$ is $C(R_6)$ or N, $X_7$ is $C(R_7)$ or N, and $X_8$ is $C(R_8)$ or N,
$X_9$ is $C(R_9)$ or N, $X_{10}$ is $C(R_{10})$ or N, $X_{11}$ is $C(R_{11})$ or N, and $X_{12}$ is $C(R_{12})$ or N,
$X_{13}$ is $C(R_{13})$ or N, $X_{14}$ is $C(R_{14})$ or N, $X_{15}$ is $C(R_{15})$ or N, and $X_{16}$ is $C(R_{16})$ or N,
$X_{17}$ is $C(R_{17})$ or N, $X_{18}$ is $C(R_{18})$ or N, and $X_{19}$ is $C(R_{19})$ or N,
L1 is a single bond, O, S, Se, $N(R_{61})$, $B(R_{61})$, $C(R_{61})(R_{62})$, or $Si(R_{61})(R_{62})$,
a1 is 1, 2, 3, 4, or 5,
$R_1$ to $R_{20}$, $R_{30}$, $R_{40}$, $R_{50}$, $R_{61}$, and $R_{62}$ are each independently hydrogen, deuterium, -F, -Cl, -Br, -I, $-SF_5$, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted

or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -Ge($Q_1$)($Q_2$)($Q_3$), - C($Q_1$)($Q_2$)($Q_3$), -B($Q_1$)($Q_2$), -N($Q_1$)($Q_2$), -P($Q_1$)($Q_2$), -C(=O)($Q_1$), -S(=O)($Q_1$), - S(=O)$_2$($Q_1$), -P(=O)($Q_1$)($Q_2$), or -P(=S)($Q_1$)($Q_2$),

(i) at least one of $R_1$ to $R_5$ and at least one of $R_6$ to $R_{19}$ are each independently a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, or a substituted or unsubstituted $C_1$-$C_{60}$ alkylthio group, and/or
(ii) at least one of $R_{50}$ is a substituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group,

at least two neighboring groups among $R_1$ to $R_{20}$, $R_{30}$, $R_{40}$, $R_{50}$, $R_{61}$, and $R_{62}$ are optionally bonded together to form a substituted or unsubstituted $C_5$-$C_{30}$ carbocyclic group or a substituted or unsubstituted $C_1$-$C_{30}$ heterocyclic group,
b20, b30, b40, and b50 are each independently 1, 2, 3, 4, 5, 6, 7, 8, 9, or 10,
at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group is:

deuterium, -F, -Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;
a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, -Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -Si($Q_{11}$)($Q_{12}$)($Q_{13}$), -Ge($Q_{11}$)($Q_{12}$)($Q_{13}$), -N($Q_{14}$)($Q_{15}$), -B($Q_{16}$)($Q_{17}$), -P($Q_{18}$)($Q_{19}$), -P(=O)($Q_{18}$)($Q_{19}$), or a combination thereof;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio

group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{21})(Q_{22})(Q_{23})$, $-Ge(Q_{21})(Q_{22})(Q_{23})$, $-N(Q_{24})(Q_{25})$, $-B(Q_{26})(Q_{27})$, $-P(Q_{28})(Q_{29})$, $-P(=O)(Q_{28})(Q_{29})$, or a combination thereof; or

$-Si(Q_{31})(Q_{32})(Q_{33})$, $-Ge(Q_{31})(Q_{32})(Q_{33})$, $-N(Q_{34})(Q_{35})$, $-B(Q_{36})(Q_{37})$, $-P(Q_{38})(Q_{39})$, or $-P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ are each independently: hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

FIG. 1

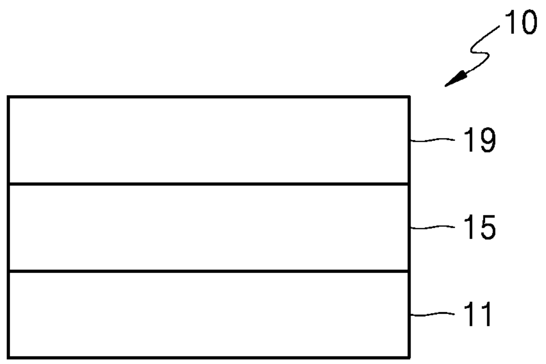
10
19
15
11

FIG. 2

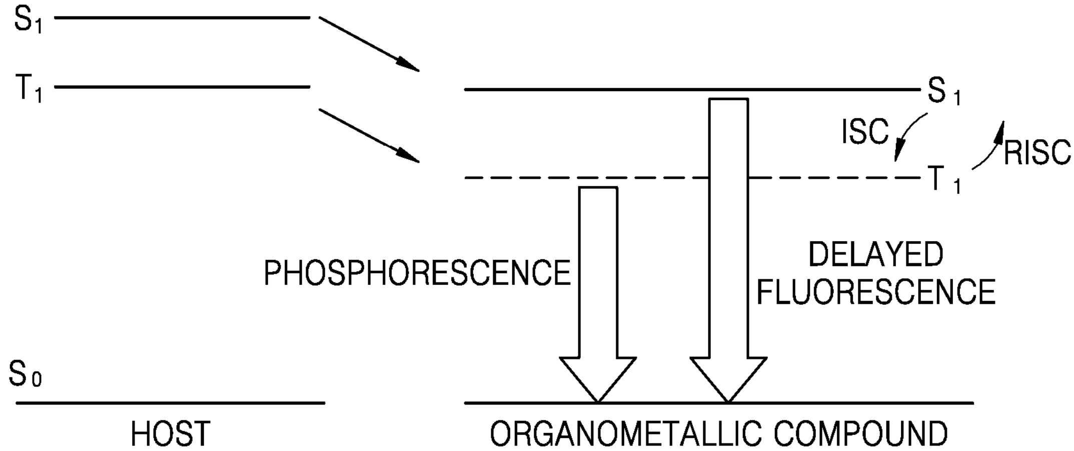
S1
T1
S1
ISC
T1
RISC
PHOSPHORESCENCE
DELAYED
FLUORESCENCE
S0
HOST
ORGANOMETALLIC COMPOUND

FIG. 3

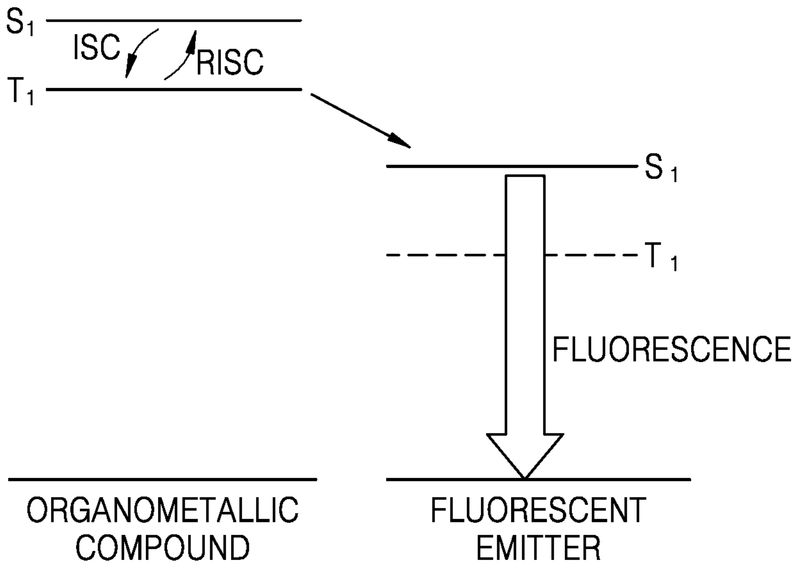
S1
ISC
RISC
T1
S1
T1
FLUORESCENCE
ORGANOMETALLIC COMPOUND
FLUORESCENT EMITTER

FIG. 4

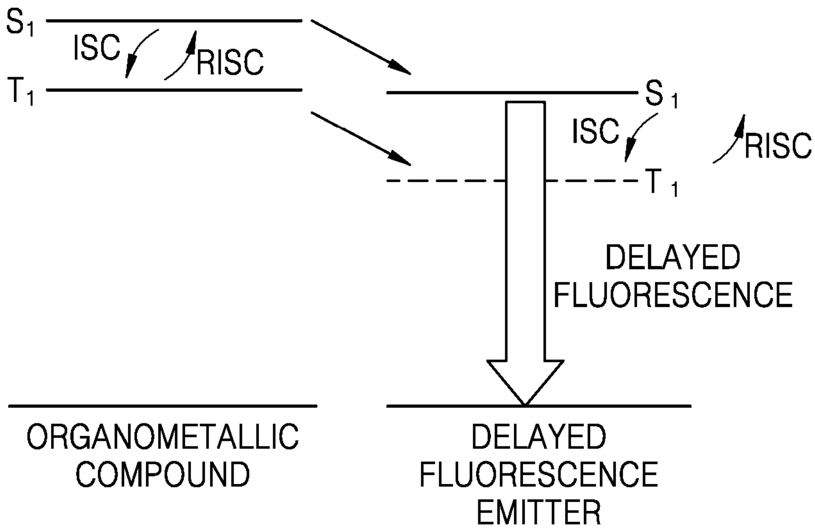
S1
ISC
RISC
T1
S1
ISC
RISC
T1
DELAYED FLUORESCENCE
ORGANOMETALLIC COMPOUND
DELAYED FLUORESCENCE EMITTER